(19) Europäisches Patentamt / European Patent Office / Office européen des brevets

(11) **EP 4 506 933 A1**

(12) **EUROPEAN PATENT APPLICATION**
published in accordance with Art. 153(4) EPC

(43) Date of publication:
**12.02.2025 Bulletin 2025/07**

(21) Application number: **23838775.7**

(22) Date of filing: **30.06.2023**

(51) International Patent Classification (IPC):
*G09G 3/32* (2016.01)   *H10K 59/121* (2023.01)

(86) International application number:
**PCT/CN2023/105120**

(87) International publication number:
**WO 2024/012283 (18.01.2024 Gazette 2024/03)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **12.07.2022 CN 202210811589**

(71) Applicants:
• **Boe Technology Group Co., Ltd.**
  **Beijing 100015 (CN)**
• **Beijing BOE Technology Development Co., Ltd.**
  **Beijing 100176 (CN)**

(72) Inventor: **LONG, Chunping**
  **Beijing 100176 (CN)**

(74) Representative: **Maiwald GmbH**
  **Elisenhof**
  **Elisenstraße 3**
  **80335 München (DE)**

(54) **DISPLAY SUBSTRATE AND DISPLAY APPARATUS**

(57)     A display substrate and a display apparatus. **In** the display substrate, a drive transistor controls a light-emitting device to emit light; data lines are connected to a first electrode of a data write transistor, and are configured to provide data signals for the data write transistor; in response to a first scanning signal which is applied to a gate electrode of the data write transistor, the data write transistor writes the data signals in a gate electrode of the drive transistor; a first connecting structure is connected to the gate electrode of the drive transistor and a first electrode plate of a storage capacitor, both the data lines and the first connecting structure extend in a first direction, the data lines comprise an overlapping part, the first connecting structure and the overlapping part of the data lines are at least partially opposite each other, and a second direction is parallel to a base substrate and is perpendicular to the first direction; the first connecting structure and the overlapping part of the data lines are insulated from each other, and the first connecting structure and the overlapping part of the data lines respectively constitute a first electrode plate and a second electrode plate of a parasitic capacitor; and the ratio of a capacitance value of the parasitic capacitor to a capacitance value of the storage capacitor is greater than 0.001 and less than 0.01.

Fig. 3I

## Description

The application claims priority to the Chinese patent application No. 202210811589.8, filed on July 12, 2022, the entire disclosure of which is incorporated herein by reference as part of the present application.

TECHNICAL FIELD

At least one embodiment of the present disclosure relates to a display substrate and a display apparatus.

BACKGROUND

Compared with traditional liquid crystal displays (LCDs), active matrix organic light-emitting diode (AMOLED) displays have the advantages of self-illumination, wide color gamut, high contrast, and thinness, which enables the active matrix organic light-emitting diode displays to be widely used in mobile phones, tablet computers, and other fields, and also widely used in a flexible wearable field such as smart watches. Usually, a pixel circuit is arranged in the display region, and a gate driving circuit, such as a GOA driving circuit, is arranged in the frame region to provide drive signals to the pixel circuit.

SUMMARY

At least one embodiment of the present disclosure provides a display substrate, the display substrate includes a base substrate, a plurality of pixels arranged in an array are provided on the base substrate; each pixel of at least part of the plurality of pixels comprises a plurality of sub-pixels, each sub-pixel of at least part of the plurality of sub-pixels comprises a pixel circuit, the pixel circuit comprises: a light-emitting device, a storage capacitor, a driving transistor, a data writing transistor, a data line and a first connection structure. The light-emitting device, the storage capacitor, the driving transistor, the data writing transistor. Each of the driving transistor and the data writing transistor comprises an active layer, a gate electrode, a first electrode and a second electrode, the driving transistor is configured to control the light-emitting device to emit light; the data line is connected with the first electrode of the data writing transistor and is configured to provide a data signal to the data writing transistor; the data writing transistor is configured to write the data signal to the gate electrode of the driving transistor in response to a first scan signal applied to the gate electrode of the data writing transistor; and the first connection structure is connected with the gate electrode of the driving transistor and a first electrode plate of the storage capacitor, both the data line and the first connection structure extend along a first direction, and the data line comprises an overlapping part, the first connection structure is at least partially opposite to the overlapping part of the data line in a second direction, and the second direction is parallel to the base substrate and perpendicular to the first direction; the first connection structure and the overlapping part of the data line are insulated from each other, the first connection structure and the overlapping part of the data line respectively constitute a first electrode plate and a second electrode plate of a parasitic capacitance; and a ratio of a capacitance value of the parasitic capacitance to a capacitance value of the storage capacitor is greater than 0.001 and less than 0.01.

For example, in the display substrate provided by an embodiment of the present disclosure, a size of one of the sub-pixels in the second direction is greater than $50\mu m$, and the ratio of the capacitance value of the parasitic capacitance to the capacitance value of the storage capacitor is less than 0.005.

For example, in the display substrate provided by an embodiment of the present disclosure, the size of the one of the sub-pixels in the second direction is less than or equal to $68\mu m$, and the ratio of the capacitance value of the parasitic capacitance to the capacitance value of the storage capacitor is greater than or equal to 0.003.

For example, in the display substrate provided by an embodiment of the present disclosure, a size of one of the sub-pixels in the second direction is less than 50um, and the ratio of the capacitance value of the parasitic capacitance to the capacitance value of the storage capacitor is greater than 0.005 and less than 0.006.

For example, in the display substrate provided by an embodiment of the present disclosure, the first connection structure comprises a first part extending along the first direction, an edge of the first part of the first connection structure close to the overlapping part of the data line is a first edge, the first part of the first connection structure further comprises a second edge away from the overlapping part of the data line, and an edge of the overlapping part of the data line close to the first connection structure is a third edge; the plurality of sub-pixels comprise a first sub-pixel and a second sub-pixel that are adjacent to each other in the second direction; a distance from an orthographic projection of the second edge of the first connection structure of the first sub-pixel on the base substrate to an orthographic projection of the third edge of the overlapping part of the data line of the second sub-pixel on the base substrate is a first distance, a distance from a first edge of the first connection structure of the first sub-pixel to a third edge of an overlapping part of a data line of the first sub-pixel is a second distance, and a ratio of the first distance to the second distance is greater than 14.

For example, in the display substrate provided by an embodiment of the present disclosure, a size of one of the sub-pixels in the second direction is less than 50μm, and the ratio of the first distance to the second distance is greater than 14 and less than 15.5.

For example, in the display substrate provided by an embodiment of the present disclosure, a size of one of the sub-pixels in the second direction is greater than 50μm, and the ratio of the first distance to the second distance is greater than 15.5.

For example, in the display substrate provided by an embodiment of the present disclosure, the plurality of sub-pixels comprise the first sub-pixel and the second sub-pixel adjacent to each other in the second direction; the first connection structure of the first sub-pixel is located between the data line of the first sub-pixel and the data line of the second sub-pixel in the second direction; a distance between an orthographic projection of the first connection structure of the first sub-pixel on the base substrate and an orthographic projection of the data line of the first sub-pixel on the base substrate is smaller than a size of one of the sub-pixels in the second direction, and a distance between the orthographic projection of the first connection structure of the first sub-pixel on the base substrate and an orthographic projection of the data line of the second sub-pixel on the base substrate is smaller than a size of one of the sub-pixels in the second direction.

For example, in the display substrate provided by an embodiment of the present disclosure, the first connection structure of the first sub-pixel is located between the data line of the first sub-pixel and the data line of the second sub-pixel in the second direction; a distance between an orthographic projection of the first connection structure of the first sub-pixel on the base substrate and an orthographic projection of the data line of the first sub-pixel on the base substrate is smaller than a size of one of the sub-pixels in the second direction, and a distance between the orthographic projection of the first connection structure of the first sub-pixel on the base substrate and an orthographic projection of the data line of the second sub-pixel on the base substrate is greater than the size of one of the sub-pixels in the second direction.

For example, in the display substrate provided by an embodiment of the present disclosure, an edge of the gate electrode of the driving transistor of the first sub-pixel close to the overlapping part of the data line of the second sub-pixel is a fourth edge; a distance from a second edge of the first sub-pixel to a third edge of the second sub-pixel is equal to a sum of a distance from the second edge of the first sub-pixel to the fourth edge and a distance from the fourth edge of the first sub-pixel to the third edge of the second sub-pixel.

For example, in the display substrate provided by an embodiment of the present disclosure, the first connection structure and the data line are arranged in different layers, an orthographic projection of the first connection structure on the base substrate is at least partially overlapped with the orthographic projection of the overlapping part of the data line on the base substrate; or, the first connection structure and the data line are arranged in different layers, an orthographic projection of the first connection structure on the base substrate is not overlapped with an orthographic projection of the overlapping part of the data line on the base substrate.

For example, in the display substrate provided by an embodiment of the present disclosure, the first connection structure and the data line are arranged in a same layer, and the first connection structure and the overlapping part of the data line are opposite to each other in the second direction.

For example, in the display substrate provided by an embodiment of the present disclosure, at least one of the overlapping part of the data line and the first connection structure comprises a recessed part, the recessed part of any one of the overlapping part of the data line and the first connection structure is recessed in a direction away from other one of the overlapping part of the data line and the first connection structure in the second direction.

For example, in the display substrate provided by an embodiment of the present disclosure, the overlapping part of the data line comprises a first recessed part, the first recessed part is recessed in a direction away from the first connection structure in the second direction, and a part of the first connection structure opposite to the data line is in a straight strip shape.

For example, in the display substrate provided by an embodiment of the present disclosure, the first connection structure comprises a second recessed part, the second recessed part is recessed in a direction away from the overlapping part of the data line in the second direction, and the overlapping part of the data line is in a straight strip shape.

For example, in the display substrate provided by an embodiment of the present disclosure, the overlapping part of the data line comprises a first recessed part, the first recessed part is recessed in a direction away from the first connection structure in the second direction, and the first connection structure comprises a second recessed part, the second recessed part is recessed in a direction away from the overlapping part of the data line in the second direction.

For example, the display substrate provided by an embodiment of the present disclosure further comprises a first reset scan signal line, a second reset scan signal line, a first reset signal line and a second reset signal line; the pixel circuit further comprises: a first reset transistor and a second reset transistor. The first reset transistor comprises an active layer, the first reset scan signal line is configured to provide a first reset scan signal to a gate electrode of the first reset transistor, a first electrode of the first reset transistor is electrically connected with the gate electrode of the driving transistor, a second electrode of the first reset transistor is configured to be electrically connected with the first reset signal line to receive a first reset signal, and the first reset transistor is configured to write the first reset signal to the gate electrode of the driving transistor in response to the first reset scan signal; and the second reset scan signal line is configured to provide a second reset scan signal to a gate electrode of the second reset transistor, a first electrode of the second reset transistor is electrically connected with a first display electrode of the light-emitting device, a second electrode of the second reset transistor is configured to be electrically connected with the second reset signal line to receive a second reset signal, and the second reset transistor is configured to write the second reset signal to the first display electrode of the light-emitting device in response to the second reset scan signal; an active layer of the first reset transistor extends along the first direction, and the first reset scan signal line extends in the second direction; the plurality of sub-pixels comprise a first sub-pixel and a second sub-pixel that are adjacent to each other in the second direction; the plurality of sub-pixels further comprise a third sub-pixel, and the third sub-pixel is adjacent to the second sub-pixel in the first direction; and a part of the second reset signal line in each of the sub-pixels in the plurality of sub-pixels comprises a transverse part and a first vertical part, the transverse part extends along the second direction and has a first end and a second end that are opposite each other in the second direction, the first vertical part is connected with the first end of the transverse part and extends along the first direction, and an orthographic projection of the transverse part of the second reset signal line in the second sub-pixel on the base substrate is at least partially overlapped with an orthographic projection of the first reset scan signal line in the third sub-pixel on the base substrate, and the first vertical part of the second reset signal line in the second sub-pixel is spaced apart from the active layer of the first reset transistor of the third sub-pixel in the second direction.

For example, in the display substrate provided by an embodiment of the present disclosure, a planar pattern of a sub-part of the second reset signal line corresponding to one of the sub-pixels is in a shape of an inverted "π"; the sub-part in the shape of the inverted "π" comprises a U-shaped groove, and the transverse part of the second reset signal line serves as a bottom of the U-shaped groove.

For example, the display substrate provided by an embodiment of the present disclosure further comprises a compensation scan signal line; the pixel circuit further comprises a compensation transistor which comprises an active layer, a gate electrode, a first electrode and a second electrode; the compensation scan signal line is configured to apply a second scan signal to the gate electrode of the compensation transistor, the compensation transistor is configured to perform threshold compensation on the driving transistor in response to the second scan signal; and the active layer of the compensation transistor and the active layer of the first reset transistor constitute an integral structure.

For example, in the display substrate provided by an embodiment of the present disclosure, a part of the second reset signal line in one of the sub-pixels further comprises a second vertical part, the second vertical part is connected with the second end of the transverse part and extends along the first direction, an active layer of the second reset transistor is between the first vertical part and the second vertical part, and in one same sub-pixel of the sub-pixels, in the second direction, a distance from the first vertical part to the data line is greater than a distance from the second vertical part to the data line; a distance from an active layer of the second reset transistor of the third sub-pixel to the first vertical part of the second reset signal line of the second sub-pixel is less than a distance from the active layer of the second reset transistor of the third sub-pixel to the second vertical part of the second reset signal line of the second sub-pixel.

For example, in the display substrate provided by an embodiment of the present disclosure, the gate electrode of the driving transistor and the first electrode plate of the storage capacitor are arranged in a same layer and constitute an integral structure, the second reset scan signal line is arranged in a same layer as the gate electrode of the driving transistor; the gate electrode of the driving transistor and the first electrode plate of the storage capacitor are located on a side of the active layer of the driving transistor away from the base substrate; a second electrode plate of the storage capacitor is located on a side of both the gate electrode of the driving transistor and the first electrode plate of the storage capacitor away from the base substrate, the compensation scan signal line is arranged in a same layer as the second electrode plate of the storage capacitor; the active layer of the compensation transistor is located on a side of the second electrode plate of the storage capacitor away from the base substrate; and the second reset signal line is located on a side of the active layer of the compensation transistor away from the base substrate .

For example, the display substrate provided by an embodiment of the present disclosure further comprises a first reset scan signal line and a first reset signal line; the pixel circuit further comprises a first reset transistor. The first reset transistor comprises an active layer, the first reset scan signal line is configured to provide a first reset scan signal to a gate electrode of the first reset transistor, the first electrode of the second reset transistor is electrically connected with the gate electrode of the driving transistor, a second electrode of the first reset transistor is configured to be electrically connected with the first reset signal line to receive a first reset signal, the first reset transistor is configured to write the first reset signal to the gate electrode of the driving transistor in response to the first reset scan signal; the active layer of the first reset transistor and the active layer of the driving transistor are made of different materials and are arranged in different layers; and the first reset signal line and the second electrode plate of the storage capacitor are arranged in a same layer.

For example, in the display substrate provided by an embodiment of the present disclosure, the gate electrode of the compensation transistor and the gate electrode of the first reset transistor are both double gate structures, the gate electrode of the compensation transistor comprises a first gate electrode and a second gate electrode, and the gate electrode of the first reset transistor comprises a first gate electrode and a second gate electrode; an orthographic projection of the first gate electrode of the compensation transistor on the base substrate coincides with an orthographic projection of the second gate electrode of the compensation transistor on the base substrate, and an orthographic projection of the first gate electrode of the first reset transistor on the base substrate coincides with an orthographic projection of the second gate electrode of the first reset transistor on the base substrate.

For example, in the display substrate provided by an embodiment of the present disclosure, the first gate electrode of the compensation transistor and the first gate electrode of the first reset transistor are arranged in a same layer as the second electrode plate of the storage capacitor, the second gate electrode of the compensation transistor and the second gate electrode of the first reset transistor are located on a side of both the active layer of the compensation transistor and the active layer of the first reset transistor away from the base substrate, and are located on a side of the second reset signal line close to the base substrate.

For example, in the display substrate provided by an embodiment of the present disclosure, a material of the active layer of the first reset transistor is an oxide semiconductor; and a material of the active layer of the driving transistor and a material of the active layer of the data writing transistor are low-temperature polysilicon.

For example, in the display substrate provided by an embodiment of the present disclosure, the first connection structure is located on a side of the second electrode plate of the storage capacitor away from the base substrate; the second electrode plate of the storage capacitor has a first via hole exposing the first electrode plate of the storage capacitor, the first connection structure passes through the first via hole and is connected with the first electrode plate of the storage capacitor; the second electrode plate of the storage capacitor comprises a first part located on a first side of the first via hole in the second direction and a second part located on a second side of the first via hole in the second direction, the first side of the first via hole is opposite to the second side of the first via hole, the second part of the second electrode plate is located on a side of the first part of the second electrode plate close to the data line; an orthographic projection of an edge of the first connection structure close to the second part of the second electrode plate of the storage capacitor in the second direction on the base substrate, an orthographic projection of an edge of the first display electrode close to the first connection structure on the base substrate, and an orthographic projection of an edge of the second part of the second electrode plate close to the first connection structure on the base substrate are overlapped with each other.

For example, in the display substrate provided by an embodiment of the present disclosure, the first connection structure and the second reset signal line are arranged in a same layer; upon the first connection structure and the data line being arranged in different layers, the data line is located on a side of the first connection structure away from the base substrate, or, the data line is located on a side of the first connection structure close to the base substrate.

For example, in the display substrate provided by an embodiment of the present disclosure, the first connection structure comprises a first part extending along the first direction and a second part extending along the second direction, the second part of the first connection structure is connected with the first part of the first connection structure; the active layer of the compensation transistor is located on a side of the first connection structure away from the data line, and the second part of the first connection structure is connected with the active layer of the compensation transistor.

For example, in the display substrate provided by an embodiment of the present disclosure, an orthographic projection of an entirety of the first connection structure on the base substrate is located within an orthographic projection of a first display electrode of the light-emitting device on the base substrate; the plurality of sub-pixels comprise a first sub-pixel and a second sub-pixel that are adjacent to each other in the second direction; the first display electrode of the first sub-pixel covers a boundary between the first sub-pixel and the second sub-pixel, and an orthographic projection of the first connection structure of the first sub-pixel on the base substrate and an orthographic projection of the first connection structure of the second sub-pixel on the base substrate are both located within an orthographic projection of the first display electrode of the first sub-pixel on the base substrate.

For example, in the display substrate provided by an embodiment of the present disclosure, an orthographic projection of an edge of the first display electrode of the first sub-pixel away from the second sub-pixel on the base substrate is overlapped with an orthographic projection of an edge of the first connection structure of the first sub-pixel close to the data line of the first sub-pixel on the base substrate, an orthographic projection of an edge of the first display electrode of the first sub-pixel close to the second sub-pixel on the base substrate is overlapped with an orthographic projection of an edge of the first connection structure of the second sub-pixel close to the data line of the second sub-pixel on the base substrate.

For example, in the display substrate provided by an embodiment of the present disclosure, a part of the orthographic projection of the first connection structure on the base substrate is located within an orthographic projection of a first display electrode of the light-emitting device on the base substrate; the plurality of sub-pixels comprise a first sub-pixel and a second sub-pixel that are adjacent to each other in the second direction; a first display electrode of the first sub-pixel covers a boundary between the first sub-pixel and the second sub-pixel, and both a part of an orthographic projection of the first connection structure of the first sub-pixel on the base substrate and a part of an orthographic projection of the first connection structure of the second sub-pixel on the base substrate are located within an orthographic projection of the first display electrode of the first sub-pixel on the base substrate.

For example, in the display substrate provided by an embodiment of the present disclosure, a light-emitting material of the light-emitting device of the first sub-pixel emits green light.

For example, in the display substrate provided by an embodiment of the present disclosure, the first electrode plate of the storage capacitor has an upper surface away from the base substrate and a side surface intersecting the upper surface; a second electrode plate of the storage capacitor comprises a central part and an edge part. An orthographic projection of the central part on the base substrate at least partially coincides with an orthographic projection of the first electrode plate of the storage capacitor on the base substrate, and the central part comprises a bottom surface opposite to the upper surface of the first electrode plate of the storage capacitor; the edge part at least partially surrounds the central part and connected with the central part, and comprising a bottom surface close to the base substrate and an inner side surface intersecting the bottom surface, wherein the inner side surface and the side surface of the first electrode plate of the storage capacitor are opposite to each other, and an orthographic projection of the inner surface on a reference plane perpendicular to the base substrate is at least partially overlapped with an orthographic projection, of the side surface of the first electrode plate of the storage capacitor which is opposite to the inner surface, on the reference plane; a distance between the inner side of the edge part and the side surface of the first electrode plate of the storage capacitor which is opposite to the inner side is less than a distance between the bottom surface of the central part and the upper surface of the first electrode plate of the storage capacitor.

For example, in the display substrate provided by an embodiment of the present disclosure, a first display electrode of the light-emitting device has a first end and a second end that are opposite to each other in the second direction; the display substrate comprises a first semiconductor layer, the first semiconductor layer comprises the active layer of the driving transistor and the active layer of the data writing transistor, the data line is connected with the first semiconductor layer through a second via hole; the plurality of sub-pixels comprise a first sub-pixel and a second sub-pixel that are adjacent to each other in the second direction; a first display electrode of the first sub-pixel covers a boundary between the first sub-pixel and the second sub-pixel, an orthographic projection of the first end of the first display electrode of the first sub-pixel on the base substrate has a first protrusion part that is convex and tapered in the second direction toward an orthographic projection of the second via hole of the first sub-pixel on the base substrate, an orthographic projection of the second end of the first display electrode of the first sub-pixel on the base substrate has a second protrusion part that is convex and tapered in the second direction toward the orthographic projection of the second via hole of the second sub-pixel on the base substrate, and an orthographic projection of the first protrusion part is directly opposite to the orthographic projection of the second via hole of the first sub-pixel on the base substrate in the second direction, an orthographic projection of the second protrusion part and the orthographic projection of the second via hole of the second sub-pixel on the base substrate is directly opposite in the second direction; a light-emitting material of the light-emitting device of the first sub-pixel emits blue light.

For example, in the display substrate provided by an embodiment of the present disclosure, the gate electrode of the driving transistor and the first electrode plate of the storage capacitor are arranged in a same layer and constitute an integral structure; the gate electrode of the driving transistor and the first electrode plate of the storage capacitor are located on a side of the active layer of the driving transistor away from the base substrate; a second electrode plate of the storage capacitor is located on a side of both the gate electrode of the driving transistor and the first electrode plate of the storage capacitor away from the base substrate, the display substrate further comprises a first power line which is connected with a first voltage terminal and configured to provide a first power voltage to the pixel circuit, and extending along the first direction; the pixel circuit further comprises a second connection structure located between the first power line and the second electrode plate of the storage capacitor in a direction perpendicular to the base substrate, and connecting the first power line and the second electrode plate of the storage capacitor, wherein the second connection structure comprises a horizontal part and a vertical part, the horizontal part extends along the second direction, and the vertical part is connected with the horizontal part and extends along the first direction; an orthographic projection of the first power line on the base substrate is overlapped with an orthographic projection of the horizontal part of the second connection structure on the base substrate, the orthographic projection of the first power line on the base substrate is not overlapped with orthographic projections of other structures that are arranged in a same layer as the second connection structure on the base substrate.

For example, in the display substrate provided by an embodiment of the present disclosure, the vertical part is substantially aligned with the first connection structure in the first direction, the orthographic projection of the horizontal part on the base substrate extends along the first direction from an orthographic projection of the vertical part on the base substrate to the orthographic projection of the first power line on the base substrate.

For example, the display substrate provided by an embodiment of the present disclosure further comprises a first insulation layer and a second insulation layer. The first insulation layer is located between the first power line and the second connection structure; the second insulation layer is located between the second connection structure and the second electrode plate of the storage capacitor, wherein a horizontal part of the first power line is connected with the second connection structure through a third via hole penetrating through the first insulation layer, and the vertical part of the second connection structure is connected with the second electrode plate of the storage capacitor through a fourth via hole penetrating through the second insulation layer.

For example, in the display substrate provided by an embodiment of the present disclosure, the first power line and the data line are arranged in a same layer, and the second connection structure and the first connection structure are arranged in a same layer.

For example, in the display substrate provided by an embodiment of the present disclosure, the pixel circuit further comprises a first light-emitting transistor which is connected with the first electrode of the driving transistor and a first voltage terminal, and configured to apply the first power supply voltage of the first voltage terminal to the first electrode of the driving transistor in response to a first light-emitting control signal applied to a gate electrode of the first light-emitting transistor; the display substrate comprises a first semiconductor layer, the first semiconductor layer comprises the active layer of the driving transistor, the active layer of the data writing transistor, and an active layer of the first light-emitting transistor, and the horizontal part of the second connection structure is connected with the first semiconductor layer through a fifth via hole.

For example, in the display substrate provided by an embodiment of the present disclosure, the horizontal part of the second connection structure has a first end and a second end that are opposite to each other in the second direction, the first end of the horizontal part is located on a side of the first power line close to the vertical part and is connected with the vertical part, and the second end of the horizontal part is located on a side of the first power line away from the vertical part and is connected with the first semiconductor layer through the fifth via hole.

At least one embodiment of the present disclosure further provides a display apparatus, and the display apparatus includes any one of the display substrates provided by the embodiments of the present disclosure.

BRIEF DESCRIPTION OF DRAWINGS

In order to clearly illustrate the technical solution of the embodiments of the present disclosure, the drawings of the embodiments will be briefly described. It is obvious that the described drawings in the following are only related to some embodiments of the present disclosure and thus are not construed as any limitation to the present disclosure.

Fig. 1 is a planar schematic diagram of a display substrate provided by an embodiment of the present disclosure;

Fig. 2A is a schematic diagram of a pixel circuit provided by at least one embodiment of the present disclosure;

Fig. 2B is a circuit diagram of a specific example of the pixel circuit shown in Fig. 2A;

Fig. 2C is a signal timing diagram of a driving method for a pixel circuit provided by at least one embodiment of the present disclosure;

Fig. 3A is a planar schematic diagram showing a first semiconductor layer and a first conductive layer that are stacked of a sub-pixel of a display substrate provided by an embodiment of the present disclosure;

Fig. 3B is a planar schematic diagram showing a second conductive layer and a second semiconductor layer that are stacked of a sub-pixel of a display substrate provided by an embodiment of the present disclosure;

Fig. 3C is a planar schematic diagram showing a first semiconductor layer, a first conductive layer, a second conductive layer and a second semiconductor layer that are stacked of a sub-pixel of a display substrate provided by an embodiment of the present disclosure;

Fig. 3D is a planar schematic diagram showing a second conductive layer and a third conductive layer that are stacked of a sub-pixel of a display substrate provided by an embodiment of the present disclosure;

Fig. 3E is a planar schematic diagram showing a first semiconductor layer, a first conductive layer, a second conductive layer, a second semiconductor layer and a third conductive layer that are stacked of a sub-pixel of a display substrate provided by an embodiment of the present disclosure;

Fig. 3F is a planar schematic diagram showing a first interlayer insulation layer and a fourth conductive layer that are stacked of a sub-pixel of a display substrate provided by an embodiment of the present disclosure;

Fig. 3G is a planar schematic diagram showing a first semiconductor layer, a first conductive layer, a second conductive layer, a second semiconductor layer, a third conductive layer, a first interlayer insulation layer and a fourth conductive layer that are stacked of a sub-pixel of a display substrate provided by an embodiment of the present disclosure;

Fig. 3H is a planar schematic diagram showing a first planarization layer and a fifth conductive layer that are stacked of a sub-pixel of a display substrate provided by an embodiment of the present disclosure;

Fig. 3I is a planar schematic diagram showing a first semiconductor layer, first conductive layer, a second conductive layer, a second semiconductor layer, a third conductive layer, a first interlayer insulation layer, a fourth conductive layer, a first planarization layer and a fifth conductive layer that are stacked of a sub-pixel of a display substrate provided by an embodiment of the present disclosure;

Fig. 3J is a planar schematic diagram showing a second planarization layer, a first electrode and a pixel definition layer that are stacked of a sub-pixel of a display substrate provided by an embodiment of the present disclosure;

Fig. 3K is a planar schematic diagram of a sub-pixel of a display substrate provided by an embodiment of the present disclosure, that is, a planar schematic diagram of a stack structure of a first semiconductor layer, a first conductive layer, a second conductive layer, a second semiconductor layer, a third conductive layer, a first interlayer insulation layer, a fourth conductive layer, a first planarization layer, a fifth conductive layer, a second planarization layer, a first electrode and a pixel definition layer that are stacked of the sub-pixel;

Fig. 4A is a cross-sectional schematic diagram along an extension direction of an active layer of a third transistor and an extension direction of an active layer of a sixth transistor in Fig. 3K in sequence;

Fig. 4B is a structural schematic diagram of a display substrate;

Fig. 4C is a schematic diagram of a flat plate capacitor with electrodes right facing each other;

Fig. 4D is a schematic diagram of a flat plate capacitor with inclined electrodes;

Fig. 4E is another cross-sectional schematic diagram of a display substrate provided by an embodiment of the present disclosure;

Fig. 5 is a planar schematic diagram of at least two adjacent sub-pixels of a display substrate provided by an embodiment of the present disclosure.

Fig. 6 is a schematic diagram with a first power line being removed based on Fig. 5.

Fig. 7A is a cross-sectional schematic diagram from a first perspective along extension directions of an active layer of a fourth transistor, an active layer of a third transistor, an active layer of a second transistor, and an active layer of a first transistor in Fig. 3K in sequence.

Fig. 7B is a cross-sectional schematic diagram from a second perspective along extension directions of the active layer of the fourth transistor, the active layer of the third transistor, the active layer of the second transistor, and the active layer of the first transistor in Fig. 3K in sequence.

Fig. 7C is a cross-sectional schematic diagram along extension directions of an active layer of a fifth transistor, the active layer of the third transistor, and the active layer of the sixth transistor in Fig. 3K in sequence, that is, a cross-sectional schematic diagram taken along the line A1-A2 in Fig. 3K.

Fig. 7D is a cross-sectional schematic diagram along extension directions of the active layer of the third transistor and the active layer of the sixth transistor in Fig. 3K in sequence, that is, a cross-sectional schematic diagram taken along the line B1-B2 in Fig. 3K.

Fig. 8 is another planar schematic diagram of a display substrate provided by an embodiment of the present disclosure.

Fig. 9 is another cross-sectional schematic diagram of a display substrate provided by an embodiment of the present disclosure.

Fig. 10 is still another cross-sectional schematic diagram of a display substrate provided by an embodiment of the present disclosure.

Fig. 11 is still another planar schematic diagram of a display substrate provided by an embodiment of the present disclosure.

Fig. 12 is still another planar schematic diagram of a display substrate provided by an embodiment of the present disclosure.

Fig. 13 is still another cross-sectional schematic diagram of a display substrate provided by an embodiment of the present disclosure.

Fig. 14A is a schematic diagram of a first connection structure and a data line in a display substrate provided by an embodiment of the present disclosure.

Fig. 14B is a schematic diagram of a first connection structure and a data line in another display substrate provided by an embodiment of the present disclosure.

Fig. 14C is a schematic diagram of a first connection structure and a data line in still another display substrate provided by an embodiment of the present disclosure.

Fig. 15 is a schematic diagram of a display apparatus provided by at least one embodiment of the present disclosure.

DETAILED DESCRIPTION

In order to make objectives, technical details, and advantages of the embodiments of the present disclosure clearer, the technical solutions of the embodiments will be described in a clearly and fully understandable way in connection with the drawings related to the embodiments of the present disclosure. Apparently, the described embodiments are just a part but not all of the embodiments of the present disclosure. Based on the described embodiments herein, those skilled in the art can obtain other embodiment(s), without any inventive work, which should be within the scope of the present disclosure.

Unless otherwise defined, all the technical and scientific terms used herein have the same meanings as commonly understood by one of ordinary skill in the art to which the present disclosure belongs. The terms "first", "second", etc., which are used in the present disclosure, are not intended to indicate any sequence, amount or importance, but distinguish various components. Also, the terms "comprise," "comprising," "include," "including," etc., are intended to specify that the elements or the objects stated before these terms encompass the elements or the objects and equivalents thereof listed after these terms, but do not preclude the other elements or objects. "In/inside," "outside," "on," "under" and the like are only used to indicate relative position relationship, and when the position of the object which is described is changed, the relative position relationship may be changed accordingly.

The drawings in the present disclosure are not strictly drawn to actual scale, a number of the sub-pixels and the dummy pixels in the display substrate is not limited to the number shown in the figures, and a specific size and quantity of each of the structures can be determined according to actual needs. The drawings described in the present disclosure are only structural schematic diagrams.

It should be noted that an orthographic projection of a certain structure on the base substrate in the present application refers to an orthographic projection of the structure on a main surface of the base substrate, and the main surface of the base substrate refers to a surface of the base substrate on which the pixel circuit is arranged.

It should be noted that the term "arranged in a same layer" used in the present disclosure refers to a structure formed by two (or more than two) structures formed by one same deposition process and patterned by one same patterning process, and the materials of the two (or more than two) structures can be the same or different. The term "continuous integral structure" in the present disclosure refers to an interconnected structure in which the two (or more than two) structures are patterned by one same film through one same patterning process, and the materials of the two (or more than two) structures are the same or different.

It should also be noted that Scan(N)(n) represents a scan signal line connected with N-type TFTs in the n-th row, Scan(N)(n-1) represents a scan signal line connected with N-type TFTs in the (n-1)-th row, and Scan(N)(n+1) represents a scan signal line connected with N-type TFTs in the (n+1)-th row. Scan(P)(n) represents a scan signal line connected with P-type TFTs in the n-th row, and Scan(P)(n+1) represents a scan signal line connected with P-type TFTs in the (n+1)-th row.

Generally, a driving circuit of a pixel of an AMOLED has a plurality of transistors, a parasitic capacitance is often formed between a gate node of a driving transistor of a driving circuit of a pixel and the data line adjacent to this gate node, so that a jump voltage on the data line affects a driving voltage of the driving transistor during a display process.

At least one embodiment of the present disclosure provides a display substrate, the display substrate includes a base substrate, a plurality of pixels arranged in an array are provided on the base substrate; each pixel of at least part of the plurality of pixels comprises a plurality of sub-pixels, each sub-pixel of at least part of the plurality of sub-pixels comprises a pixel circuit, the pixel circuit comprises: a light-emitting device, a storage capacitor, a driving transistor, a data writing transistor, a data line and a first connection structure. The light-emitting device, the storage capacitor, the driving transistor, the data writing transistor. Each of the driving transistor and the data writing transistor comprises an active layer, a gate electrode, a first electrode and a second electrode, the driving transistor is configured to control the light-emitting device to emit light; the data line is connected with the first electrode of the data writing transistor and is configured to provide a data signal to the data writing transistor; the data writing transistor is configured to write the data signal to the gate electrode of the driving transistor in response to a first scan signal applied to the gate electrode of the data writing transistor; and the first connection structure is connected with the gate electrode of the driving transistor and a first electrode plate of the storage capacitor, both the data line and the first connection structure extend along a first direction, and the data line comprises an overlapping part, the first connection structure is at least partially opposite to the overlapping part of the data line in a second direction, and the second direction is parallel to the base substrate and perpendicular to the first direction; the first connection structure and the overlapping part of the data line are insulated from each other, the first connection structure and the overlapping part of the data line respectively constitute a first electrode plate and a second electrode plate of a parasitic capacitance; and a ratio of a capacitance value of the parasitic capacitance to a capacitance value of the storage capacitor is greater than 0.001 and less than 0.01.

It should be noted that the capacitance value of the parasitic capacitance involved in the protection scope of the claims of the present disclosure shall be subjected to a calculation method disclosed in the specification.

At least one embodiment of the present disclosure further provides a display apparatus, and the display apparatus includes any one of the display substrates provided by the embodiments of the present disclosure.

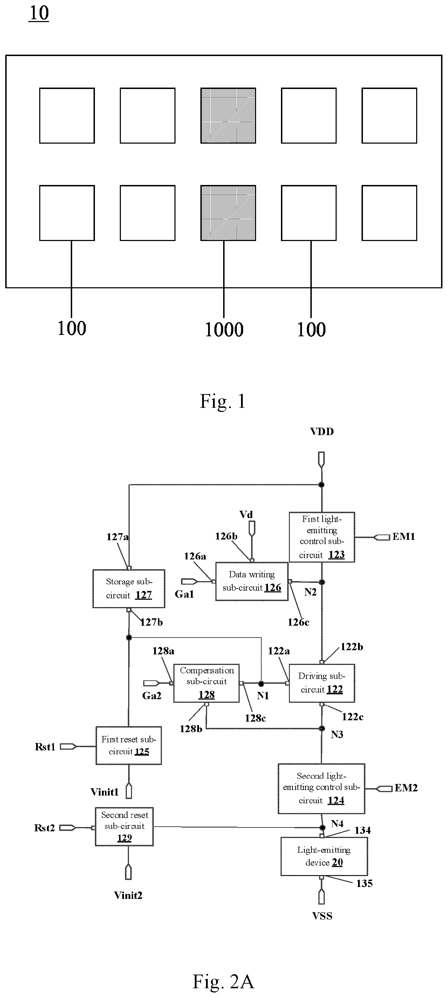

Exemplarily, Fig. 1 is a planar schematic diagram of a display substrate provided by an embodiment of the present disclosure. As shown in Fig. 1, for example, the display substrate 10 includes a plurality of pixels 100 arranged in an array, each pixel 100 of at least a part of the plurality of pixels 100 includes a plurality of sub-pixels, and each sub-pixel of at least a part of the plurality of sub-pixels includes a light-emitting device and a pixel circuit driving the light-emitting device to emit light. For example, the pixel circuit may include a 2T1C (that is, two transistors and a capacitor) pixel circuit, a 4T2C pixel circuit, a 5T1C pixel circuit, a 7T1C pixel circuit or an nTmC (n and m are positive integers) pixel circuit. For example, in different embodiments, the pixel circuit may also include a compensation sub-circuit, the compensation sub-circuit includes an internal compensation sub-circuit or an external compensation sub-circuit, the compensation sub-circuit may include transistors and capacitors. For example, as needed, the pixel circuit may further include a reset circuit, a light-emitting control sub-circuit and a detection circuit.

For example, as shown in Fig. 1, the plurality of pixels 100 are located in the display region. For example, in the display substrate 10 provided in some embodiments, some pixels among the plurality of pixels 100 are dummy pixels 1000, the dummy pixels 1000 do not participate in display work, each of the dummy pixels 1000 includes a plurality of dummy sub-pixels, and does not include sub-pixels that function as display driving.

For example, in some embodiments, the display substrate 10 is an organic light-emitting diode (OLED) display substrate, and the light-emitting device is OLED. The display substrate 10 may also include a plurality of scan lines and a plurality of data lines for providing scan signals (control signals) and data signals for the plurality of sub-pixels respectively, thus the plurality of sub-pixels are driven. As needed, the display substrate 10 may further include power lines, and detection lines and so on.

Fig. 2A is a schematic diagram of a pixel circuit provided by at least one embodiment of the present disclosure. As shown in Fig. 2A, the pixel circuit unit includes a driving sub-circuit 122, a compensation sub-circuit 128, a data writing sub-circuit 126, a storage sub-circuit 127, a first light-emitting control sub-circuit 123, a second light-emitting control sub-circuit 124, a first reset sub-circuit 125 and a second reset sub-circuit 129.

For example, the driving sub-circuit 122 includes a control terminal 122a, a first terminal 122b and a second terminal 122c, and is configured to be connected with the light-emitting device 20 and control a driving current flowing through the light-emitting device 20. The control terminal 122a of the driving sub-circuit 122 is connected with a first node N1, the first terminal 122b of the driving sub-circuit 122 is connected to a second node N2 and is configured to receive a first power supply voltage VDD, and the second terminal 122c of the driving sub-circuit 122 is connected to a third node N3.

For example, the data writing sub-circuit 126 includes a control terminal 126a, a first terminal 126b and a second terminal 126c, the control terminal 126a is configured to receive a first scan signal Ga1, and the first terminal 126b is configured to receive a data signal Vd, and the second terminal 126c is connected with the first terminal 122b (that is, the second node N2) of the driving sub-circuit 122. The data writing sub-circuit 126 is configured to write a data signal Vd into the first terminal 122b of the driving sub-circuit 122 in response to the first scan signal Ga1. For example, the first terminal 126b of the data writing sub-circuit 126 is connected with the data line 12 to receive the data signal Vd, and the control terminal 126a is connected with the gate line 11 serving as a scan line to receive the first scan signal Ga1. For example, during the data writing and compensation stage, the data writing sub-circuit 126 may be turned on in response to the first scan signal Ga1, thus the data signal can be written to the first terminal 122b (the second node N2) of the driving sub-circuit 122, and the data signal is stored in the storage sub-circuit 127, so that a driving current for driving the light-emitting device 20 to emit light can be generated according to the data signal during the light-emitting stage, for example.

For example, the compensation sub-circuit 128 includes a control terminal 128a, a first terminal 128b, and a second terminal 128c. The control terminal 128a of the compensation sub-circuit 128 is configured to receive a second scan signal Ga2, the first terminal 128b and the second terminal 128c of the compensation sub-circuit 128 are respectively electrically connected with the second terminal 122c and the control terminal 122a of the driving sub-circuit 122. The compensation sub-circuit 128 is configured to perform threshold compensation on the driving sub-circuit 122 in response to the second scan signal Ga2.

For example, the first scan signal Ga1 may be the same as the second scan signal Ga2. For example, the first scan signal Ga1 and the second scan signal Ga2 may be connected to a same signal output terminal. For example, the first scan signal Ga1 and the second scan signal Ga2 may be transmitted through a same scan line.

In other examples, the first scan signal Ga1 may also be different from the second scan signal Ga2. For example, the first scan signal Ga1 and the second scan signal Ga2 may be connected to different signal output terminals. For example, the first scan signal Ga1 and the second scan signal Ga2 may be respectively transmitted through different scan lines.

For example, the storage sub-circuit 127 includes a first terminal 127a and a second terminal 127b, the first terminal 127a of the storage sub-circuit is configured to receive a first power supply voltage VDD, and the second terminal 127b of the storage sub-circuit is electrically connected to the control terminal 122a of the driving sub-circuit.

For example, the storage sub-circuit 127 is electrically connected with the control terminal 122a and the first voltage terminal vdd of the driving sub-circuit 122, and is configured to store the data signal written by the data writing sub-circuit 126. For example, during the data writing and compensation stage, the compensation sub-circuit 128 may be turned on in response to the second scan signal Ga2, thus the data signal written by the data writing sub-circuit 126 can be stored in the storage sub-circuit 127. For example, at the same time, during the data writing and compensation stage, the compensation sub-circuit 128 may electrically connect the control terminal 122a and the second terminal 122c of the driving sub-circuit 122, so that relevant information related to a threshold voltage of the driving sub-circuit 122 can also be stored in the storage sub-circuit accordingly, therefore, for example, the stored data signal and the threshold voltage can be used to control the driving sub-circuit 122 during the light-emitting stage, so that the output of the driving sub-circuit 122 is compensated.

For example, the first light-emitting control sub-circuit 123 is connected with the first terminal 122b (the second node N2) of the driving sub-circuit 122 and the first voltage terminal vdd, and is configured to apply a first power supply voltage VDD from the first voltage terminal vdd to the first terminal 122b of the driving sub-circuit 122 in response to a first light-emitting control signal EM1. For example, as shown in Fig. 2A, the first light-emitting control sub-circuit 123 is connected with the first light-emitting control terminal EM1, the first voltage terminal vdd and the second node N2.

For example, the second light-emitting control sub-circuit 124 is connected with the second light-emitting control terminal EM2, the first terminal 134 of the light-emitting device 20 and the second terminal 122c of the driving sub-circuit 122, and is configured to enable the driving current to be applied to the light-emitting device 20 in response to a second light-emitting control signal.

For example, during the light-emitting stage, the second light-emitting control sub-circuit 124 is turned on in response to the second light-emitting control signal EM2 provided by the second light-emitting control terminal EM2, thus the driving sub-circuit 122 can be electrically connected with the light-emitting device 20 through the second light-emitting control sub-circuit 124, thereby, the light-emitting device 20 is driven to emit light under the control of the driving current; in a non-light-emitting stage, the second light-emitting control sub-circuit 124 is turned off in response to the second light-emitting control signal EM2, thus the current causing the light-emitting device 20 to emit light is prevented from flowing through the light-emitting device 20, and thus the contrast of the corresponding display apparatus can be improved.

For another example, in the initialization stage, the second light-emitting control sub-circuit 124 may also be turned on in response to the second light-emitting control signal EM2, thus the reset sub-circuit can be combined to perform the reset operation on the driving sub-circuit 122 and the light-emitting device 20.

For example, the second light-emitting control signal EM2 may be the same as the first light-emitting control signal EM1, for example, the second light-emitting control signal EM2 can be connected to the same signal output terminal as the first light-emitting control signal EM1, and for example, the second light-emitting control signal EM2 may be transmitted through the same light-emitting control line as the first light-emitting control signal EM1.

In other examples, the second light-emitting control signal EM2 may be different from the first light-emitting control signal EM1. For example, the second light-emitting control signal EM2 and the first light-emitting control signal EM1 may be from different signal output terminals respectively. For example, the second light-emitting control signal EM2 and the first light-emitting control signal EM1 may be respectively transmitted through different light-emitting control lines.

For example, the first reset sub-circuit 125 is connected to a first reset voltage terminal Vinit1 and the control terminal 122a (the first node N1) of the driving sub-circuit 122, and is configured to apply a first reset voltage Vinit1 to the control terminal 122a of the driving sub-circuit 122 in response to a first reset control signal Rst1.

For example, the second reset sub-circuit 129 is connected to a second reset voltage terminal Vinit2 and the first terminal 134 (a fourth node N4) of the light-emitting device 20, and is configured to apply a second reset voltage Vinit2 to the first terminal 134 of the light-emitting device 20 in response to a second reset control signal Rst2.

For example, the first reset sub-circuit 125 and the second reset sub-circuit 129 may be turned on respectively in response to the first reset control signal Rst1 and the second reset control signal Rst2, thus the second reset voltage Vinit2 can be applied to the first node N1 and the first reset voltage Vinit1 can be applied to the first terminal 134 of the light-emitting device 20 respectively, therefore, the reset operation can be performed on the driving sub-circuit 122, the compensation sub-circuit 128 and the light-emitting device 20, to eliminate the influence of the previous light-emitting stage.

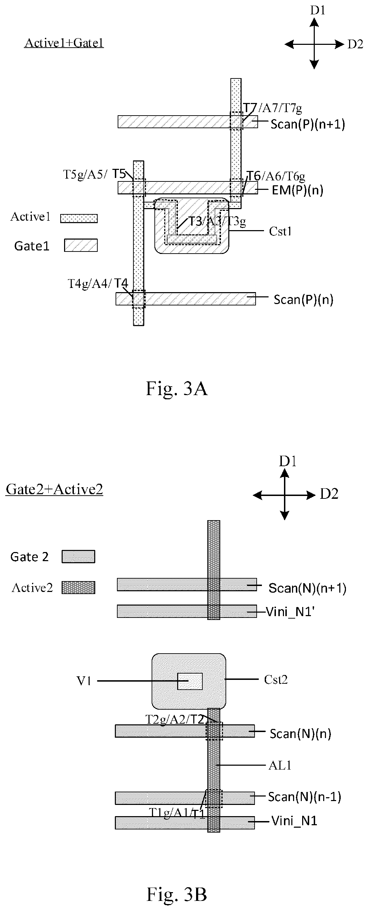

For example, the second reset control signal Rst2 of each row of sub-pixels may be a same signal as the first scan signal Ga1 of the same row of sub-pixels, both the second reset control signal Rst2 and the first scan signal Ga1 can be transmitted through the same gate line (for example, the reset control line 220b in Fig. 3A). For example, the first reset control signal Rst1 of each row of sub-pixels may be combined with the first scan signal Ga1 of the previous row of sub-pixels, both the first reset control signal Rst1 and the first scan signal Ga1 can be transmitted through the same gate line (for example, the reset control line 220a in Fig. 3A).

For example, as shown in Fig. 2A, the light-emitting device 20 includes a first terminal 134 and a second terminal 135, the first terminal 134 of the light-emitting device 20 is configured to be connected with the second terminal 122c of the driving sub-circuit 122, the second terminal 135 of the light-emitting device 20 is configured to be connected with the second voltage terminal VSS. For example, in one example, as shown in Fig. 2A, the first terminal 134 of the light-emitting device 20 may be connected with the fourth node N4 through the second light-emitting control sub-circuit 124. Embodiments of the present disclosure include but are not limited to this situation.

It should be noted that in the descriptions of the embodiments of the present disclosure, the first node N1, the second node N2, the third node N3 and the fourth node N4 do not necessarily represent actual existing components, rather represents meeting points of related circuit connections in a circuit diagram.

It should be noted that in the descriptions of the embodiments of the present disclosure, the symbol Vd may represent both a data signal terminal and a level of a data signal, similarly, the symbols Ga1 and Ga2 may represent the first scan signal and the second scan signal, may also represent the first scan signal terminal and the second scan signal terminal, and the symbol Rst1 may represent both the first reset control terminal and the first reset control signal. The symbol Rst2 may represent both the second reset control terminal and the second reset control signal, the symbols Vinit1 and Vinit2 may represent not only the first reset voltage terminal and the second reset voltage terminal, but also the first reset voltage and the second reset voltage respectively, the symbol VDD may represent both the first power supply voltage and the first power line, and the symbol VSS may represent both the public power supply voltage and the public power line. The following embodiments are the same and will not be described again.

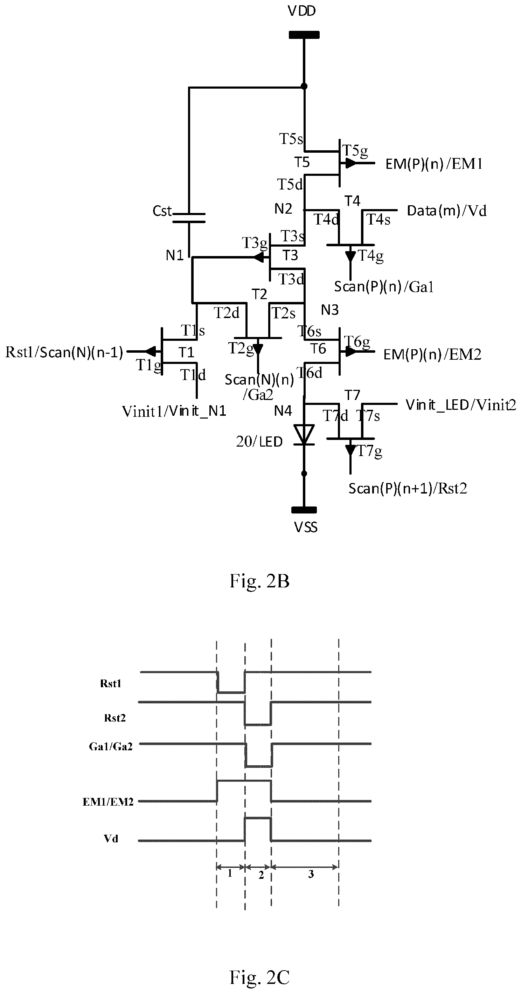

Fig. 2B is a circuit diagram of a specific implementation of the pixel circuit shown in Fig. 2A. As shown in Fig. 2B, the pixel circuit includes the first to the seventh transistors T1, T2, T3, T4, T5, T6, T7 and a storage capacitor Cst. For example, the third transistor T3 is used as the driving transistor, the first transistor T1, the second transistor T2, the fourth transistor T4, the fifth transistor T5, the sixth transistor T6 and the seventh transistor are used as switch transistors.

For example, as shown in Fig. 2B, the driving sub-circuit 122 may be implemented as the third transistor T3. The gate electrode of the third transistor T3 serves as the control terminal 122a of the driving sub-circuit 122, and is connected with the first node N1; the first electrode of the third transistor T3 serves as the first terminal 122b of the driving sub-circuit 122, and is connected with the second node N2; and the second electrode of the third transistor T3 serves as the second terminal 122c of the driving sub-circuit 122, and is connected with the third node N3.

For example, as shown in Fig. 2B, the data writing sub-circuit 126 may be implemented as the fourth transistor T4. The gate electrode T4g of the fourth transistor T4 is connected with the first scan line (the first scan signal terminal Ga1) to receive the first scan signal, the first electrode T4s of the fourth transistor T4 is connected with the data line (the data signal terminal Vd) to receive the data signal, and the second electrode T4d of the fourth transistor T4 is connected with the first terminal 122b (the second node N2) of the driving sub-circuit 122.

For example, as shown in Fig. 2B, the compensation sub-circuit 128 may be implemented as the second transistor T2. The gate electrode T2g, the first electrode T2s and the second electrode T2d of the second transistor T2 respectively serve as the control terminal 128a, the first terminal 128b and the second terminal 128c of the compensation sub-circuit. The gate electrode of the second transistor T2 is configured to be connected with the second scan line (the second scan signal terminal Ga2) to receive the second scan signal, the first electrode T2s of the second transistor T2 is connected with the second electrode T3d (the third node N3) of the third transistor T3, and a second electrode T3d of the second transistor T2 is electrically connected with the gate electrode T1g (the first node N1) of the third transistor T3. For example, as shown in Fig. 2B, the storage sub-circuit 127 may be implemented as the storage capacitor Cst, the storage capacitor Cst includes a first electrode plate Cst1 and a second electrode plate Cst2, the first electrode plate Cst2 is electrically connected with the first voltage terminal vdd, and the second electrode plate Cst1 is electrically connected with the gate electrode T1g (the first node N1) of the third transistor T3.

For example, as shown in Fig. 2B, the first light-emitting control sub-circuit 123 may be implemented as the fifth transistor T5. The fifth transistor T5 is a first light-emitting control transistor. The gate electrode T5g of the fifth transistor T5 is connected with a first light-emitting control line (the first light-emitting control terminal EM1) to receive the first light-emitting control signal, the first electrode T5s of the fifth transistor T5 is connected with the first voltage terminal vdd to receive the first power supply voltage VDD, and the second electrode T5d of the fifth transistor T5 is connected with the first terminal 122b (the second node N2) of the driving sub-circuit 122.

For example, the light-emitting device 20 is implemented as a light-emitting diode (LED), for example, may be an organic light-emitting diode (OLED), a quantum dot light-emitting diode (QLED) or an inorganic light-emitting diode, for example, the light-emitting device 20 may be a micro light-emitting diode (Micro LED) or a micro OLED. For example, the light-emitting device 20 may be a top-emitting structure, a bottom-emitting structure, or a double-sided emitting structure. The light-emitting device 20 can emit red light, green light, blue light or white light. The embodiments of the present disclosure do not limit the specific structure of the light-emitting device.

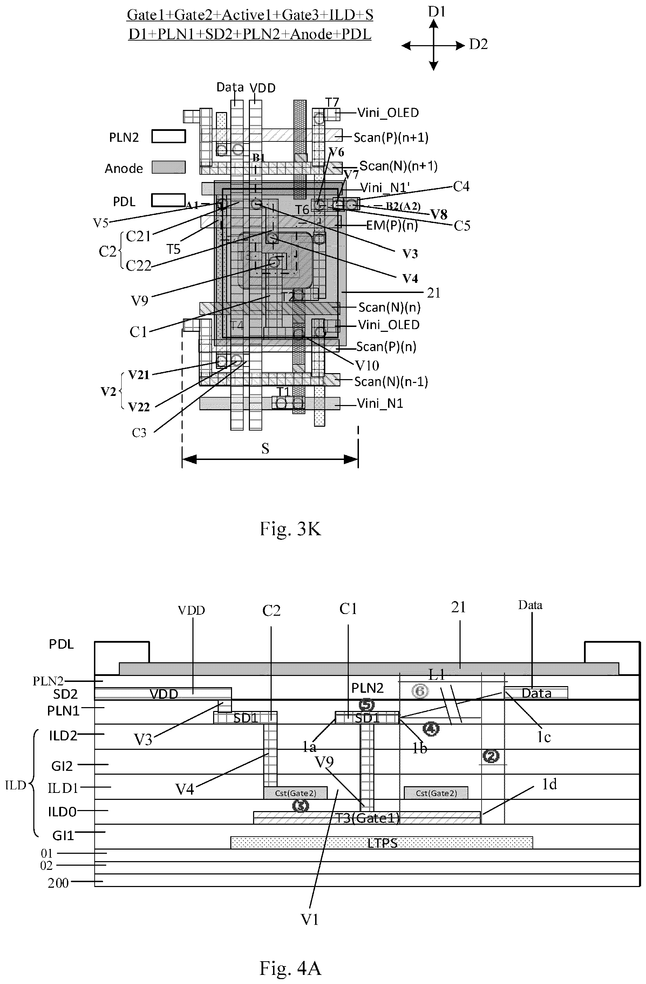

For example, a first end of the light-emitting device 20 includes a first display electrode 21 (as shown in Fig. 4A), the first display electrode is connected with the fourth node N4 and is configured to be connected with the second terminal 122c of the driving sub-circuit 122 through the second light-emitting control sub-circuit 124, a second end of the light-emitting device 20 includes a second display electrode (for example, a cathode), the second display electrode is configured to be connected with the common power supply voltage terminal VSS to receive the public power supply voltage VSS, a circuit flowing into the light-emitting device 20 from the second terminal 122c of the driving sub-circuit 122 determines brightness of the light-emitting device. For example, the common power supply voltage terminal VSS may be grounded, that is, VSS may be 0V. For example, the common supply voltage VSS may be a negative voltage.

For example, the second light-emitting control sub-circuit 124 may be implemented as the sixth transistor T6. The fifth transistor T6 is a second light-emitting control transistor. The gate electrode T6g of the sixth transistor T6 is connected with a second light-emitting control line (the second light-emitting control terminal EM2) to receive the second light-emitting control signal, the first electrode T6s of the sixth transistor T6 is connected to the second terminal 122c (the third node N3) of the driving sub-circuit 122, and the second electrode T6d of the sixth transistor T6 is connected with the first terminal 134 (the fourth node N4) of the light-emitting device 20.

For example, the first reset sub-circuit 125 may be implemented as the first transistor T1, the second reset sub-circuit 129 is implemented as the seventh transistor T7. The gate electrode T1g of the first transistor T1 is configured to be connected with a first reset control terminal Rst1 to receive the first reset control signal Rst1, the first electrode T1s of the first transistor T1 is connected with the first reset voltage terminal Vinit1 to receive the first reset voltage Vinit1, the second electrode T1d of the first transistor T1 is configured to be connected to the first node N1. The gate electrode T7g of the seventh transistor T7 is configured to be connected with a second reset control terminal Rst2 to receive the second reset control signal Rst2, the first electrode T7s of the seventh transistor T7 is connected to a second reset voltage terminal Vinit2 to receive the second reset voltage Vinit2, and the second electrode T7d of the seventh transistor T7 is configured to be connected to the fourth node N4.

It should be noted that the transistors used in the embodiments of the present disclosure may be thin film transistors or field effect transistors or other switch devices with the same characteristics. In the embodiments of the present disclosure, thin film transistors are taken as examples for description. The source electrodes and the drain electrodes of the transistors used herein may be symmetrical in structure, therefore, there may be no structural difference between the source electrodes and the drain electrodes. In the embodiment of the present disclosure, in order to distinguish the two electrodes of the transistor except the gate electrode, one electrode is directly described as the first electrode and the other electrode is the second electrode.

In addition, transistors can be divided into N-type transistors and P-type transistors according to their characteristics. In the case where the transistor is a P-type transistor, a turn-on voltage is a low-level voltage (for example, 0V, -5V, -10V or other suitable voltages), a turn-off voltage is a high-level voltage (for example, 5V, 10V or other suitable voltage); in the case where the transistor is an N-type transistor, a turn-on voltage is a high-level voltage (for example, 5V, 10V or other suitable voltage), a turn-off voltage is a low-level voltage (for example, 0V, -5V, -10V or other suitable voltage). For example, as shown in Fig. 2B, the first to the seventh transistors T1 to T7 are all P-type transistors, such as low-temperature polysilicon thin film transistors. However, the embodiment of the present disclosure does not limit the type of the transistors, in the case where the type of the transistors is changed, the connection relationship in the circuit can be adjusted accordingly.

The working principle of the pixel circuit shown in Fig. 2B will be described below in conjunction with the signal timing diagram shown in Fig. 2C. As shown in Fig. 2C, a display process of each frame image includes three stages, namely an initialization stage 1, a data writing and compensation stage 2, and a light-emitting stage 3.

For example, with reference to Fig. 2B and Fig. 3A to Fig. 3B, the first scan signal Ga1 is provided by the first scan signal line Scan(P)(n), the second scan signal Ga2 is provided by the second scan signal line Scan(N)(n); and the first light-emitting control signal EM1 and the second light-emitting control signal EM2 are both provided by the light-emitting control line EM(P)(n). Fig. 2C is a signal timing diagram of a driving method for the pixel circuit provided by at least one embodiment of the present disclosure. As shown in Fig. 2C, in this embodiment, the first scan signal Ga1 and the second scan signal Ga2 adopt a same signal, the first light-emitting control signal EM1 and the second light-emitting control signal EM2 adopt a same signal. For example, the second reset control signal Rst2 and the first scan signal Ga1/ the second scan signal Ga2 may also use a same signal, that is, waveforms of the second reset control signal Rst2 and the first scan signal Ga1/second scan signal Ga2 are the same; the first reset signal Rst1 of the sub-pixels in a present row has a same waveform as the first scan signal Ga1/second scan signal Ga2 of the sub-pixels in a previous row, that is, the first reset signal Rst1 of the sub-pixels in the present row and the first scan signal Ga1/second scan signal Ga2 of the sub-pixels in the previous row are a same signal. However, this is not intended to limit the invention, in other embodiments, different signals may be respectively used as the first scan signal Ga1, the second scan signal Ga2, the first reset control signal Rst1, and the second reset control signal Rst2, and different signals may be respectively used as the first light-emitting control signal EM1 and the second light-emitting control signal EM2.

In the initialization stage 1, the first reset control signal Rst1 is input to turn on the first transistor T1, and the first reset voltage Vinit1 is applied to the gate electrode of the third transistor T3, thus the first node N1 is reset.

In the data writing and compensation stage 2, the first scan signal Ga1, the second scan signal Ga2 (for example, the compensation scan signal) and the data signal Vd are input, the fourth transistor T4 and the second transistor T2 are turned on, the data signal Vd is written into the second node N2 by the fourth transistor T4, and the first node N1 is charged through the third transistor T3 and the second transistor T2 until the potential of the first node N1 changes to Vd+Vth, and thus the third transistor T3 is turned off, Vth is a threshold voltage of the third transistor T3. The potential of the first node N1 is stored and maintained in the storage capacitor Cst, that is, the voltage information with the data signal and threshold voltage Vth is stored in the storage capacitor Cst, it is used to provide grayscale display data and compensate the threshold voltage of the third transistor T3 during the subsequent light-emitting stage.

In the data writing and compensation stage 2, the second reset control signal Rst2 may also be input to turn on the seventh transistor T7, the second reset voltage Vinit2 is applied to the fourth node N4, thus the fourth node N4 is reset. For example, the resetting of the fourth node N4 may also be performed in the initialization stage 1, for example, the first reset control signal Rst1 and the second reset control signal Rst2 may be the same. The embodiment of the present disclosure does not limit this.

In the light-emitting stage 3, the first light-emitting control signal EM1 and the second light-emitting control signal EM2 are input to turn on the fifth transistor T5, the sixth transistor T6 and the third transistor T3, the sixth transistor T6 applies a driving current to the OLED to cause the OLED to emit light. A value of the driving current Id flowing through the OLED can be obtained according to the following formula:

$$Id = K\,(VGS - Vth)2 = K\,[\,(Vd + Vth - VDD) - Vth\,]2 = K\,(Vd - VDD)2,$$

in which K is the conductivity of the first transistor.

In the above formula, Vth represents the threshold voltage of the third transistor T3, VGS represents a voltage between the gate electrode and the source electrode (here, referring to the first electrode) of the third transistor T3, and K is a constant value related to the third transistor T3. It can be seen from the above calculation formula of Id that the driving current Id flowing through the OLED is no longer related to the threshold voltage Vth of the third transistor T3, in this way, compensation for the pixel circuit can be achieved, and the problem of threshold voltage drift of the driving transistor (the third transistor T3 in the embodiment of the present disclosure) caused by the manufacturing process and long-term operation is solved, and the influence caused by the problem of threshold voltage drift on the driving current Id is eliminated. Therefore, the display effect of the display apparatus adopting the pixel circuit can be improved.

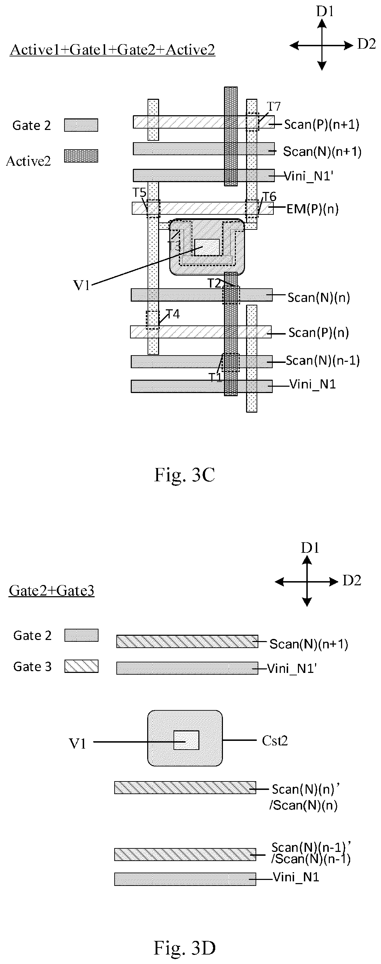

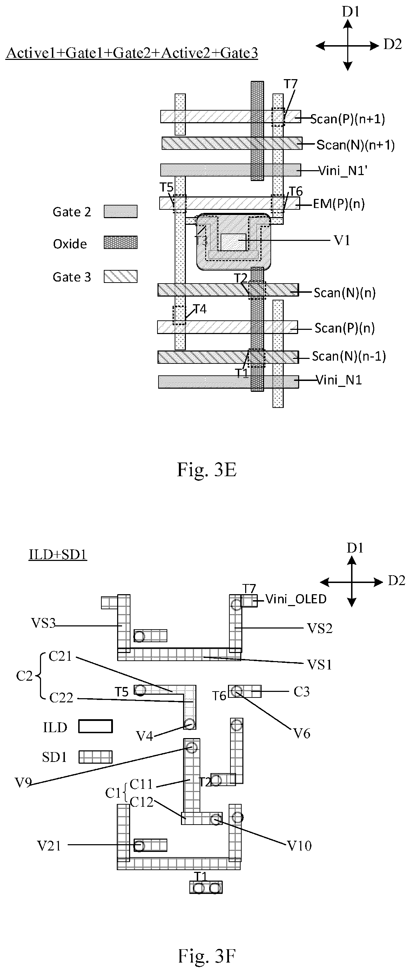

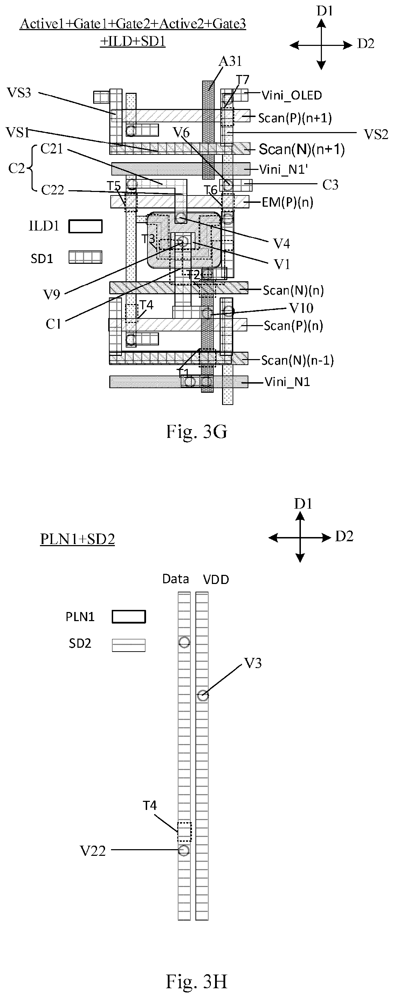

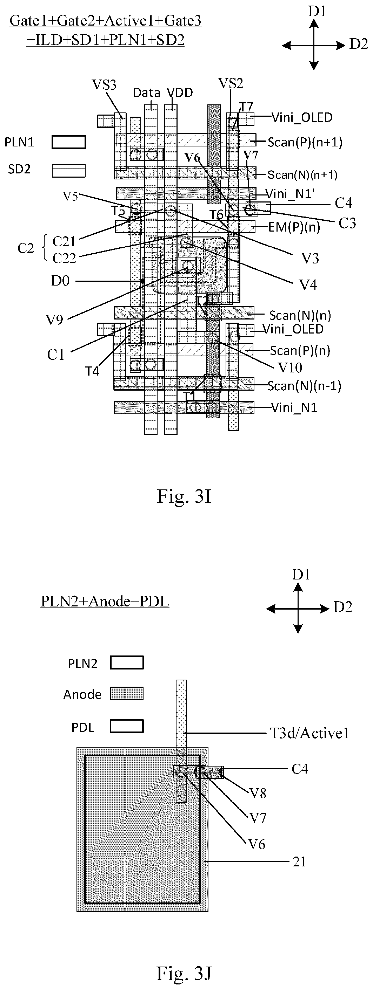

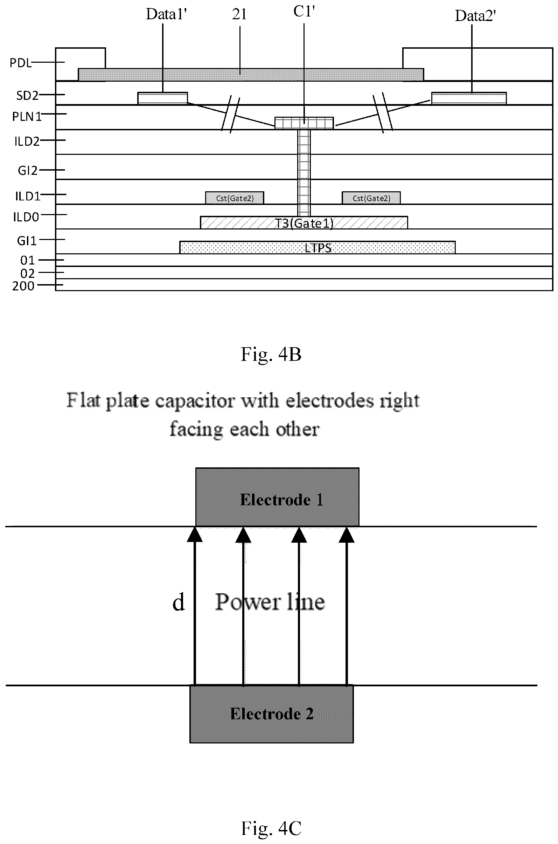

Fig. 3A is a planar schematic diagram showing a first semiconductor layer and a first conductive layer that are stacked of a sub-pixel of a display substrate provided by an embodiment of the present disclosure. Fig. 3B is a planar schematic diagram showing a second conductive layer and a second semiconductor layer that are stacked of a sub-pixel of a display substrate provided by an embodiment of the present disclosure. Fig. 3C is a planar schematic diagram showing a first semiconductor layer, a first conductive layer, a second conductive layer and a second semiconductor layer that are stacked of a sub-pixel of a display substrate provided by an embodiment of the present disclosure. Fig. 3D is a planar schematic diagram showing a second conductive layer and a third conductive layer that are stacked of a sub-pixel of a display substrate provided by an embodiment of the present disclosure. Fig. 3E is a planar schematic diagram showing a first semiconductor layer, a first conductive layer, a second conductive layer, a second semiconductor layer and a third conductive layer that are stacked of a sub-pixel of a display substrate provided by an embodiment of the present disclosure. Fig. 3F is a planar schematic diagram showing a first interlayer insulation layer and a fourth conductive layer that are stacked of a sub-pixel of a display substrate provided by an embodiment of the present disclosure. Fig. 3G is a planar schematic diagram showing a first semiconductor layer, a first conductive layer, a second conductive layer, a second semiconductor layer, a third conductive layer, a first interlayer insulation layer and a fourth conductive layer that are stacked of a sub-pixel of a display substrate provided by an embodiment of the present disclosure. Fig. 3H is a planar schematic diagram showing a first planarization layer and a fifth conductive layer that are stacked of a sub-pixel of a display substrate provided by an embodiment of the present disclosure. Fig. 3I is a planar schematic diagram showing a first semiconductor layer, first conductive layer, a second conductive layer, a second semiconductor layer, a third conductive layer, a first interlayer insulation layer, a fourth conductive layer, a first planarization layer and a fifth conductive layer that are stacked of a sub-pixel of a display substrate provided by an embodiment of the present disclosure. Fig. 3J is a planar schematic diagram showing a second planarization layer, a first electrode and a pixel definition layer that are stacked of a sub-pixel of a display substrate provided by an embodiment of the present disclosure. Fig. 3K is a planar schematic diagram of a sub-pixel of a display substrate provided by an embodiment of the present disclosure, that is, a planar schematic diagram of a stack structure of a first semiconductor layer, a first conductive layer, a second conductive layer, a second semiconductor layer, a third conductive layer, a first interlayer insulation layer, a fourth conductive layer, a first planarization layer, a fifth conductive layer, a second planarization layer, a first electrode and a pixel definition layer that are stacked of the sub-pixel. Fig. 4A is a cross-sectional schematic diagram along an extension direction of an active layer of a third transistor and an extension direction of an active layer of a sixth transistor in Fig. 3K in sequence. Fig. 4B is a structural schematic diagram of a display substrate.

Fig. 3A to Fig. 3I and Fig. 4A, the display substrate 10 includes a base substrate 200, a first signal line that overall extends along the second direction D2 and a second signal line that overall extends along the first direction D1 intersecting the second direction D2, the first signal line and the second signal line are arranged on the base substrate 200; for example, the first signal line intersects the second signal line to define a plurality of sub-pixels 100. It should be noted that the boundary of each of the plurality of sub-pixels is not necessarily the first signal line and the second signal line. The feature "the first signal line intersects the second signal line to define a plurality of sub-pixels" means that the arrangement mode of the plurality of sub-pixels is consistent with the arrangement mode of the regions defined by the intersections of the first signal lines and the second signal lines, that is, the plurality of sub-pixels correspond to the plurality of regions defined by the intersections of the first signal lines and the second signal lines. For example, the first signal line is a gate line serving as a scan signal line, and the second signal line is a data line; or, in some other embodiments, the first signal line is a data line, and the second signal line is a gate line serving as a scan signal line.

It should be noted that in the present disclosure, the description "overall extends/ extending along the second direction" means extending along the second direction as a whole, at least the overall extension trend is to extend along the second direction. Taking the first signal line as an example, in some examples, the first signal line that overall extends along the second direction may have a certain curved part, for example, may include a part in a wavy shape; or, in some examples, the edge extending along the second direction of the first signal line that extends overall in the second direction may not be a smooth line, for example, the edge of the first signal line may have burrs or jagged edges. To sum up, it is only required that the first signal line is in a strip shape overall extending along the second direction. The same is true for "overall extends/ extending along the first direction". For example, the data line overall extends along the first direction, for another example, the first connection structure described below overall extends along the first direction.

Each of at least part of sub-pixels of the plurality of sub-pixels includes a pixel circuit, and the pixel circuit includes the light-emitting device 20, the driving transistor T1, and the data writing transistor T2 that are mentioned above. For example, the at least part of sub-pixels of the plurality of sub-pixels refer to sub-pixels that perform a display function, not dummy sub-pixels.

As shown in Fig. 3F and Fig. 3I, the pixel circuit further includes a first connection structure C1, the first connection structure C1 is connected with a gate electrode T3g of a driving transistor T3 and a first electrode plate Cst1 of a storage capacitor Cst, both the data line Data and the first connection structure C1 overall extend along the first direction D1, and the data line Data includes an overlapping part D0, the first connection structure C1 is at least partially right opposite to the overlapping part D0 of the data line Data, that is, the first connection structure C1 and the overlapping part D0 of the data line Data are at least partially right opposite to each other in the second direction D2, the second direction D2 is parallel to the base substrate 200 and is perpendicular to the first direction D1; for example, the entire overlapping part D0 is right opposite to the first connection structure C1 in the second direction D2. The overlapping part D0 of the data line Data is insulated from the first connection structure C1, the first connection structure C1 and the overlapping part D0 of the data line Data respectively constitutes a first electrode plate and a second electrode plate of the parasitic capacitance Cgd; a ratio of a capacitance value of the parasitic capacitance Cgd to a capacitance value of the storage capacitor Cst is greater than 0.001 and less than 0.01. In this way, it is obtained through experiments that in the case where the ratio of the capacitance value of the parasitic capacitor Cgd to the capacitance value of the storage capacitor Cst is less than 0.01, the voltage charged to the storage capacitor Cgd (that is, the data signal) loses at most 1% (deviates from 1%), so that the OLED driving current loses at most 1% (deviates from 1%), thus the deviation of the light-emitting brightness is controlled within a small range. By controlling the ratio of the capacitance value of the parasitic capacitance Cgd to the capacitance value of the storage capacitance Cst within this range, it is possible to achieve a high PPI while achieving a small parasitic capacitance Cgd, and an impact caused by a jump voltage on the data line Data on the driving voltage of the driving transistor T3 during the display process is significantly reduced, thus higher display quality is achieved.

Taking a sub-pixel as an example, as shown in Fig. 3K, for example, in at least one embodiment, a size S (Pixel Pitch) of one sub-pixel 100 in the second direction D2 is greater than 50$\mu$m, the ratio of the capacitance value of the parasitic capacitance Cgd to the capacitance value of the storage capacitor Cst is less than 0.005. It has been found through experiments that in a display substrate with sub-pixels designed with this size, if the ratio of the capacitance value of the parasitic capacitance Cgd to the capacitance value of the storage capacitor Cst is less than 0.005, the impact caused by the jump voltage on the data line Data on the driving voltage of the driving transistor T3 during the display process can be significantly reduced, while achieving a high PPI, thus a better display effect is obtained. Especially in large-size display substrates or display panels, such as display substrates or display panels larger than 55 inches, the effect of reducing the impact caused by the jump voltage on the data line Data on the driving voltage of the driving transistor T3 during the display process is particularly significant while taking into account the realization of a high PPI.

As shown in Fig. 3K, for example, in at least one embodiment, the size S of one sub-pixel 100 in the second direction D2 is less than or equal to 68$\mu$m, the ratio of the capacitance value of the parasitic capacitance Cgd to the capacitance value of the storage capacitor Cst is greater than or equal to 0.003. It has been found through experiments that in a display substrate with sub-pixels designed with this size, the ratio of the capacitance value of the parasitic capacitance Cgd to the capacitance value of the storage capacitor Cst can be greater than or equal to 0.003, moreover, in this case, the impact caused by the jump voltage on the data line Data on the driving voltage of the driving transistor T3 during the display process can be significantly reduced, while also taking into account the realization of a high PPI, thus better display effect is obtained. Especially in large-size display substrates or display panels, such as display substrates or display panels larger than 55 inches, the effect of reducing the impact caused by the jump voltage on the data line Data on the driving voltage of the driving transistor T3 during the display process is particularly significant while taking into account the realization of a high PPI.

As shown in Fig. 3K, for example, in at least one embodiment, the size S of one sub-pixel 100 in the second direction D2 is less than 50$\mu$m, the ratio of the capacitance value of the parasitic capacitance Cgd to the capacitance value of the storage capacitor Cst is greater than 0.005 and less than 0.006. It has been found through experiments that in a display substrate with sub-pixels designed with this size, a single sub-pixel is smaller in size so as to achieve a high PPI, in this case, the jump voltage on the data line Data has a greater impact on the driving voltage of the driving transistor T3, the ratio of the capacitance value of the parasitic capacitance Cgd to the capacitance value of the storage capacitor Cst is greater than 0004 and less than 0.006, which can achieve a high PPI while reducing the impact caused by the jump voltage on the data line Data on the driving voltage of the driving transistor T3 during the display process, and a relatively high-quality display effect can be obtained while taking both of the two into consideration. Especially in large-size display substrates or display panels, such as display substrates or display panels larger than 55 inches, the effect of reducing the impact cause by the jump voltage on the data line Data on the driving voltage of the driving transistor T3 during the display process is particularly significant while taking into account the realization of a high PPI.

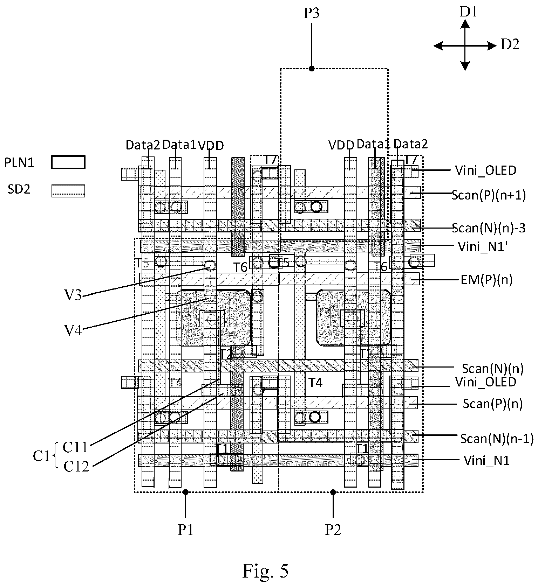

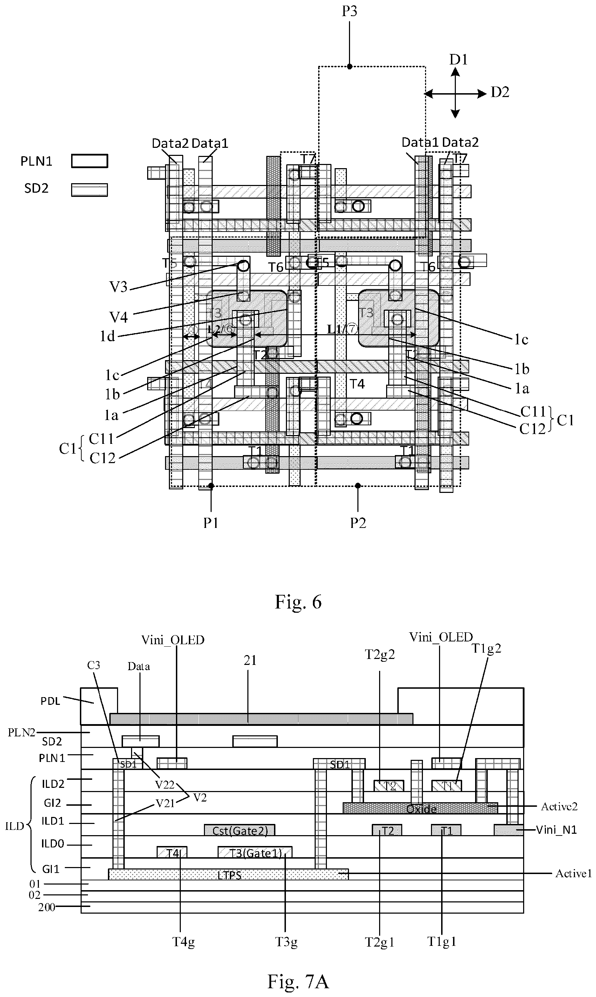

Fig. 5 is a planar schematic diagram of at least two adjacent sub-pixels of a display substrate provided by an embodiment of the present disclosure. Fig. 6 is a schematic diagram with a first power line being removed based on Fig. 5. For example, as shown in Fig. 5 and Fig. 6, the plurality of sub-pixels 100 include a first sub-pixel P1 and a second sub-pixel P2 that are adjacent to each other in the second direction D2. In one sub-pixel, for example, in the first sub-pixel P1, the first connection structure C1 includes a first part C11 extending along the first direction D1 and a second part C12 extending along the second direction, the second part C12 is connected with the first part C11, an edge of the first part C11 close to the overlapping part D0 of the data line Data is a first edge 1a, the first part C11 further has a second edge 1b away from the overlapping part D0 of the data line Data, and an edge of the overlapping part D0 of the data line Data close to the first connection structure C1 is a third edge 1c. For the first sub-pixel P1 and second sub-pixel P2 that are adjacent, the distance from the orthographic projection of the second edge 1b of the first connection structure C1 of the first sub-pixel P1 on the base substrate 200 to the third edge 1c of the overlapping part D0 of the data line Data of the second sub-pixel P2 on the base substrate 200 is a first distance L1, that is, the distance ⑥ in Fig. 4A and Fig. 6, a distance from the first edge 1a of the first connection structure C1 of the first sub-pixel P1 to the third edge 1c of the overlapping part D0 of the data line Data of the first sub-pixel P1 is a second distance L2, that is, the distance ⑦ in Fig. 6, a ratio of the first distance L1 to the second distance L2 is greater than 14. In this way, on the one hand, it can be ensured that the first connection structure C1 of the present sub-pixel is separated from the data line Data of the adjacent sub-pixel by a sufficient distance, the distance L1 is greater than 14 times the distance L2 between the first connection structure C1 of the sub-pixel and the data line Data of the present sub-pixel. Therefore, the parasitic capacitance Cgd formed by the data lines Data of the adjacent sub-pixels on the first connection structure C1 of the current sub-pixel is greatly reduced, and thus the impact caused by the jump voltage on the data line Data on the driving voltage of the driving transistor T3 during the display process is greatly reduced, so that the display quality is improved.

For example, the above definitions of the first distance L1 and the second distance L2 are applicable to any one of the sub-pixels in the pixel array of the display substrate. Therefore, the following descriptions of the first distance L1 in the second sub-pixel P2 is also the same.

Comparing the display substrate shown in Fig. 4B with the display substrate provided by an embodiment of the present application shown in Fig. 5 and Fig. 6 of the present disclosure, it can be seen that, in the display substrate shown in Fig. 4B, two data lines Data1' and Data2' are respectively arranged at the positions closer to the first connection structure C1' respectively on the left side and the right side of a sub-pixel, which causes that large parasitic capacitances are generated between the first connection structure C1' and both the data lines Data1' and Data2' on the left side and the right side of the first connection structure C1', and thereby the display quality is seriously affected. However, in the display substrate provided by an embodiment of the present application shown in Fig. 5 and Fig. 6 of the present disclosure, a ratio of the first distance L1 to the second distance L2 is greater than 14, which can better avoid this problem.

For example, in at least one embodiment, the size S of one sub-pixel 100 in the second direction D2 is less than 50$\mu$m, the ratio of the first distance L1 to the second distance L2 is greater than 14 and less than 15.5. It is proved through experiments that in a display substrate with sub-pixels designed with the size S smaller than 50um, the ratio of the first distance L1 to the second distance L2 is greater than 14 and less than 15.5, which can achieve a high PPI while achieving a small parasitic capacitance Cgd. Especially for large-size display substrates or display panels, such as display substrates or display panels larger than 55 inches, the effect of reducing the impact caused by the jump voltage on the data line Data on the driving voltage of the driving transistor T3 during the display process is particularly significant while the realization of a high PPI is taken into account.

For example, in at least one embodiment, the size S of one sub-pixel 100 in the second direction D2 is greater than 50$\mu$m, for example, 50um<the size S<68$\mu$m, the ratio of the first distance L1 to the second distance L2 is greater than 15.5. It is proved through experiments that in a display substrate with sub-pixels designed with the size S smaller than 50$\mu$m, the ratio of the first distance L1 to the second distance L2 is greater than 14 and less than 15.5, which can achieve a high PPI while achieving a small parasitic capacitance Cgd, especially for large-size display substrates or display panels, such as display substrates or display panels larger than 55 inches, the effect of reducing the impact caused by the jump voltage on the data line Data on the driving voltage of the driving transistor T3 during the display process is particularly significant while taking into account the realization of a high PPI.

For example, in the embodiment shown in Fig. 5 and Fig. 6, the first connection structure C1 of the first sub-pixel P1 is located between the data line Data1 of the first sub-pixel P1 and the data line Data1 of the second sub-pixel P2 in the second direction D2. It should be noted that in Fig. 5 and Fig. 6, the data line Data2 located at the left side of the data line Data1 of the first sub-pixel P1 and adjacent to the data line Data1 of the first sub-pixel P1 is the data line of a sub-pixel (not shown in full) at the left side of the first sub-pixel P1 and adjacent to the first sub-pixel P1, the data line Data2 located at the right side of the data line Data1 of the second sub-pixel P2 and adjacent to the data line Data1 of the second sub-pixel P2 is the data line of a sub-pixel (not shown in full) at the right side of the second sub-pixel P2 and adjacent to the second sub-pixel P2. For example, the distance between the orthographic projection of the first connection structure C1 of the first sub-pixel P1 on the base substrate 200 and the orthographic projection of the data line Data of the first sub-pixel P1 on the base substrate 200 is smaller than the size of one sub-pixel 100 in the second direction D2, and the distance between the orthographic projection of the first connection structure C1 of the first sub-pixel P1 on the base substrate 200 and the orthographic projection of the data line Data of the second sub-pixel P2 on the base substrate 200 is greater than the size of one sub-pixel 100 in the second direction D2. For example, at least the first connection structures C1 and the data lines Data of the first sub-pixel P1 and the second sub-pixel P2 that are adjacent to each other are symmetrical (mirror symmetric) with respect to a symmetry axis extending along the first direction. In this way, it can better satisfy the situation that the ratio of the first distance L1 to the second distance L2 is greater than 14 as much as possible, that is, the distance between the data line Data of the second sub-pixel P1 and the first connection structure C1 of the first sub-pixel P1 is maximized, the length in the first direction can be fully utilized to design the layout of the pixel circuit to achieve a higher PPI.

Or, in other embodiments, for example, the distance between the orthographic projection of the first connection structure C1 of the first sub-pixel P1 on the base substrate 200 and the orthographic projection of the data line Data of the first sub-pixel P1 on the base substrate 200 is less than the size S of one sub-pixel in the second direction D2, and the distance between the orthographic projection of the first connection structure C1 of the first sub-pixel P1 on the base substrate 200 and the orthographic projection of the data line Data of the second sub-pixel P2 on the base substrate 200 is smaller than the size S of one of the sub-pixels 100 in the second direction D2. That is, at least the first connection structures C1 and the data lines Data of the first sub-pixel P1 and the second sub-pixel P2 that are adjacent to each other are asymmetric (non-mirror symmetric) with respect to a axis extending along the first direction. The embodiment of the present disclosure does not limit the specific positions of each structure of the pixel circuit, as long as the above-mentioned relationship between the first distance L1 and the second distance L2 is satisfied.

For example, as shown in Fig. 5 and Fig. 6, an edge of the gate electrode T3g of the driving transistor T3 of the first sub-pixel P1 close to the overlapping part D0 of the data line Data of the second sub-pixel P2 is a fourth edge 1d. A distance from the second edge 1b of the first sub-pixel P1 to the third edge 1c of the second sub-pixel P2 is equal to a sum of a distance between the second edge 1b of the first sub-pixel P1 and the fourth edge 1d of the first sub-pixel P1 and a distance between the fourth edge 1d of the first sub-pixel P1 and the third edge 1c of the second sub-pixel P2.

For example, referring to Fig. 4A, the first connection structure C1 and the data line Data are arranged in different layers, the orthographic projection of the first connection structure C1 on the base substrate 200 is not overlapped with the orthographic projection of the overlapping part D0 of the data line Data on the base substrate 200. Or, in some other embodiments, the first connection structure C1 and the data line Data are arranged in different layers, the orthographic projection of the first connection structure C1 on the base substrate 200 at least partially is overlapped with the orthographic projection of the overlapping part D0 of the data line Data on the base substrate 200.

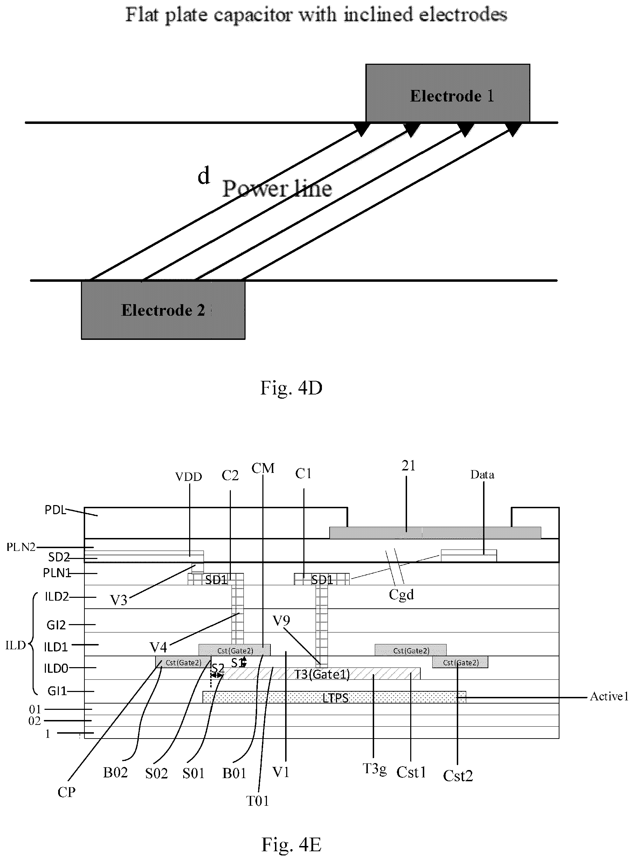

Fig. 4C is a schematic diagram of a flat plate capacitor with electrodes right facing each other; Fig. 4D is a schematic diagram of a flat plate capacitor with inclined electrodes. Referring to Fig. 4C, the flat plate capacitor with electrodes right facing each other refers to a flat plate capacitor in which the two electrode plates of the flat plate capacitor, such as an electrode 1 and an electrode 2, right face each other, that is, the opposite surfaces of the electrode 1 and the electrode 2 are parallel to each other and the orthographic projections of the electrode 1 and the electrode 2 on a plane, parallel to the opposite surfaces facing each other, are overlapped. Referring to Fig. 4D, the flat plate capacitor with inclined electrodes refers to a flat plate capacitor in which the two electrode plates of the flat plate capacitor such as the electrode 1 and the electrode 2, and the opposite surfaces are parallel to each other and the orthographic projections of the electrode 1 and the electrode 2 on a surface, parallel to the opposite surfaces facing each other, are partially overlapped or are not overlapped. The capacitance value of the parasitic capacitance involved in the protection scope of the claims of the present disclosure shall be subject to the calculation method disclosed in the following of the specification.

For the flat plate capacitor with electrodes right facing each other shown in Fig. 4C and the flat plate capacitor with inclined electrodes shown in Fig. 4D, the plate capacitance C formed by the electrode 1 and the electrode 2 that are used as two capacitor plates satisfies formula (1):

$$C = \varepsilon \times A/d \qquad \text{Formula (1)}$$

in which A represents a surface area of the two electrodes of the electrode 1 and the electrode 2 overlapping each other, d represents a distance traveled by a power line. According to formula (1), in the embodiment shown in Fig. 4A,

Cgd represents the capacitance value of the parasitic capacitance Cgd, and Cgd satisfies formula (2):

$$\text{Cgd} = \varepsilon \times A/d = \varepsilon_{PI} \times (W_{sd1} \times w_{sd1})/(t^2_{PLN1} + d^2_{sd1})^{1/2} \qquad \text{Formula (2)},$$

in which
referring to Fig. 4A, $\varepsilon_{PI}$ represents a dielectric constant of a medium between the overlapping part D0 of the data line Data and the first connection structure C1.

A represents an equivalent overlapping area of the overlapping part D0 of the data line Data and the first connection structure C1. As shown in Fig. 4D, in the flat plate capacitor with inclined electrodes, the equivalent overlapping area is an area of the surfaces of the electrode 1 and the electrode 2 that are right opposite to each other and power lines are both distributed on the surfaces of the electrode 1 and the electrode 2 that are right opposite to each other; for example, in the case where the orthographic projection of the overlapping part D0 of the data line Data on the base substrate 200 is not overlapped or is at least partially overlapped with the orthographic projection of the first connection structure C1 on the base substrate 200, the overlapping part D0 of the data line Data and the first connection structure C1 are respectively equivalent to the electrode 1 and the electrode 2 in Fig. 4D.

d represents the distance traveled by a power line.

$W_{sd1}$ represents the width of the first connection structure C1 in the second direction D2, that is, the distance ⑤.

$w_{sd1}$ represents the length of the first connection structure C1 in the first direction D1.

$t_{PLN1}$ represents the distance between the first connection structure C1 and the data line Data in a direction perpendicular to the base substrate 200.

$d_{sd1}$ represents the distance between the first edge 1a of the first connection structure C1 and the third edge 1c of the data line Data in one sub-pixel, that is, the second distance L2.

The following uses an example to calculate the parasitic capacitance Cgd formed by the first connection structure C1 and the overlapping part D0 of the data line Data that are adjacent to each other in one sub-pixel. Other plate capacitors can be referred to the calculation method.

For example, in one example, referring to Fig. 4A and Fig. 6, taking Fig. 4A as a cross-sectional schematic diagram of the second sub-pixel P2 as an example, S=51.4$\mu$m (greater than 50$\mu$m), and Cst=42fF. Each pitch is as follows.

① represents a distance between the data line Data1 of the first sub-pixel P1 and the data line Data2 of the sub-pixel which is adjacent to the first sub-pixel P1 and asymmetrical to the first sub-pixel P1 (the first sub-pixel P1 and the second sub-pixel P2 adjacent to each other constitute a repeating unit, and the sub-pixel adjacent to the first sub-pixel P1 on the side of the first sub-pixel P1 away from the second sub-pixel P2 belongs to another repeating unit), for example ①=3.4$\mu$m.

② represents a distance between the edges of the data line Data1 and the gate electrode T3g of the driving transistor T3 that are close to each other in the second sub-pixel P2, for example, ②=1.4$\mu$m.

③ represents a width of the gate electrode T3g of the driving transistor T3 in the second direction D2, for example, ③=11.5$\mu$m.

④ represents a distance between a first edge 1a of the first connection structure C1 above the gate electrode T3g of the driving transistor T3 of the second sub-pixel P2 and the data line Data1 of the gate electrode T3g of the driving transistor T3 close to the second sub-pixel P2, for example, ④=4$\mu$m.

⑤ represents a width of the first connection structure C1 of the gate electrode T3g of the driving transistor T3 in the second direction D1, for example, ⑤=5.4$\mu$m.

⑥ represents in one sub-pixel, for example, the second sub-pixel P2, a distance from the second edge 1b of the first connection structure C1 to the third edge 1c of the overlapping part D0 of the data line Data1 of the first sub-pixel P1, that is, the above-mentioned first distance L1, for example, in this example, ⑥=②+④=5.4$\mu$m.

⑦ represents the distance between the orthographic projection of the first edge 1a of the first connection structure C1 of the first sub-pixel P1 on the base substrate 200 and the orthographic projection of the third edge 1c of the overlapping part D0 of the data line Data1 of the second sub-pixel P2 on the base substrate 200 , that is, the second distance L2, for example, in this example, a line width Data Width of one data line Data1 (for example, the line widths of a plurality of data lines are basically the same) is equal to 2.5$\mu$m, thus ⑦=2×S - ① - 2×Data Width (the line width of the data line, for example, the line widths of a plurality of data lines are basically the same) - ⑥ - ⑤=2×51.4-3.4-2×2.5-5.4-5.4= 83.6$\mu$m.

Therefore, ⑦/⑥ =15.48, that is, L2/L1=15.48, which satisfies that the ratio of the first distance L1 to the second distance L2 is greater than 14.

Based on the above dimensions, for example, $\varepsilon_{PI}$=4.0, $t_{PLN1}$=1.24$\mu$m, $d_{sd1}$ =L2=⑥ =5.4$\mu$m, $W_{sd1}$=5.4$\mu$m, $w_{sd1}$=5.4$\mu$m.

For example, in the case where the first connection structures C1 and the data lines Data of the first sub-pixel P1 and the second sub-pixel P2 adjacent to each other shown in Fig. 5 are mirror symmetrical with respect to the symmetry axis extending along the first direction respectively, the first connection structure C1 of one of the sub-pixels only forms the parasitic capacitance Cgd with the data line Data located on one side of the first connection structure C1 in the second direction D2, therefore, the it is calculated that Cgd=0.186fF, the value of the Cgd is much smaller than that of the Cst which is equal to 42fF, and Cgd/Cst=4.4×10[-3], the ratio of the capacitance value of the parasitic capacitance Cgd to the capacitance value of the storage capacitor Cst is less than 0.005.

For example, in the case where the first connection structures C1 and the data lines Data of the first sub-pixel P1 and the second sub-pixel P2 adjacent to each other are not mirror symmetrical, for example, the data lines Data are arranged on two sides of the first connection structure C1 of one of the sub-pixels in the second direction D2 at two positions, distances from the two positions to the first connection structure C1 respectively are substantially equal, thus the formed parasitic capacitance is approximately twice the parasitic capacitance of the mirror design, that is, $Cgd=2\times0.168fF=0.11fF$, $Cgd/Cst=8.8\times10^{-3}$. Compared with the non-mirror design, the ratio of the capacitance value of the parasitic capacitor Cgd to the capacitance value of the storage capacitor Cst in the mirror design with the same other conditions mentioned above is smaller, in this case, the jump voltage on the data lines Data of the display panel has a small impact on the driving voltage of the driving transistor T3, and the display effect is better.

For example, in another example, referring to Fig. 4A and Fig. 6, taking Fig. 4A as a cross-sectional schematic diagram of the second sub-pixel P2 as an example, $S=45.2\mu m$ (less than $50\mu m$), $Cst=29.2fF$. According to the same design rules, the following distances are calculated based on the ratio of the value of S in the present example to the value of S in the example with S=51.4 as a reference. Therefore, the distances are as follows.

① represents the distance between the data line Data1 of the first sub-pixel P1 and the data line Data2 of the sub-pixel which is adjacent to the first sub-pixel P1 and asymmetrical to the first sub-pixel P1 (the first sub-pixel P1 and the second sub-pixel P2 adjacent to each other form a repeating unit, and the sub-pixel adjacent to the first sub-pixel P1 on the side of the first sub-pixel P1 away from the second sub-pixel P2 belongs to another repeating unit), for example, ①$=3.4\times45.2/51.4=3\mu m$.

⑤ represents the width of the first connection structure C1 of the gate electrode T3g of the driving transistor T3 in the second direction D1, for example, ⑤$=5.4\times45.2/51.4=4.75\mu m$.

⑥ represents, in one sub-pixel, for example, the second sub-pixel P2, the distance from the second edge 1b of the first connection structure C1 to the third edge 1c of the overlapping part D0 of the data line Data1 of the first sub-pixel P1, that is, the above-mentioned first distance L1, for example, in this example, ⑥$=5.4\times45.2/51.4=4.75\mu m$.

⑦ represents the distance from the orthographic projection of the first edge 1a of the first connection structure C1 of the first sub-pixel P1 on the base substrate 200 to the third edge 1c of the overlapping part D0 of the data line Data1 of the second sub-pixel P2 on the base substrate 200, that is, the second distance L2, for example, in this example, the line width Data Width of one data line Data1 (for example, the line widths of the plurality of data lines are basically the same) is equal to $2.5\mu m$, thus ⑦$=2\times S-$①$-2\times$Data Width$-$⑥$-$⑤$=2\times45.2^{-3}-2\times2.5-4.75-4.75=73.9\mu m$.

Therefore, ⑦/⑥$=15.56$, that is, L2/L1=15.56, it is satisfied that the ratio of the first distance L1 to the second distance L2 is greater than 14.

Based on the above dimensions, for example, $\varepsilon_{PI}=4.0$, $t_{PLN1}=1.05\mu m$, $d_{sd1}=L2=$⑥$=5.4\times45.2/51.4=4.75\mu m$, $W_{sd1}=5.4\times45.2/51.4=4.75\mu m$, $w_{sd1}=4.75\mu m$.

For example, in the case where the first connection structures C1 and the data lines Data of the first sub-pixel P1 and the second sub-pixel P2 adjacent to each other shown in Fig. 5 are mirror symmetrical with respect to the symmetry axis extending along the first direction respectively, the first connection structure C1 of one of the sub-pixels only forms a parasitic capacitance Cgd with the data line Data located on one side of the first connection structure C1 in the second direction D2, therefore, the calculated $Cgd=0.168fF$, which is much smaller than $Cst=29.2fF$, $Cgd/Cst=5.75\times10^{-3}$, the ratio of the capacitance value of the parasitic capacitance Cgd to the capacitance value of the storage capacitor Cst is greater than 0.005.

For example, in the case where the first connection structures C1 and the data lines Data of the first sub-pixel P1 and the second sub-pixel P2 adjacent to each other are not mirror symmetrical, for example, the data lines Data are arranged on two sides of the first connection structure C1 of one of the sub-pixels in the second direction D2 at two positions, distances from the two positions to the first connection structure C1 respectively are substantially equal, thus the formed parasitic capacitance is approximately twice the parasitic capacitance of the mirror design, that is, $Cgd=2\times0.168fF=0.33fF$, $Cgd/Cst=10\times10^{-3}$. Compared with the non-mirror design, the ratio of the capacitance value of the parasitic capacitor Cgd to the capacitance value of the storage capacitor Cst in the mirror design with the same other conditions mentioned above is smaller, in this case, the jump voltage on the data lines Data of the display panel has a small impact on the driving voltage of the driving transistor T3, and the display effect is better.

For example, in still another example, referring to Fig. 4A and Fig. 6, taking Fig. 4A as a cross-sectional schematic diagram of the second sub-pixel P2 as an example, $S=68\mu m$, $Cst=51.4fF$. The distances are as follows.

① represents the distance between the data line Data1 of the first sub-pixel P1 and the data line Data2 of the sub-pixel which is adjacent to the first sub-pixel P1 and asymmetrical to the first sub-pixel P1 (the first sub-pixel P1 and the second sub-pixel P2 adjacent to each other constitute a repeating unit, and the sub-pixel adjacent to the first sub-pixel P1 on the side of the first sub-pixel P1 away from the second sub-pixel P2 belongs to another repeating unit), for example, ①$=5.3\mu m$.

② represents the distance between the sides of the data line Data1 and the gate electrode T3g of the driving transistor T3 that are close to each other in the second sub-pixel P2, for example, ②$=2.9\mu m$.

③ represents the width of the gate electrode T3g of the driving transistor T3 in the second direction D2, for example, ③$=12\mu m$.

④ represents the distance between the first edge 1a of the first connection structure C1 above the gate electrode T3g of the driving transistor T3 of the second sub-pixel P2 and the gate electrode T3g of the driving transistor T3 close to the data line Data1 of the second sub-pixel P2, for example, ④=4.3μm.

⑤ represents the width of the first connection structure C1 of the gate electrode T3g of the driving transistor T3 in the second direction D1, for example, ⑤=7.5μm.

⑥ represents, in one sub-pixel such as the second sub-pixel P2, the distance from the second edge 1b of the first connection structure C1 to the third edge 1c of the overlapping part D0 of the data line Data1 of the first sub-pixel P1, that is, the above-mentioned first distance L1, for example, in this example, ⑥=②+④=7.2μm.

⑦ represents the distance from the orthographic projection of the first edge 1a of the first connection structure C1 of the first sub-pixel P1 on the base substrate 200 to the third edge 1c of the overlapping part D0 of the data line Data1 of the second sub-pixel P2 on the base substrate 200, that is, the second distance L2, for example, in this example, the line width Data Width of one data line Data1 (for example, the line widths of the plurality of data lines are basically the same) is equal to 2.4um, thus ⑦=2×S-①-2×Data Width (the line width of the data line, for example, the line widths of the plurality of data lines are basically the same) - ⑥ - ⑤=2×68-5.3-2×2.4-7.2-4.3= 114.4μm.

Therefore, ⑦/⑥ =15.9, that is, L2/L1=15.9, it is satisfied that the ratio of the first distance L1 to the second distance L2 is greater than 14.

Based on the above dimensions, for example, $\varepsilon_{PI}$=4.0, $t_{PLN1}$=1.24μm, $d_{sd1}$ =L2= ⑥=7.2μm, $W_{sd1}$=7.5μm, $w_{sd1}$=4.3μm.

For example, in the case where the first connection structures C1 and the data lines Data of the first sub-pixel P1 and the second sub-pixel P2 adjacent to each other shown in Fig. 5 are mirror symmetrical with respect to the symmetry axis extending along the first direction, the first connection structure C1 of one of the sub-pixels only forms the parasitic capacitance Cgd with the data line Data located on one side of the first connection structure C1 in the second direction D2, therefore, the calculated Cgd=0.155fF, which is much smaller than Cst=51.4fF, Cgd/Cst=3×10⁻³, that is, in the case where S=68μm, the ratio of the capacitance value of the parasitic capacitance Cgd to the capacitance value of the storage capacitance Cst is equal to 0.003. In the case where S is less than 68μm, that is, the width of a single sub-pixel is small, in order to achieve a high PPI, the space limitation is greater, therefore, it can be satisfied that the ratio of the capacitance value of the parasitic capacitance Cgd to the capacitance value of the storage capacitance Cst is less than 0.003.

For example, in the case where the first connection structure C1 and the data line Data of the first sub-pixel P1 and the second sub-pixel P2 adjacent to each other are not mirror symmetrical, for example, the data lines Data are arranged on two sides of the first connection structure C1 of one of the sub-pixels in the second direction D2 at two positions, distances from the two positions to the first connection structure C1 respectively are substantially equal, the formed parasitic capacitance is approximately twice that of the mirror design, that is, Cgd=2×0.155fF=0.31fF, Cgd/Cst=6×10⁻³. Compared with the non-mirror design, the ratio of the capacitance value of the parasitic capacitor Cgd to the capacitance value of the storage capacitor Cst in the mirror design with the same other conditions mentioned above is smaller, in this case, the jump voltage on the data line Data of the display panel has less impact on the driving voltage of the driving transistor T3, and the display effect is better.

For example, in yet another example, referring to Fig. 4A and Fig. 6, taking Fig. 4A as a cross-sectional schematic diagram of the second sub-pixel P2 as an example, S=49.3μm (less than 50μm), Cst=44.8fF. The distances are as follows:

① represents the distance between the data line Data1 of the first sub-pixel P1 and the data line Data2 of the sub-pixel which is adjacent to the first sub-pixel P1 and asymmetrical to the first sub-pixel P1 (the first sub-pixel P1 and the second sub-pixel P2 adjacent to each other constitute a repeating unit, and the sub-pixel adjacent to the first sub-pixel P1 on the side of the first sub-pixel P1 away from the second sub-pixel P2 belongs to another repeating unit), for example, ①=3.3μm.

② represents the distance between the edges of the data line Data1 and the gate electrode T3g of the driving transistor T3 that are close to each other in the second sub-pixel P2, for example, ②=12.5μm.

③ represents the width of the gate electrode T3g of the driving transistor T3 in the second direction D2, for example, ③=11.7μm.

④ represents the distance between the first edge 1a of the first connection structure C1 above the gate electrode T3g of the driving transistor T3 of the second sub-pixel P2 and the edge of the gate electrode T3g of the driving transistor T3 close to the data line Data1 of the second sub-pixel P2, for example, ④=3.3μm.

⑤ represents the width of the first connection structure C1 of the gate electrode T3g of the driving transistor T3 in the second direction D1, for example, ⑤=6 μm.

⑥ represents in one sub-pixel, the distance from the edge of the first connection structure away from the overlapping part of the data line in the sub-pixel to the edge of the overlapping part of the data line of a sub-pixel adjacent to the one sub-pixel, For example, in this example, ⑥=2μm.

⑦ represents the distance from the orthographic projection of the first edge 1a of the first connection structure C1 of the first sub-pixel P1 on the base substrate 200 to the third edge 1c of the overlapping part D0 of the data line Data1 of the second sub-pixel P2 on the base substrate 200, that is the second distance L2, for example, in this example, Data Width of one data line Data1 (for example, the line widths of the plurality of data lines are basically the same) is equal to $2.4\mu$m, thus ⑦=28.3$\mu$m.

Therefore, ⑦/⑥ =14.15, that is, L2/L1=14.15, which satisfies that the ratio of the first distance L1 to the second distance L2 is greater than 14.

Based on the above dimensions, for example, $\varepsilon_{PI}$=4.0, $t_{PLN1}$=1.36$\mu$m, $d_{sd1}$ =L2=⑥ =4$\mu$m, $W_{sd1}$=6$\mu$m, $w_{sd1}$=9$\mu$m.

For example, in the case where the first connection structures C1 and the data lines Data of the first sub-pixel P1 and the second sub-pixel P2 adjacent to each other shown in Fig. 5 are mirror symmetrical with respect to the symmetry axis extending along the first direction, the first connection structure C1 of one of the sub-pixels only forms the parasitic capacitance Cgd with the data line Data located on one side of the first connection structure C1 in the second direction D2, therefore, the calculated Cgd=0.24fF, which is much smaller than Cst=44.8fF, Cgd/Cst=$5.4\times10^{-3}$, that is, in the case where S is less than 50$\mu$m, the ratio of the capacitance value of the parasitic capacitance Cgd to the capacitance value of the storage capacitance Cst is greater than 0.005 and less than 0.006. In the case where S is less than 50$\mu$m, that is, the width of a single sub-pixel is small, in order to achieve high PPI, the space limitations are further greater, therefore, it can be satisfied that the ratio of the capacitance value of the parasitic capacitance Cgd to the capacitance value of the storage capacitance Cst is less than 0.003.

For example, in the case where the first connection structures C1 and the data lines Data of the first sub-pixel P1 and the second sub-pixel P2 adjacent to each other are not mirror symmetrical, for example, the data lines Data are arranged on two sides of the first connection structure C1 of one of the sub-pixels in the second direction D2 at two positions, distances from the two positions to the first connection structure C1 respectively are substantially equal, the formed parasitic capacitance is approximately twice that of the mirror design, that is, Cgd=$2\times0.24$fF=0.48fF, Cgd/Cst=$10.8\times10^{-3}$. Compared with the non-mirror design, the ratio of the capacitance value of the parasitic capacitor Cgd to the capacitance value of the storage capacitor Cst in the mirror design with the same other conditions mentioned above is smaller, in this case, the jump voltage on the data line Data of the display panel has less impact on the driving voltage of the driving transistor T3, and the display effect is better.

In the above embodiments, the cases that the first connection structure C1 and the data line Data are arranged in different layers are taken as examples. Of course, in some other embodiments, the first connection structure C1 can be arranged in a same layer as the data line Data, and the first connection structure C1 and the overlapping part D0 of the data line Data face each other in the second direction D2. The present disclosure is not limited to the case that the first connection structure C1 and the data line Data are arranged in different layers, as long as the ratio of the first distance L1 to the second distance L2 is greater than 14.

Fig. 4E is another cross-sectional schematic diagram of a display substrate provided by an embodiment of the present disclosure. For example, in at least one embodiment, as shown in Fig. 4E, the first electrode plate Cst1 of the storage capacitor Cst has an upper surface T01 away from the base substrate 200 and a side surface S01 intersecting the upper surface T01. The second electrode plate Cst2 of the storage capacitor Cst includes a middle part CM and an edge part CP. An orthographic projection of the middle part CM on the base substrate 200 is at least partially coincided with an orthographic projection of the first electrode plate Cst1 of the storage capacitor Cst on the base substrate 200, and the middle part CM includes a bottom surface B01 opposite to the upper surface T01 of the first electrode plate Cst1 of the storage capacitor Cst; the edge part CP at least partially surrounds the middle part CM and is connected with the middle part CM, and the edge part CP includes a bottom surface B02 close to the base substrate 200 and an inner side surface S02 intersecting the bottom surface B02, the inner side surface S02 and the side surface S01 of the first electrode plate Cst1 of the storage capacitor Cst are opposite to each other, and an orthographic projection of the inner side surface S02 on a reference plane perpendicular to the base substrate 200 is at least partially overlapped with an orthographic projection of the side surface S01 of the first electrode plate Cst1 of the storage capacitor Cst opposite the inner side surface S02 on the reference plane; a distance S1 between the inner side surface S02 of the edge part CP and the side surface of the first electrode plate Cst1 of the storage capacitor Cst opposite to the inner side surface S02 is less than a distance S2 between the bottom surface of the middle part CM and the upper surface of the first electrode plate Cst1 of the storage capacitor Cst, so as to utilize the limited space to achieve a larger capacitance value of the storage capacitor Cst, the charge storage capacity of the storage capacitor Cst is improved, it is also beneficial to reduce the ratio of the parasitic capacitance Cgd and the storage capacitance Cs formed by the overlapping part D0 of the first connection structure C1 and the data line Data, the influence of the parasitic capacitance Cgd on the display effect is reduced and the display effect is improved.

In order to clearly describe the structural characteristics of the sub-pixels, the structure of each layer of the sub-pixels is introduced below with an example.

Combining Fig. 3A to Fig. 3I with Fig. 4A, for example, the display substrate 10 includes a first semiconductor layer Active1, a first conductive layer Gate1, a second conductive layer Gate2, a second semiconductor layer Active2, a third conductive layer stack Gate3, an interlayer insulation layer ILD, a fourth conductive layer SD1, a first planarization layer PLN1 and a fifth conductive layer SD2 which are arranged on a base substrate 200 and are arranged in sequence in a direction away from the base substrate 200.

As shown in Fig. 3A, the first signal line includes a first scan signal line Scan(P)(n), a light-emitting control line EM(P)(n) and a second reset scan signal line Scan(P)(n+1). For example, the first scan signal line Scan(P)(n), the light-emitting control line EM(P)(n) and the second reset scan signal line Scan(P)(n+1) are located in the first conductive layer Gate1, and all these lines overall extend along the second direction D2. The driving transistor T3 includes a gate electrode T3g. For example, the gate electrode T3g of the driving transistor T3 is also located in the first conductive layer Gate1; for example, the gate electrode T3g of the driving transistor T3 and the first electrode plate Cst1 of the capacitor constitute a continuous integral structure. In this way, the first scan signal line Scan(P)(n), the light-emitting control line EM(P)(n), the second reset scan signal line Scan(P)(n+1), the gate electrode T3g of the driving transistor T3, the first electrode plate Cst1 of the storage capacitor Cst are arranged in a same layer. A part of the first scan signal line Scan(P)(n) overlapping the first semiconductor layer Active1 constitutes a gate electrode T4g of the fourth transistor T4; two parts of the light-emitting control line EM(P)(n) overlapping the first semiconductor layer Active1 respectively constitute a gate electrode T5g of the fifth transistor T5 and a gate electrode T6g of the sixth transistor T6. The fifth transistor T5 and the sixth transistor T6 serve as light-emitting control transistors, the fifth transistor T5 serves as a first light-emitting control transistor, and the sixth transistor T6 serves as a second light-emitting control transistor; a part of the second reset scan signal line Scan(P)(n+1) overlapping the first semiconductor layer Active1 constitutes a gate electrode T7g of the seventh transistor T7, the seventh transistor T7 serves as a second reset transistor. Thus, the first semiconductor layer Active1 includes an active layer A3 of the driving transistor T3, an active layer A4 of the fourth transistor T4, an active layer A5 of the fifth transistor T5, an active layer A6 of the sixth transistor T6, and an active layer A7 of the seventh transistor T7. In this way, the gate electrode T3g of the driving transistor T3 and the first electrode plate Cst1 of the storage capacitor Cst are located on the side of the active layer A3 of the driving transistor T3 away from the base substrate 200.

For example, the third transistor T3 serves as a driving transistor T3 of the pixel circuit, the fourth transistor T4 serves as a data writing transistor T4 of the pixel circuit. The driving transistor T3 is configured to control the light-emitting device 20 to emit light. The data line Data is connected with the first electrode of the data writing transistor T4 and is configured to provide a data signal to the data writing transistor T4, the data writing transistor T4 is configured to write a data signal Vd to the gate electrode T3g of the driving transistor T3 in response to a first scan signal applied to the gate electrode of the data writing transistor T4; for example, the data writing transistor T2 is configured to transmit the data signal Vd to the driving transistor T1 under the control of the first scan signal Ga1, the first scan signal Ga1 is transmitted on the first scan signal line Scan(P)(n), and the data signal Vd is transmitted on the second signal line.

The reference symbols Data, Data1 and Data2 in the present application are used to refer to data lines in different embodiments or different sub-pixels, for details, please refer to the corresponding drawings.

As shown in Fig. 3B, for example, the first signal line further includes a second scan signal line Scan(N)(n) and a first reset scan signal line Scan(N)(n-1). For example, the second scan signal line Scan(N)(n) and the first reset scan signal line Scan(N)(n-1) are located on the second conductive layer Gate2. The part of the second scan signal line Scan(N)(n) overlapping the second semiconductor layer Active2 constitutes a gate electrode T2g of the second transistor T2, the second transistor T2 serves as a compensation transistor; the part of the first reset scan signal line Scan(N)(n-1) overlapping the second semiconductor layer Active2 constitutes a gate electrode T1g of the first transistor T1, the first transistor T1 serves as a first reset transistor. Thus, the second semiconductor layer Active2 includes an active layer A1 of the first transistor T1 and an active layer A2 of the second transistor T2.

For example, the active layers A1 to A7 of the first transistor to the seventh transistor mentioned herein refer to the parts of the semiconductor layer that are used to form the first transistor to the seventh transistor overlapping with the gate electrodes of the respective transistors.

The second scan signal line Scan(N)(n) serves as a compensation scan signal line, the second scan signal line Scan(N)(n) is configured to apply a second scan signal Ga2 (ie, the compensation scan signal) to the gate electrode T2g of the compensation transistor T2, and the compensation transistor T2 is configured to perform threshold compensation on the driving transistor T3 in response to the second scan signal Ga2.

For example, as shown in Fig. 3B, the display substrate 10 further includes a first reset signal line Vini_N1. For example, the first reset signal line Vini_N1 is located in the second conductive layer Gate2. The first reset scan signal line Scan(N)(n-1) is configured to provide a first reset scan signal to the gate electrode T1g of the first reset transistor T1, that is, the first reset control signal Rst1, the first electrode T1s of the first reset transistor T1 is electrically connected with the gate electrode T3g of the driving transistor T3, the second electrode T1d of the first reset transistor T1 is configured to be electrically connected with the first reset signal line Vini_N1 to receive a first reset signal, for example, a first reset voltage Vinit1, the first reset transistor T1 is configured to write the first reset voltage Vinit1 to the gate electrode T3g of the driving transistor T3 in response to the first reset control signal Rst1.

As shown in Fig. 3F, the display substrate 10 further includes a second reset signal line Vini_OLED. For example, the second reset signal line Vini_OLED is located in the fourth conductive layer SD1. The second reset scan signal line Scan(P)(n+1) is configured to provide a second reset scan signal Rst2 to the gate electrode T7g of the second reset transistor T7, the first electrode T7s of the second reset transistor T7 is electrically connected with the first display electrode 21 of the light-emitting device 20, the second electrode T7d of the second reset transistor T7 is configured to be electrically connected with the second reset signal line Vini_OLED to receive a second reset signal such as a second reset voltage Vinit2, and the second reset transistor T7 is configured to write a second reset signal to the first display electrode 21 of the light-emitting device 20 in response to the second reset scan signal Rst2.

For example, as shown in Fig. 3B, the active layer A2 of the compensation transistor T2 and the active layer A1 of the first reset transistor T1 constitute an integral structure AL1. The integral structure AL1 extends along the first direction D1, in this way, that is, the active layer A1 of the first reset transistor T1 extends along the first direction D1, or the active layer A2 of the compensation transistor T2 extends along the first direction D1. For example, as shown in Fig. 3C, an orthographic projection of the first semiconductor layer Active1 on the base substrate 200 does not overlap with an orthographic projection of the second semiconductor layer Active2 on the base substrate 200, so that the transistors respectively formed based on the first semiconductor layer Active1 and the second semiconductor layer Active2 will not interfere with each other.

For example, a material of the first semiconductor layer Active1 is different from a material of the second semiconductor layer Active2. For example, the material of the first semiconductor layer Active1 includes but is not limited to silicon-based materials (amorphous silicon a-Si, polycrystalline silicon p-Si, etc.). For example, the material of the first semiconductor layer Active1 is low-temperature polysilicon (LTPS). For example, the material of the second semiconductor layer Active2 is an oxide semiconductor, such as indium gallium zinc oxide (IGZO), zinc oxide (ZnO), AZO, IZTO and so on. Of course, the type of the material of the first semiconductor layer Active1 and the type of the material of the second semiconductor layer Active2 are not limited to the types listed above, and no limitation is imposed to this in the embodiments of the present disclosure. In this way, the active layer located in the first semiconductor layer Active1 and the active layer located in the second semiconductor layer Active2 are made of different materials and are arranged in different layers, for example, the active layer A1 of the first reset transistor T1 and the active layer A3 of the driving transistor T3 are made of different materials and are arranged in different layers.

For example, in at least one embodiment, for the 7T1C pixel circuit shown in Fig. 2B, the driving transistor T3, the data writing transistor T4, the first light-emitting control transistor T5, the second light-emitting control transistor T6, and the second reset transistor T7 that resets the light-emitting device are P-type transistors using LTPS materials to make the active layer. Because a P-type transistor with an active layer made of the LTPS materials has higher mobility and more stable source voltage, and is suitable for driving organic light-emitting diodes such as OLEDs; the first reset transistor T1 that reset the driving transistor T3 and the compensation transistor T2 are N-type transistors whose active layers are made of oxide semiconductor materials, because the N-type transistor with an active layer made of the oxide semiconductor materials has a lower leakage current, voltages of the driving transistor T3 and the storage capacitor Cst can be better kept stable. Of course, in other embodiments, the type of each of the transistors of the pixel circuit and the material of the active layers are not limited to the above examples, and no limitation is imposed to this in the embodiments of the present disclosure.

Combining Fig. 3B and Fig. 5, the plurality of sub-pixels 100 include a third sub-pixel P3, the signal line Scan(N)(n+1) is the first reset scan signal line of the third sub-pixel P3, the signal line Vini_N1' is the first reset signal line of the third sub-pixel P3, and the third sub-pixel P3 and the second sub-pixel P2 are adjacent to each other in the first direction D1. For example, the complete pixel circuit shown in Fig. 3A to Fig. 3K is a pixel circuit of the second sub-pixel P2, and also involves a part of the structure of the pixel circuit of the sub-pixel adjacent to the second sub-pixel P2, such as the third sub-pixel P3. The second scan signal line Scan(N)(n), the first reset scan signal line Scan(N)(n-1) and the first reset signal line Vini_N1 in Fig. 3B all belong to the second sub-pixel P2.

For example, as shown in Fig. 3F and Fig. 3G, a part of the second reset signal line Vini_OLED located in one of the sub-pixels 100 includes a transverse part VS1 and a first vertical part VS2, the transverse part VS1 extends along the second direction D2 and has a first end and a second end opposite to each other in the second direction D2, the first vertical part VS2 is connected with the first end of the transverse part VS1 in the second direction D2 and extends along the first direction D1, furthermore, taking the second sub-pixel P2 and the third sub-pixel P3 shown in Fig. 5 as two sub-pixels adjacent in the first direction D1 as an example, in Fig. 3F and Fig. 3G, the orthographic projection of the transverse part VS1 of the second reset signal line Vini_OLED of the second sub-pixel P2 on the base substrate 200 is at least partially overlapped with the orthographic projection of the first reset scan signal line Scan(N)(n+1) of the third sub-pixel P3 on the base substrate 200, the first vertical part VS2 of the second reset signal line Vini_OLED of the second sub-pixel P2 and the active layer of the first reset transistor of the third sub-pixel P3 are spaced apart in the second direction D2, that is, the first vertical part VS2 and the integral structure A31 constituted by the active layer of the compensation transistor and the active layer of the first reset transistor in the second semiconductor layer Active2 are arranged at intervals in the second direction D2 (since the pixel circuit structure of each of the sub-pixels is a repeating unit, the integral structure A31 in the third sub-pixel P3 can refer to the position of the integral structure AL in the sub-pixel as the second sub-pixel P2 located at the lower part of Fig. 3G), therefore, the first vertical part VS2 extending along the first direction D1 of the second reset signal line Vini_OLED keeps away from the second semiconductor layer Active2, that is, the orthographic projection of the first vertical part VS2 on the base substrate 200 does not overlap with the orthographic projection of the second semiconductor layer Active2 on the base substrate 200, to avoid signal interference between the first vertical part VS2 and the second semiconductor layer Active2, the influence of the second reset signal line Vini_OLED on the active layer A2 of the compensation transistor T2 is avoided, so that the compensation transistor T2 with an active layer made of an oxide semiconductor material has a stable high on-state current and a stable low leakage current, which ensures that the voltage of the first node N1 connected with the gate electrode of the driving transistor T3 and the storage capacitor Cst is more stable, and electricity leakage phenomenon is less likely to occur, therefore, the driving current of the driving transistor T3 is more stable, the light-emitting efficiency of the light-emitting device 20 is more stable, and the display quality of a display apparatus using the display substrate is improved. Especially in the case where the second reset signal line Vini_OLED and the second semiconductor layer Active2 are relatively close to each other in a direction perpendicular to the main surface of the base substrate 200. Moreover, the feature " the orthographic projection of the transverse part VS1 of the second reset signal line Vini_OLED of the second sub-pixel P2 on the base substrate 200 is at least partially overlapped with the orthographic projection of the first reset scan signal line Scan(N)(n+1) of the third sub-pixel P3 on the base substrate 200" can reduce an area occupied by the scan signal lines, and the aperture ratio of the display substrate is improved. For example, as shown in Fig. 3F to Fig. 3G, correspondingly, the first vertical part VS2 of the second reset signal line Vini_OLED of the second sub-pixel P2 and the integral structure AL1 of the active layer A1 for forming the first reset transistor T1 of the third sub-pixel P3 arranged at intervals in the second direction D2, that is, the first vertical part VS2 of the second reset signal line Vini_OLED of the second sub-pixel P2 keeps away from the active layer A1 of the first reset transistor T1 of the third sub-pixel P3, so that the limited space is used to optimize the positional relationship design among the pixel circuit structures of the plurality of sub-pixels, and the arrangement is compact, to achieve a high PPI.

For example, as shown in Fig. 3I, a planar pattern of a part of the second reset signal line Vini_OLED corresponding to one sub-pixel 100 is in a shape of an inverted "π"; the "π"-shaped sub-part can not only achieve the above-mentioned effect of keeping away from the second semiconductor layer Active2, but also includes an U-shaped groove, and the transverse part VS1 of the second reset signal line Vini_OLED serves as a bottom of the U-shaped groove, thus other wires can be placed in the U-shaped groove, thereby the space is rationally utilized, and the compactness of the structure is improved.

For example, as shown in Fig. 3I , the part of the second reset signal line Vini_OLED located at one sub-pixel 100 further includes a second vertical part VS3, the second vertical part VS3 is connected with the second end of the transverse part VS1 in the second direction D2 and extends along the first direction D1, an active layer A7 of the second reset transistor T7 is located between the first vertical part VS2 and the second vertical part VS3, and in a same sub-pixel 100, in the second direction D2, a distance between the first vertical part VS2 and the data line Data is greater than a distance between the second vertical part VS3 and the data line Data. A distance from the active layer of the second reset transistor T7 of the third sub-pixel P3 to the first vertical part VS2 of the second reset signal line Vini_OLED of the second sub-pixel P2 is smaller than a distance from the active layer of the second reset transistor T7 of the third sub-pixel P3 to the second vertical part VS3 of the second reset signal line Vini_OLED of the second sub-pixel P2, so that while the first vertical part VS2 of the second reset signal line Vini_OLED keeps away from the second semi-conductor layer Active2, the limited space is rationally utilized, to avoid overly dense arrangement of the signal lines.

As shown in Fig. 3B, the second electrode plate Cst2 of the storage capacitor Cst is located in the second conductive layer Gate2, and is arranged in a same layer as the second scan signal line Scan(N)(n) and the first reset scan signal line Scan(N)(n-1). The second scan signal line Scan(N)(n) is a compensation scan signal line. In this way, the second electrode plate Cst2 of the storage capacitor Cst is located on a side of both the gate electrode T3g of the driving transistor T3 and the first electrode plate Cst1 of the storage capacitor Cst away from the base substrate 200. The compensation scan signal line is arranged in a same layer as the second electrode plate Cst2 of the storage capacitor Cst, the first reset signal line Vini_N1 is arranged in a same layer as the second electrode plate Cst2 of the storage capacitor Cst; and the active layer A2 of the compensation transistor T2 is located in the second semiconductor layer Active2, thus on a side of the second electrode plate Cst2 of the storage capacitor Cst away from the base substrate 200.

As shown in Fig. 3F to Fig. 3G, the second reset signal line Vini_OLED is located in a fourth conductive layer SD1, in this way, the second reset signal line Vini_OLED is located on a side of the active layer A2 of the compensation transistor T2 away from the base substrate 200.

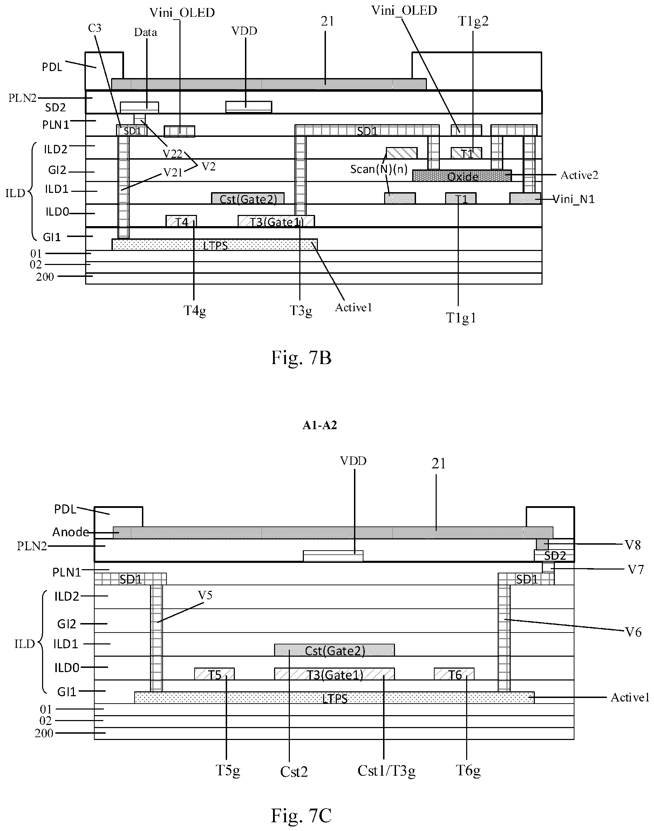

Fig. 7A is a cross-sectional schematic diagram from a first perspective along extension directions of an active layer of a fourth transistor, an active layer of a third transistor, an active layer of a second transistor, and an active layer of a first transistor in Fig. 3K in sequence. Fig. 7B is a cross-sectional schematic diagram from a second perspective along extension directions of the active layer of the fourth transistor, the active layer of the third transistor, the active layer of the second transistor, and the active layer of the first transistor in Fig. 3K in sequence. For example, referring to Fig. 3E and Fig. 7A to Fig. 7B, the gate electrode T2g of the compensation transistor T2 and the gate electrode T1g of the first reset transistor T1 are both double-gate structures, the gate electrode T2g of the compensation transistor T2 includes a first gate electrode T2g1 and a second gate electrode T2g2, and the gate electrode T1g of the first reset transistor T1 includes a first gate electrode T1g1 and a second gate electrode T1g2; the orthographic projection of the first gate electrode T2g1 of the compensation transistor T2 on the base substrate 200 coincides with the orthographic projection of the second gate electrode T2g2 of the compensation transistor T2 on the base substrate 200, and the orthographic projection of the first gate electrode T1g1 of the first reset transistor T1 on the base substrate 200 coincides with the orthographic projection of the second gate electrode T1g2 of the first reset transistor T1 on the base substrate 200.

For example, referring to Fig. 3E and Fig. 7A to Fig. 7B, the first gate electrode T1g1 of the first reset transistor T1 and the first gate electrode T2g1 of the compensation transistor T2 are located in the second conductive layer Gate2, the second gate electrode T1g2 of the first reset transistor T1 and the second gate electrode T2g2 of the compensation transistor T2 are located in the third conductive layer Gate3. Because in the direction perpendicular to the main surface of the base substrate 200, the second semiconductor layer Active2 where the active layer A2 of the compensation transistor T2 and the active layer A1 of the first reset transistor T1 are located in is located between the second conductive layer Gate2 and the third conductive layer Gate3, therefore, the first gate electrode T2g1 of the compensation transistor T2 and the first gate electrode T1g1 of the first reset transistor T1 are arranged in a same layer as the second electrode plate Cst2 of the storage capacitor Cst, the second gate electrode T2g2 of the compensation transistor T2 and the second gate electrode T1g2 of the first reset transistor T1 are located on a side of both the active layer A2 of the compensation transistor T2 and the active layer A1 of the first reset transistor T1 away from the base substrate 200, and are located on a side of the second reset signal line Vini_OLED close to the base substrate 200.

As shown in Fig. 3D, the third conductive layer Gate3 further includes a dual-gate reset scan signal line Scan(N)(n-1)' and a dual-gate compensation scan signal line Scan(N)(n)'. As shown in Fig. 3E, a part of the double-gate reset scan signal line Scan(N)(n-1)' overlapping with the first semiconductor layer Active1 constitutes the second gate electrode T1g2 of the first reset transistor T1; and a part of the double-gate compensation scan signal line Scan(N)(n)' overlapping with the first semiconductor layer Active1 constitutes the second gate electrode T2g2 of the compensation transistor T2.

An orthographic projection of the dual-gate reset scan signal line Scan(N)(n-1)' on the main surface of the base substrate 200 substantially coincides with an orthographic projection of the first reset scan signal line Scan(N)(n-1) on the main surface of the base substrate 200; an orthographic projection of the double-gate compensation scan signal line Scan(N)(n)' on the main surface of the base substrate 200 substantially coincides with an orthographic projection of the second scan signal line Scan(N)(n), that is, a compensation scan signal line, on the main surface of the base substrate 200. In this way, an additional pixel area occupied by the double-gate reset scan signal line Scan(N)(n-1)' and the double-gate compensation scan signal line Scan(N)(n)' that are provided for realizing the double-gate structure can be reduced, thus the aperture ratio of the display substrate is improved.

As shown in Fig. 3F, for example, the first connection structure C1 is located in the fourth conductive layer SD1, thus the first connection structure C1 and the second reset signal line Vini_OLED are arranged in a same layer, and are located on a side of the second electrode plate Cst2 of the storage capacitor Cst away from the base substrate 200.

In the case where the first connection structure C1 and the data line Data are arranged in different layers, for example, in the embodiments shown in Fig. 3A to Fig. 3I and Fig. 4A, the data line Data is located on a side of the first connection structure C1 away from the base substrate 200. Alternatively, in other embodiments, the data line Data may be located on a side of the first connection structure C1 close to the base substrate 200.

Referring to Fig. 4A, the interlayer insulation layer ILD of the display substrate 10 includes a first sub-insulation layer GI1 located between the first semiconductor layer Active1 and the first conductive layer Gate1, and a second sub-insulation layer ILD0 located between the first conductive layer Gate1 and the second conductive layer Gate2. Referring to Fig. 7A, the interlayer insulation layer ILD further includes a third sub-insulation layer ILD1 located between the second conductive layer Gate2 and the second semiconductor layer Active2, a fourth sub-insulation layer GI2 located between the second semiconductor layer Active2 and the third conductive layer Gate3, and a fifth sub-insulation layer ILD2 located between the third conductive layer Gate3 and the fourth conductive layer SD1.

The display substrate 10 further includes a sixth sub-insulation layer, that is, a first planarization layer PLN1, located between the fourth conductive layer SD1 and the fifth conductive layer SD2, and a second planarization layer PLN2 located between the fifth conductive layer SD2 and the first display electrode 21. The first planarization layer PLN1 provides a flat surface for the fifth conductive layer SD2 arranged above the first planarization layer PLN1, so that the patterning design of the fifth insulation layer SD2 is facilitated, the manufacturing difficulty of the fifth insulation layer SD2 is reduced, and the yield is improved. The second flat layer PLN2 provides a flat surface for the first display electrode 21 arranged above the second flat layer PLN2, which facilitates the patterning design of the first display electrode 21, reduces the manufacturing difficulty of the first display electrode 21, and improves the yield.

For example, as shown in Fig. 4A, the display substrate 10 further includes a pixel definition layer PDL, an opening of the pixel definition layer PDL exposes a part of the first display electrode of each of the sub-pixels 100 located in the light-emitting region, and the main body of the pixel definition layer PDL covers an edge of the first display electrode.

For example, as shown in Fig. 4A, the display substrate 10 further includes a barrier layer 02, the barrier layer 02 is located on the main surface of the base substrate 200 and on a side of the first semiconductor layer Active close to the base substrate 200. For example, the barrier layer 02 is in contact with the base substrate 200. The barrier layer 02 can protect the base substrate, and can prevent damage and corrosion to the base substrate during the process of manufacturing subsequent layers. For example, the display substrate 10 further includes a buffer layer 01, and the buffer layer 01 is located on a side of the barrier layer 02 away from the base substrate 200 to further protect the base substrate.

Combining Fig. 3B, Fig. 3K and Fig. 4A, the second electrode plate Cst2 of the storage capacitor Cst has a first via hole V1 that exposes the first electrode plate Cst1 of the storage capacitor Cst, the first connection structure C1 passes through the first via hole V1 and is connected with the first electrode plate Cst1 of the storage capacitor Cst. The first via hole V1 penetrates the second sub-insulation layer ILD0 in the direction perpendicular to the main surface of the base substrate 200. The display substrate further includes a via hole V9 which is communicated with the first via hole V1 and penetrates through the second sub-insulation layer ILD0, the third sub-insulation layer ILD1, the fourth sub-insulation layer GI2 and the fifth sub-insulation layer ILD2 in the direction perpendicular to the main surface of the base substrate 200, and the first connection structure C1 is electrically connected with the first electrode plate Cst1 of the storage capacitor Cst through the via hole V9 and the first via hole V1.

As shown in Fig. 3F, the first connection structure C1 includes a first part C11 extending along the first direction D1 and a second part C12 extending along the second direction D2, the second part C11 of the first connection structure C1 is connected with the first part C11 of the first connection structure, for example, the second part C11 of the first connection structure C1 and the first part C11 of the first connection structure constitute a continuous integral structure.

Combining Fig. 3F and Fig. 3I, the active layer A2 of the compensation transistor T2 is located on a side of the first connection structure C1 away from the data line Data, the second part C12 of the first connection structure C1 is connected with the active layer A2 of the compensation transistor T2. For example, one end of the first part C11 of the first connection structure C1 away from the second part C12 in the first direction D1 is electrically connected with the first electrode plate Cst1 of the storage capacitor Cst through the via hole V9 and the first via hole V1, the second part C12 of the first connection structure C1 is connected with the active layer A2 of the compensation transistor T2 through a second via hole V10, the second via hole V10 penetrates through the fourth sub-insulation layer GI2 and the fifth sub-insulation layer ILD2 in the direction perpendicular to the main surface of the base substrate 200 (referring to Fig. 4A).

Referring to Fig. 3K and Fig. 4A, for example, in each of the sub-pixels 100 performing a display function, the first power line VDD is connected with a first voltage terminal vdd and is configured to provide a first power voltage VDD to the pixel circuit. For example, the first power line VDD extends along the first direction D1. The pixel circuit further includes a second connection structure C2, the second connection structure C2 is located between the first power line VDD and the second electrode plate Cst2 of the storage capacitor Cst in the direction perpendicular to the main surface of the base substrate 200, and is connected with the first power line VDD and the second electrode plate Cst2 of the storage capacitor Cst. For example, the second connection structure C2 includes a horizontal part C21 and a vertical part C22, the horizontal part C21 extends along the second direction D2, and the vertical part C22 is connected to the horizontal part C21 and extends along the first direction D1. An orthographic projection of the first power line VDD on the base substrate 200 is overlapped with an orthographic projection of the horizontal part C21 of the second connection structure C2 on the base substrate 200, and the orthographic projection of the first power line VDD on the base substrate 200 is not overlapped with orthographic projections of other structures arranged in a same layer as the second connection structure C2 on the base substrate 200. In this way, on the one hand, it is convenient to electrically connect the horizontal part C21 of the second connection structure C2 with the first power line VDD by utilizing the overlapping part of the horizontal part C21 of the second connection structure C2 and the first power line VDD, thus the first power line VDD and the second electrode plate Cst2 of the storage capacitor Cst are connected through the second connection structure C2; on the other hand, because the conductive layer where the second connection structure C2 is located and the conductive layer where the first power line VDD is located are relatively close in the direction perpendicular to the main surface of the base substrate 200, for example, they are adjacent conductive layers, if too many structures in the conductive layer where the second connection structure C2 is located are overlapped with the first power line VDD in the direction perpendicular to the main surface of the base substrate 200, that is, orthographic projections of excessive structures in the conductive layer where the second connection structure C2 is located in the direction perpendicular to the main surface of the base substrate 200 are overlapped with the orthographic projection of the first power line VDD in the direction perpendicular to the main surface of the base substrate 200, which will cause interference to the first power supply voltage VDD transmitted on the first power line VDD, so that the first power supply voltage VDD becomes unstable, affecting the display effect of the display substrate, therefore, the feature "the orthographic projection of the first power line VDD on the base substrate 200 is not overlapped with orthographic projections of other structures arranged on the same layer as the second connection structure C2 on the base substrate 200" can avoid the instability of the first power supply voltage VDD caused by this, and the display effect of the display substrate can be improved.

For example, as shown in Fig. 3K, the vertical part C22 is substantially aligned with the first connection structure C1 in the first direction, the orthographic projection of the horizontal part C21 on the base substrate 200 extends from the orthographic projection of the vertical part C22 on the base substrate 200 along the first direction D1 to the orthographic projection of the first power line VDD on the base substrate 200, so that an extension trend of the second connection structure C2 is designed corresponding to an extension trend of the first power supply voltage VDD and the first connection structure C1, the limited space is rationally utilized, to achieve a regular and compact wiring design, which is conducive to improving the production yield of the pixel structure and achieving high PPI.

As shown in Fig. 4A, for example, the first insulation layer PLN1 is located between the first power line VDD and the second connection structure C2, the second insulation layer (including the third sub-insulation layer ILD1, the fourth sub-insulation layer GI2 and the fifth sub-insulation layer ILD2) is located between the second connection structure C2 and the second electrode plate Cst2 of the storage capacitor Cst; the horizontal part C21 of the second connection structure C2 is connected with the first power line VDD through the third via hole V3 that penetrates through the first insulation layer PLN1. The vertical part C22 of the second connection structure C2 is connected with the second electrode plate Cst2 of the storage capacitor Cst through the fourth via hole V4 that penetrates through the second insulation layer (that is, the fourth via hole V4 penetrates through the third sub-insulation layer ILD1, the fourth sub-insulation layer GI2, and the fifth sub-insulation layer ILD2). In this way, the vertical part C22 of the second connection structure C2 extending along the first direction D1 and the horizontal part C21 of the second connection structure C2 extending along the second direction D2 are respectively connected with the first power line VDD, therefore, the first power line VDD and the second electrode plate Cst2 of the storage capacitor Cst are electrically connected through a plurality of connection structures and a plurality of via holes, and the risk of wire breakage caused by a single via hole which is required to pass through a thicker insulation layer is reduced; moreover, the first power line VDD and the second electrode plate Cst2 of the storage capacitor Cst are electrically connected by cleverly positioning and shaping the second connection structure C2 and the relationship between the second connection structure C2 and the first power line VDD, and a compact pixel structure is achieved.

For example, in the embodiment shown in Fig. 4A, the first power line VDD and the data line Data are arranged in a same layer, for example, the first power line VDD and the data line Data are both located in the fifth conductive layer SD2; the second connection structure C2 and the first connection structure C1 are arranged in a same layer, the second connection structure C2 and the first connection structure C1 are both located in the fourth conductive layer SD. Therefore, the positional relationship between the auxiliary connection structures, such as the second connection structure C2 and the first connection structure C1, and, the first power line VDD and the data line Data is reasonably arranged, that is, manufacturing each layer of the display substrate is facilitated, and the above-mentioned pixel circuit can be realized.

For example, the first light-emitting control transistor T5 of the pixel circuit is connected with a first electrode of the driving transistor T3 and the first voltage terminal, and is configured to apply the first power supply voltage VDD of the first voltage terminal vdd to the first electrode T3s of the driving transistor T3 in response to the first light-emitting control signal applied to the gate electrode T5g of the first light-emitting control transistor T5; as above, the first semiconductor layer Active1 includes the active layer A3 of the driving transistor T3, the active layer A4 of the data writing transistor T4, and the active layer A5 of the first light-emitting control transistor T5. Fig. 7C is a cross-sectional schematic diagram along extension directions of an active layer of a fifth transistor, the active layer of the third transistor, and the active layer of the sixth transistor in Fig. 3K in sequence, that is, a cross-sectional schematic diagram taken along the line A1-A2 in Fig. 3K. Referring to Fig. 3K and Fig. 7C, the horizontal part C21 of the second connection structure C2 is connected with the first semiconductor layer Active1 through the fifth via hole V5.

For example, the horizontal part C21 of the second connection structure C2 has a first end and a second end that are opposite to each other in the second direction D2, the first end of the horizontal part C21 is located on a side of the first power line VDD close to the vertical part C22 and is connected with the vertical part C22, and the second end of the horizontal part C21 is located on a side of the first power line VDD away from the vertical part C22 and is connected with the first semiconductor layer Active1 through the fifth via hole V5. Therefore, the first power line VDD and the second electrode plate Cst2 of the storage capacitor Cst are electrically connected by cleverly positioning and shaping the second connection structure C2 and the relationship between the second connection structure C2 and the first power line VDD, and a compact pixel structure is achieved.

Referring to Fig. 3K and Fig. 7A to Fig. 7B, one sub-pixel 100 further includes a third connection structure C3. The data line Data is connected with the first semiconductor layer Active1 through a via hole V2, for example, the via hole V2 includes a first sub-via hole V21 that penetrates the first sub-insulation layer GI1, the second sub-insulation layer ILD0, the third sub-insulation layer ILD1, the fourth sub-insulation layer GI2 and the fifth sub-insulation layer ILD2, and a second sub-via hole V22 that penetrates the first planarization layer PLN1, the data line Data is connected with the third connection structure C3 through the second sub-via hole V22, and the third connection structure C3 is connected with the first semiconductor layer Active1 through the first sub-via hole V21, thus the data line Data is connected with the first semiconductor layer Active1.

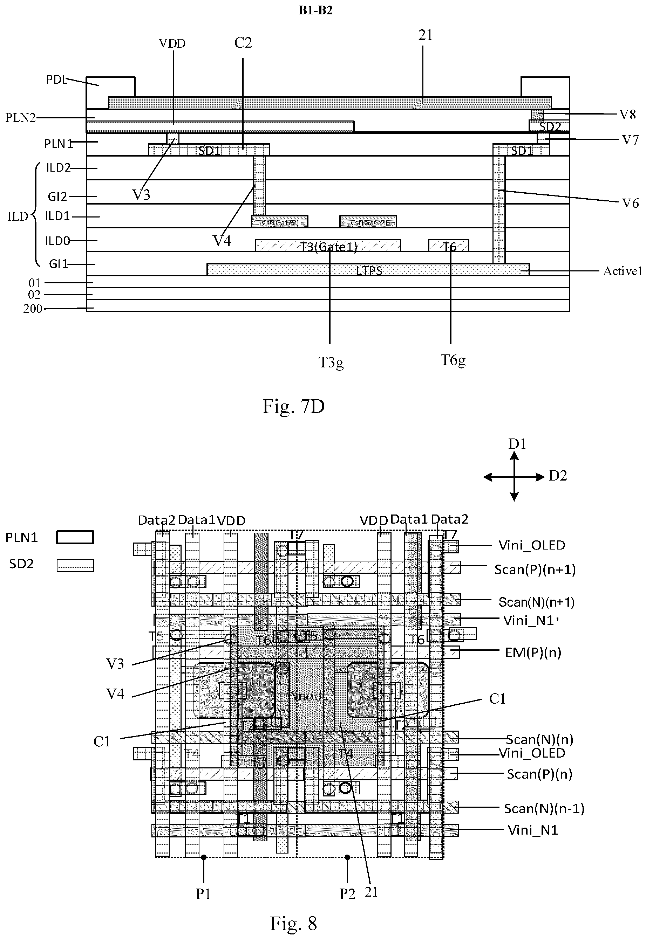

Fig. 7C is a cross-sectional schematic diagram along extension directions of an active layer of a fifth transistor, the active layer of the third transistor, and the active layer of the sixth transistor in Fig. 3K in sequence, that is, a cross-sectional schematic diagram taken along the line A1-A2 in Fig. 3K. Fig. 7D is a cross-sectional schematic diagram along extension directions of the active layer of the third transistor and the active layer of the sixth transistor in Fig. 3K in sequence, that is, a cross-sectional schematic diagram taken along the line B1-B2 in Fig. 3K. Referring to Fig. 3K and Fig. 7C to Fig. 7D, one sub-pixel 100 further includes a fourth connection structure C4 and a fifth connection structure C5. For example, the fourth connection structure C4 is located in the fifth conductive layer SD2, and the fifth connection structure C5 is located in the fourth conductive layer SD1. The first display electrode 21 is located on a surface of the second planarization layer PLN2 away from the base substrate 200 and is connected with the first semiconductor layer Active1 through the fourth connection structure C4 and via holes. For example, the first display electrode 21 is connected with the fourth connection structure C4 through the via hole V8 located in the second planarization layer PLN2; the fourth connection structure C4 is connected with the fifth connection structure C5 through the via hole V7 located in the first planarization layer PLN1; the fifth connection structure C5 is connected with the first semiconductor layer Active1 through a via hole V6 penetrating through the first sub-insulation layer GI1, the second sub-insulation layer ILD0, the third sub-insulation layer ILD1, the fourth sub-insulation layer GI2 and the fifth sub-insulation layer ILD2. In this way, the first display electrode 21 is electrically connected with the first semiconductor layer Active1 through a plurality of connection structures and a plurality of via holes, that is, the first display electrode 21 is electrically connected with the second electrode T6d of the second light-emitting transistor T6, thus the risk of wire breakage caused by a single via hole needing to pass through a thicker insulation layer can be reduced.

In the display substrate 10 provided by the embodiment of the present disclosure, for example, the base substrate 200 can be a rigid substrate, such as a glass substrate, a silicon substrate, etc., and can also be made of flexible materials with excellent heat resistance and durability, such as polyimide (PI), polycarbonate (PC), polyethylene terephthalate (PET), polyethylene, polyacrylate, polyarylate, polyetherimide, polyethersulfone, polyethylene terephthalate (PET), polyethylene (PE), polypropylene (PP), polysulfone (PSF), polymethylmethacrylate (PMMA), triacetate (TAC), cyclic olefin polymer (COP) and cyclic olefin copolymer (COC), and so on.

For example, materials of the first conductive layer to the fifth conductive layer may include gold (Au), silver (Ag), copper (Cu), aluminum (Al), molybdenum (Mo), magnesium (Mg), tungsten (W), and alloy materials composed of combinations of the above metals; or transparent conductive metal oxide materials, such as indium tin oxide (ITO), indium zinc oxide (IZO), zinc oxide (ZnO), aluminum zinc oxide (AZO), and so on.

For example, the first insulation layer and the second insulation layer are inorganic insulation layers, the materials of the inorganic insulation layers include, for example, at least one of selected from the group consisting of silicon oxide, silicon nitride, or silicon oxynitride, such as silicon oxide, silicon nitride, and silicon oxynitride, or, include aluminum oxide or titanium nitride, or other insulation materials including metallic oxide or metallic nitride. For example, the pixel definition layer PDL, the first planarization layer PLN1 and the second planarization layer PLN2 may be organic insulation material layers, such as polyimide (PI), acrylate, epoxy resin, polymethyl methacrylate (PMMA) and other organic insulation materials. No limitation is imposed to this in the embodiment of the present disclosure.

In at least one embodiment, examples of the materials and the thicknesses of the above-mentioned layers of the display substrate 10 are shown in Table 1 below, of course, the materials of each of the above-mentioned layers and the thicknesses of each of the above-mentioned layers in the direction perpendicular to the main surface of the base substrate are not limited to those shown in Table 1.

Table 1

| Layer Name | Material | Thickness/Angstrom |
|---|---|---|
| Base substrate 200 | PI/ SiO/PI | $10 \times 10^4/4000/10 \times 10^4$ |
| Barrier layer 02 | SiO | 4000 |
| Buffer layer 01 | SiN/SiO | 800/2500 |
| First semiconductor layer Active1 | LTPS | 600 |
| First sub-insulation layer GI1 | SiO | 1500 |
| First conductive layer Gate1 | Mo | 3000 |
| Second sub-insulation layer ILD0 | SiN | 1500 |
| Second conductive layer Gate2 | Mo | 3000 |
| Third sub-insulation layer ILD1 | SiN | 1000 |
| Second semiconductor layer Active2 | IGZO | 500 |
| Fourth sub-insulation layer GI2 | SiO | 1500 |
| Third conductive layer stack Gate3 | Mo | 2500 |
| Fifth sub-insulation layer ILD2 | SiO/SiN | 3000/2000 |
| Fourth conductive layer SD1 | Ti/Al/Ti | 400/6000/500 |
| First planarization layer PLN1 | PI | 12000 |

(continued)

| Layer Name | Material | Thickness/Angstrom |
|---|---|---|
| Fifth conductive layer SD2 | Ti/Al/Ti | 400/6000/500 |
| Second planarization layer PLN2 | PI | 12000 |
| First display electrode 21 | ITO/Ag/ITO | 50/900/50 |

For example, the light-emitting device possesses a top-emission structure, the first display electrode 21 is reflective and the second display electrode is transmissive or semi-transmissive. For example, the first display electrode 21 is made of a high work function material to serve as an anode, for example, the first display electrode 21 is an ITO/Ag/ITO stacked structure; and the second display electrode is made of a material with a low work function to serve as a cathode, such as a semi-transmissive metal or a metal alloy material, for example, an Ag/Mg alloy material.

Of course, the materials and the thicknesses of each of the above layers are not limited to the examples in Table 1, and those skilled in the art can design them according to specific products.

In other embodiments, for example, Fig. 8 is another planar schematic diagram of a display substrate provided by an embodiment of the present disclosure, as shown in Fig. 8, the first display electrode 21 of the first sub-pixel P1 covers a boundary between the first sub-pixel P1 and the second sub-pixel P2, and both a part of the orthographic projection of the first connection structure C1 of the first sub-pixel P1 on the base substrate 200 and a part of the orthographic projection of the first connection structure C1 of the second sub-pixel P2 on the base substrate 200 are located in the orthographic projection of the first display electrode 21 of the first sub-pixel P1 on the base substrate 200. In this case, the first display electrode is located in a junction region of two adjacent sub-pixels, thus the first display electrode covers a part of the first connection structure of each of the two adjacent sub-pixels, so that the electrode arrangement meeting specific needs is designed, and a better display effect can be achieved.

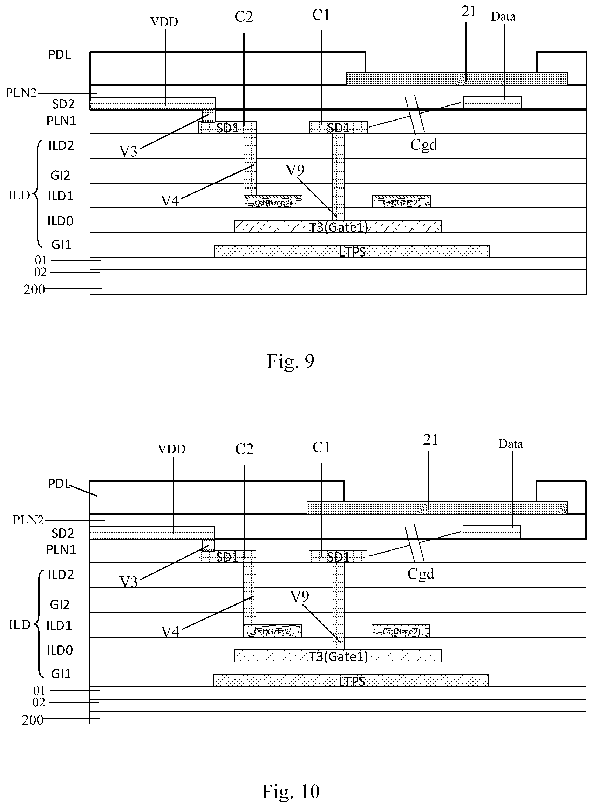

In other embodiments, for example, the orthographic projection of the entire first connection structure C1 on the base substrate 200 is located within the orthographic projection of the first display electrode 21 of the light-emitting device 20 on the base substrate 200; the plurality of sub-pixels include a first sub-pixel **P1** and a second sub-pixel P2 that are adjacent to each other in the second direction D2; the first display electrode 21 of the first sub-pixel **P1** covers the boundary between the first sub-pixel **P1** and the second sub-pixel P2, the orthographic projection of the first connection structure C1 of the first sub-pixel P1 on the base substrate 200 and the orthographic projection of the first connection structure C1 of the second sub-pixel P2 on the base substrate 200 are both located within the orthographic projection of the first display electrode 21 of the first sub-pixel P1 on the base substrate 200. Fig. 9 is a cross-sectional schematic diagram of a display substrate including a first connection structure and a first display electrode provided by an embodiment of the present disclosure. For example, as shown in Fig. 9, one part of the orthographic projection of the first connection structure C1 on the main surface of the base substrate 200 is located within the orthographic projection of the first display electrode 21 of the light-emitting device 20 on the main surface of the base substrate 200, the other part of the orthographic projection of the first connection structure C1 on the main surface of the base substrate 200 is within the orthographic projection of the first display electrode 21 of the light-emitting device 20 on the main surface of the base substrate 200, that is, one part of the first connection structure C1 is covered by the first display electrode 21, the other part of the first connection structure C1 is not covered by the first display electrode 21.

Fig. 10 is a cross-sectional schematic diagram of a display substrate including a first connection structure and a first display electrode provided by an embodiment of the present disclosure. For example, in the embodiments shown in Fig. 3K and Fig. 10, in one sub-pixel 100, the orthographic projection of the entire first connection structure C1 on the base substrate 200 is located within the orthographic projection of the first display electrode 21 on the base substrate 200.

For example, as shown in Fig. 10, an orthographic projection of the first display electrode 21 of one sub-pixel 100 on the main surface of the base substrate 200 is further overlapped with a part of an orthographic projection of a data line Data of the sub-pixel 100 on the main surface of the base substrate 200; in the sub-pixel 100, an orthographic projection of an edge of the first display electrode 21 away from the data line Data and close to the first connection structure C1 on the base substrate 200 is substantially aligned with an edge of the first connection structure C1 away from the data line Data. The "substantially aligned" here is not limited to absolute alignment, for example, if the alignment error of the above two substantially aligned edges is within 3% of the width of the first connection structure C1 in the second direction D2, it can be considered that the two edges are substantially aligned.

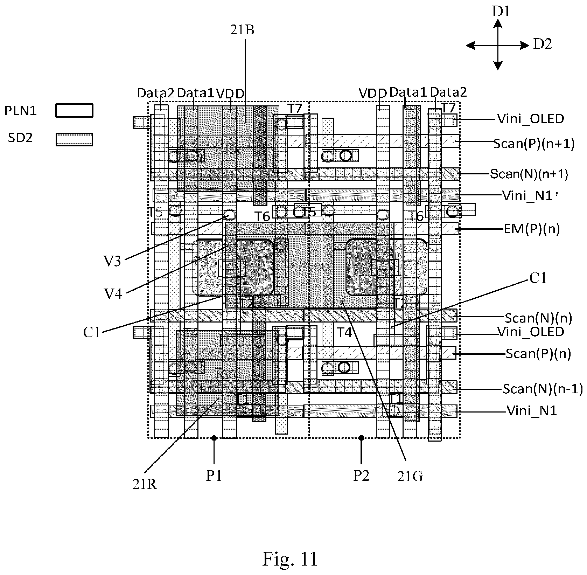

Fig. 11 is still another planar schematic diagram of a display substrate provided by an embodiment of the present disclosure. As shown in Fig. 11, a light-emitting material of the light-emitting device 20 of the first sub-pixel P1 emits green light. That is, the light-emitting layer of the first sub-pixel P1 where the first display electrode 21 is located emits green light, and the first display electrode 21 of the first sub-pixel P1 covers a part of the first connection structure C1 of the first sub-pixel P1 and the first connection structure C1 of the second sub-pixel P2 in the direction perpendicular to the base substrate 200. Because compared with the light-emitting materials emitting other colors of light, for example, the light-emitting materials of organic light-emitting diodes, green light-emitting materials are the least sensitive to changes in voltage, and due to the jump of the data voltage transmitted by the data line near the first connection structure C1, the signal on the first connection structure C1 jumps to a certain extent, and the first display electrode which is located in the boundary region of adjacent sub-pixels and covers a part of the first connection structure C1 of the two adjacent sub-pixels is closer to the first connection structure C1, therefore, in an arrangement of the first display electrodes of the plurality of sub-pixels 100, a scheme in which the light-emitting layer of the sub-pixel, where the first display electrode 21 covering the first connection structures C1 of the adjacent sub-pixels 100 (for example, the first sub-pixel P1 and the second sub-pixel P2) is located, emits green light is adopted, and the impact of the voltage jump of the first connection structure C1 on the light-emitting device where the first display electrode is located can be minimized.

As shown in Fig. 11, for example, the orthographic projection of the edge of the first display electrode 21 of the first sub-pixel P1 away from the second sub-pixel P2 on the base substrate 200 is substantially aligned with the orthographic projection of the edge of the first connection structure C1 of the first sub-pixel P1 close to the data line Data of the first sub-pixel P1 on the base substrate 200, and the orthographic projection of the edge of the first display electrode 21 of the first sub-pixel P1 close to the second sub-pixel P2 on the base substrate 200 is substantially aligned with the orthographic projection of the edge of the first connection structure C1 of the second sub-pixel P2 close to the data line Data of the second sub-pixel P2 on the base substrate 200. The "substantially aligned" here is not limited to absolute alignment, for example, if the alignment error of the above two substantially aligned edges is within 3% of the width of the first connection structure C1 in the second direction D2, it can be considered that the two edges are substantially aligned.

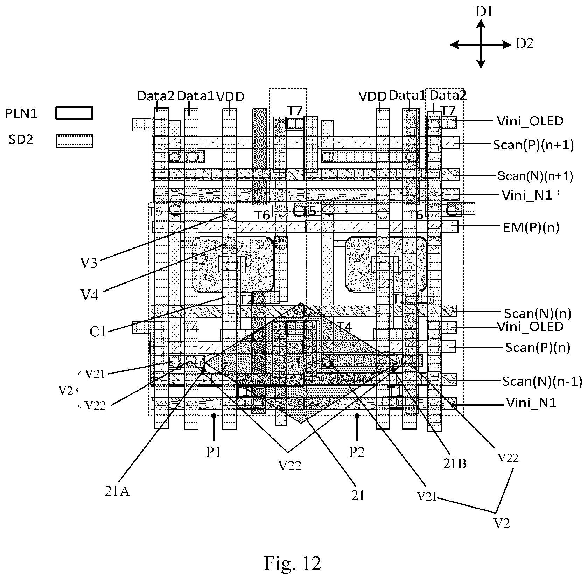

Fig. 12 is still another planar schematic diagram of a display substrate provided by an embodiment of the present disclosure. As shown in Fig. 12, for example, the first display electrode 21 of the light-emitting device 20 possesses a first end and a second end that are opposite to each other in the second direction D2; the first display electrode 21 of the first sub-pixel P1 covers the boundary between the first sub-pixel P1 and the second sub-pixel P2, the orthographic projection of the first end of the first display electrode 21 of the first sub-pixel P1 on the base substrate 200 includes a first protrusion part 21A that is convex and tapered in the second direction D2 toward the orthographic projection of the second via hole V2 of the first sub-pixel P1 on the base substrate 200, the orthographic projection of the second end of the first display electrode 21 of the first sub-pixel P1 on the main surface of the base substrate 200 includes a second protrusion part 21B that is convex and tapered in the second direction D2 toward the second via hole V2 of the second sub-pixel P2 on the main surface of the base substrate 200, moreover, the orthographic projection of the first protrusion part 21A on the main surface of the base substrate 200 is right opposite to the orthographic projection of the second via hole V2 of the first sub-pixel P1 on the main surface of the base substrate 200 in the second direction D2, and the orthographic projection of the second protrusion part 21B on the main surface of the base substrate 200 is right opposite to the orthographic projection of the second via hole V2 of the second sub-pixel P2 on the main surface of the base substrate 200 in the second direction D2; and the light-emitting material of the light-emitting device 20 of the first sub-pixel P1 emits blue light. Compared with light-emitting materials emitting other colors of light, for example, the light-emitting materials of organic light-emitting diodes, blue light-emitting materials are more sensitive to voltage changes. The two ends of the first display electrode 21 of the sub-pixel where the light-emitting device 20 adopting the blue light-emitting material is located, respectively close to the data lines Data1 located on two sides of the first display electrode 21 in the second direction D2, are tapered and protruded, and thereby the impact of the jump of the data voltage on the data line Data1 located on the two sides of the first display electrode 21 on the voltage of the first display electrode 21 can be reduced. For example, the first protrusion part 21A and the second protrusion part 21B are symmetrically designed so that the display effects on two sides of the first display electrode 21 in the second direction D2 are relatively uniform.

It should be noted that in the first sub-pixel P1 and the second sub-pixel P2, the second via holes are used to connect the data line and the first semiconductor layer, the second via holes may include two sub-via holes that are not connected to each other, for details, see the first sub-via hole and the second sub-via hole as described previously, however, in different sub-pixels, the positions of the two sub-via holes included in the second via holes are not necessarily the same. For example, as shown in Fig. 12, the position of the first sub-via hole V21 of the second via hole V2 of the first sub-pixel P1 and the position of the first sub-via hole V21 of the second via hole V2 of the second sub-pixel P2 in the respective sub-pixels are basically the same; the second sub-via hole V22 of the second via hole V2 of the first sub-pixel P1 is at the position of the data line Data1 of the first sub-pixel P1, the second sub-via hole V22 of the second via hole V2 of the second sub-pixel P2 is at the position of the data line Data1 of the second sub-pixel P2, the data line Data1 of the first sub-pixel P1 and the data line Data1 of the second sub-pixel P2 are symmetrical with respect to the symmetry axis extending along the first direction D1, and a distance between the first sub-via hole V21 of the first sub-pixel P1 and the second sub-via hole V22 of the first sub-pixel P1 is smaller than a distance between the first sub-via hole V21 of the second sub-pixel P2 and the second sub-via hole V22 of the second sub-pixel P2.

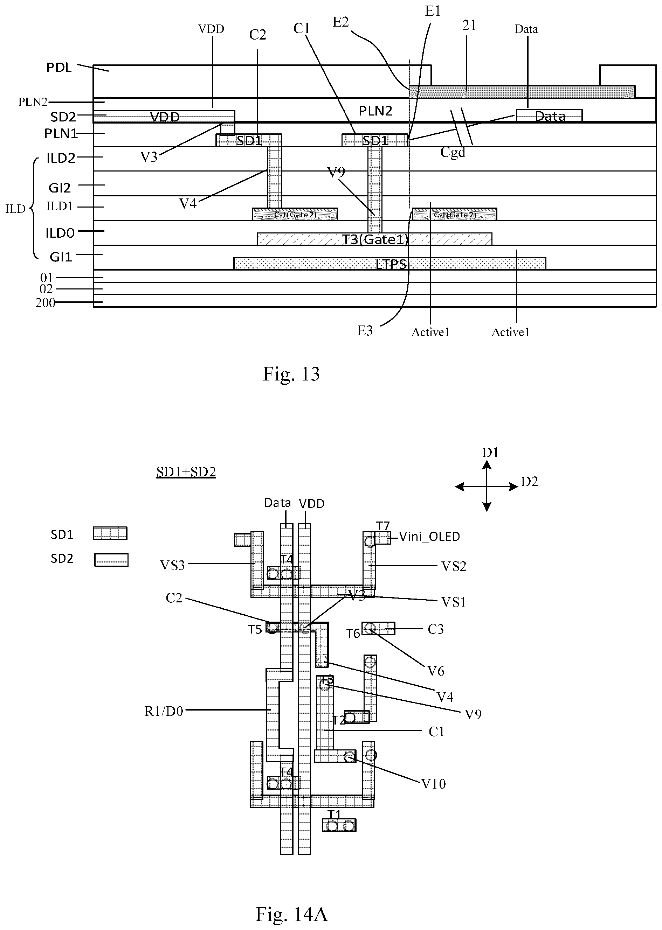

Fig. 13 is still another cross-sectional schematic diagram of a display substrate provided by an embodiment of the present disclosure. For example, as shown in Fig. 13, the second electrode plate Cst2 of the storage capacitor Cst includes a first part Cst21 located on a first side of the first via hole V1 in the second direction D2 and a second part Cst22 located on a second side of the first via hole V1 in the second direction D2, the first side of the first via hole V1 is opposite to the second side of the first via hole V1, the second part Cst22 of the second electrode plate Cst2 is located on a side of the first part Cst21 of the second electrode plate Cst2 close to the data line Data. An orthographic projection of an edge E1 of the first connection structure C1 close to the second part Cst22 of the second electrode plate Cst2 the storage capacitor Cst in the second direction D2 (i.e. the above-mentioned second edge 1b of the first connection structure C1) on the base substrate 200, an orthographic projection of an edge E2 of the first display electrode 21 close to the first connection structure C1 on the base substrate 200, and an orthographic projection of an edge E3 of the second part of the second electrode plate Cst2 close to the first connection structure C1 on the base substrate 200 are overlapped (substantially aligned). In this way, it is beneficial to reduce the parasitic capacitance formed by the first display electrode 21 and the first connection structure C1, and is also beneficial to the planarization of the fourth conductive layer SD1.

For example, in at least one embodiment, at least one of the first connection structure C1 and the overlapping part D0 of the data line Data includes a recessed part, the recessed part of either one of the first connection structure C1 and the overlapping part D0 of the data line Data is recessed in the second direction D2 toward a direction away from the other of the first connection structure C1 and the overlapping part D0 of the data line Data.

Exemplarily, Fig. 14A is a schematic diagram of a first connection structure and a data line in a display substrate provided by an embodiment of the present disclosure. As shown in Fig. 14A, for example, the overlapping part of the data line Data includes a first recessed part R1, the first recessed part R1 is recessed in the second direction D2 toward a direction away from the first connection structure C1, the part of the first connection structure C1 opposite to the data line Data is in a straight strip shape. In this way, the first recessed part R1 increases the distance between the first connection structure C1 and the overlapping part D0 of the data line Data, a capacitance value of the parasitic capacitance formed by the first connection structure C1 and the overlapping part D0 of the data line is reduced.

For example, in Fig. 14A, the data line Data and the first connection structure C1 are arranged in different layers, therefore, a layer different from the first connection structure C1 can be used to layout the pattern of the data line Data, and a space restriction on the design of the first recessed part R1 caused by structures such as the first connection structure C1 is avoided, there is sufficient space to meet requirement for the design of the first recessed part R1. For example, the first connection structure C1 is located in the above-mentioned fourth conductive layer SD1, and the data line Data is located in the above-mentioned fifth conductive layer SD2. Or, in other embodiments, the connection structure C1 is located in the above-mentioned fifth conductive layer SD2, and the data line Data is located in the above-mentioned fourth conductive layer SD1. Of course, the first connection structure and the data line may also be located in other two different conductive layers, and the present disclosure does not specifically limit the layers where the first connection structure and the data line are located.

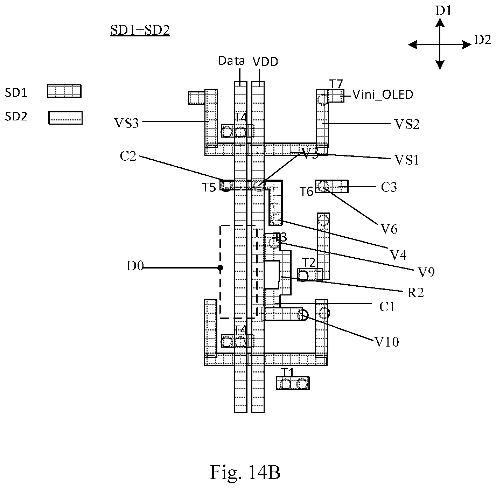

Exemplarily, Fig. 14B is a schematic diagram of the first connection structure and the data line in another display substrate provided by an embodiment of the present disclosure. As shown in Fig. 14B, for example, the first connection structure C1 includes a second recessed part R2, the second recessed part R2 is recessed in the second direction D2 toward a direction away from the overlapping part D0 of the data line Data, the overlapping part D0 of the data line Data is in a straight strip shape. Therefore, the second recessed part R2 can increase the distance between the first connection structure C1 and the overlapping part D0 of the data line Data, and the capacitance value of the parasitic capacitance formed by the overlapping part D0 of the data line Data and the first connection structure C1 is reduced.

Similarly, for example, the data line Data and the first connection structure C1 are arranged in different layers, therefore, a layer different from the data line Data can be used to layout the pattern of the first connection structure C1, the space restriction on the design of the second recessed part R2 caused by the data line Data and other structures is avoided, and there is sufficient space to meet the requirement for designing the second recessed part R2. For example, the first connection structure C1 is located in the above-mentioned the fourth conductive layer SD1, and the data line Data is located in the above-mentioned the fifth conductive layer SD2. Alternatively, in other embodiments, the connection structure C1 is located in the above-mentioned fifth conductive layer SD2, and the data line Data is located in the above-mentioned fourth conductive layer SD1. Of course, the first connection structure and the data line may also be located in other two different conductive layers, and the present disclosure does not specifically limit the layers where the first connection structure and the data line are located.

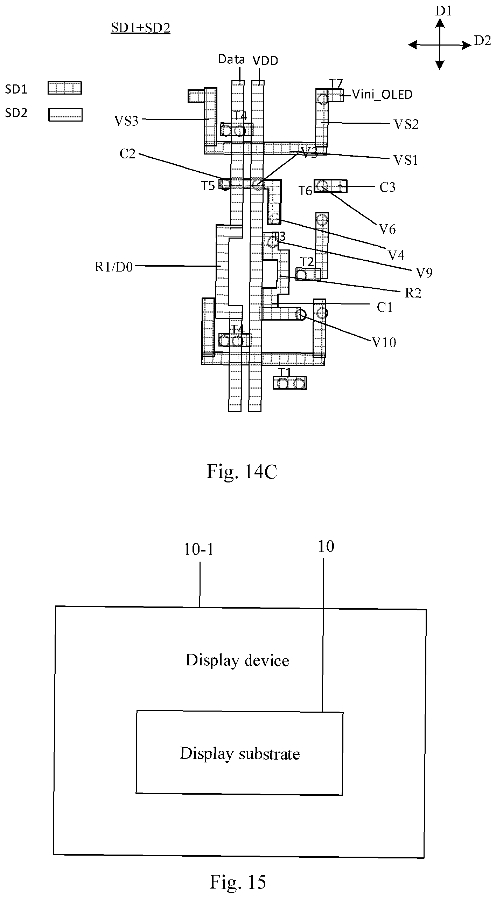

Exemplarily, Fig. 14C is a schematic diagram of the first connection structure and the data line in another display substrate provided by an embodiment of the present disclosure. As shown in Fig. 14C, for example, the overlapping part D0 of the data line Data includes a first recessed part R1, the first recessed part R1 is recessed in the second direction D2 toward a direction away from the first connection structure C1, furthermore, the first connection structure C1 includes a second recessed part R2, the second recessed part R2 is recessed in the second direction D2 toward a direction away from the overlapping part D0 of the data line Data. In this way, the portion of the first connection structure C1 opposite to the data line Data is in a straight strip shape. In this way, the first recessed part R1 and the second recessed part R2 together further increase the distance between the first connection structure C1 and the overlapping part D0 of the data line Data, and the capacitance value of the parasitic capacitance formed by the first connection structure C1 and the overlapping part D0 of the data line is further reduced.

For example, in Fig. 14C, the data line Data and the first connection structure C1 are arranged in different layers, therefore, space restrictions on designing the first recessed part R1 and the second recessed part R2 are avoided, there is sufficient space in different layers to meet the requirements for designing the first recessed part R1 and the second recessed part R2. For example, the first connection structure C1 is located in the above-mentioned fourth conductive layer SD1, and the data line Data is located in the above-mentioned fifth conductive layer SD2. Or, in other embodiments, the connection structure C1 may be located in the above-mentioned fifth conductive layer SD2, and the data line Data is located in the above-mentioned the fourth conductive layer SD1.Of course, the first connection structure and the data line may also be located in two different conductive layers, and the present disclosure does not specifically limit the layers where the first connection structure and the data line are located.

At least one embodiment of the present disclosure further provides a display apparatus, and the display apparatus includes any one of the display substrates provided by the embodiments of the present disclosure. Fig. 15 is a schematic diagram of a display apparatus provided by at least one embodiment of the present disclosure. As shown in Fig. 15, the display apparatus 10-1 provided by at least one embodiment of the present disclosure includes any one of the display panels 10 provided by the embodiments of the present disclosure. The display apparatus 10-1 may be, for example, a device with a display function such as an organic light-emitting diode display apparatus or other types of devices. No limitation is imposed to this in the embodiments of the present disclosure.

The structure, the function and the technical effect of the display apparatus provided by the embodiments of the present disclosure, can be referred to the corresponding descriptions of the display substrate 10 provided by the embodiment of the present disclosure, are not described in detail herein.

For example, the display apparatus 10-1 provided by at least one embodiment of the present disclosure may be a mobile phone, a tablet computer, a television, a monitor, a notebook computer, a digital photo frame, a navigator, or any other product or component with a display function, and no limitation is imposed to this in the embodiments of the present disclosure.

The above descriptions are only exemplary embodiments of the present disclosure and are not used to limit the scope of protection of the present disclosure, which is determined by the appended claims.

## Claims

1.  A display substrate, comprising:

    a base substrate, provided with a plurality of pixels arranged in an array, wherein each pixel of at least part of the plurality of pixels comprises a plurality of sub-pixels, each sub-pixel of at least part of the plurality of sub-pixels comprises a pixel circuit, the pixel circuit comprises:

    a light-emitting device, a storage capacitor, a driving transistor and a data writing transistor, wherein each of the driving transistor and the data writing transistor comprises an active layer, a gate electrode, a first electrode and a second electrode, the driving transistor is configured to control the light-emitting device to emit light;
    a data line, connected with the first electrode of the data writing transistor and configured to provide a data signal to the data writing transistor, wherein the data writing transistor is configured to write the data signal to the gate electrode of the driving transistor in response to a first scan signal applied to the gate electrode of the data writing transistor; and
    a first connection structure, connected with the gate electrode of the driving transistor and a first electrode plate of the storage capacitor, wherein both the data line and the first connection structure extend along a first direction, and the data line comprises an overlapping part, the first connection structure is at least partially opposite to the overlapping part of the data line in a second direction, and the second direction is parallel to the base substrate and perpendicular to the first direction;
    the first connection structure and the overlapping part of the data line are insulated from each other, the first connection structure and the overlapping part of the data line respectively constitute a first electrode plate and a second electrode plate of a parasitic capacitance, and a ratio of a capacitance value of the parasitic capacitance to a capacitance value of the storage capacitor is greater than 0.001 and less than 0.01.

2.  The display substrate according to claim 1, wherein a size of one of the sub-pixels in the second direction is greater than $50\mu m$, and the ratio of the capacitance value of the parasitic capacitance to the capacitance value of the storage capacitor is less than 0.005.

3.  The display substrate according to claim 2, wherein the size of the one of the sub-pixels in the second direction is less than or equal to $68\mu m$, and the ratio of the capacitance value of the parasitic capacitance to the capacitance value of the storage capacitor is greater than or equal to 0.003.

4. The display substrate according to claim 1, wherein a size of one of the sub-pixels in the second direction is less than 50μm, and the ratio of the capacitance value of the parasitic capacitance to the capacitance value of the storage capacitor is greater than 0.005 and less than 0.006.

5. The display substrate according to any one of claims 1 to 4, wherein the first connection structure comprises a first part extending along the first direction, an edge of the first part of the first connection structure close to the overlapping part of the data line is a first edge, the first part of the first connection structure further comprises a second edge away from the overlapping part of the data line, and an edge of the overlapping part of the data line close to the first connection structure is a third edge;

the plurality of sub-pixels comprise a first sub-pixel and a second sub-pixel that are adjacent to each other in the second direction; a distance from an orthographic projection of the second edge of the first connection structure of the first sub-pixel on the base substrate to an orthographic projection of the third edge of the overlapping part of the data line of the second sub-pixel on the base substrate is a first distance, a distance from a first edge of the first connection structure of the first sub-pixel to a third edge of an overlapping part of a data line of the first sub-pixel is a second distance, and a ratio of the first distance to the second distance is greater than 14.

6. The display substrate according to claim 5, wherein a size of one of the sub-pixels in the second direction is less than 50μm, and the ratio of the first distance to the second distance is greater than 14 and less than 15.5.

7. The display substrate according to claim 5, wherein a size of one of the sub-pixels in the second direction is greater than 50μm, and the ratio of the first distance to the second distance is greater than 15.5.

8. The display substrate according to any one of claims 5 to 7, wherein the plurality of sub-pixels comprise the first sub-pixel and the second sub-pixel adjacent to each other in the second direction; the first connection structure of the first sub-pixel is located between the data line of the first sub-pixel and the data line of the second sub-pixel in the second direction;

a distance between an orthographic projection of the first connection structure of the first sub-pixel on the base substrate and an orthographic projection of the data line of the first sub-pixel on the base substrate is smaller than a size of one of the sub-pixels in the second direction, and
a distance between the orthographic projection of the first connection structure of the first sub-pixel on the base substrate and an orthographic projection of the data line of the second sub-pixel on the base substrate is smaller than a size of one of the sub-pixels in the second direction.

9. The display substrate according to any one of claims 5 to 8, wherein the first connection structure of the first sub-pixel is located between the data line of the first sub-pixel and the data line of the second sub-pixel in the second direction;

a distance between an orthographic projection of the first connection structure of the first sub-pixel on the base substrate and an orthographic projection of the data line of the first sub-pixel on the base substrate is smaller than a size of one of the sub-pixels in the second direction, and
a distance between the orthographic projection of the first connection structure of the first sub-pixel on the base substrate and an orthographic projection of the data line of the second sub-pixel on the base substrate is greater than the size of one of the sub-pixels in the second direction.

10. The display substrate according to any one of claims 5 to 9, wherein an edge of the gate electrode of the driving transistor of the first sub-pixel close to the overlapping part of the data line of the second sub-pixel is a fourth edge; a distance from a second edge of the first sub-pixel to a third edge of the second sub-pixel is equal to a sum of a distance from the second edge of the first sub-pixel to the fourth edge and a distance from the fourth edge of the first sub-pixel to the third edge of the second sub-pixel.

11. The display substrate according to claim 10, wherein the first connection structure and the data line are arranged in different layers, an orthographic projection of the first connection structure on the base substrate is at least partially overlapped with the orthographic projection of the overlapping part of the data line on the base substrate; or, the first connection structure and the data line are arranged in different layers, an orthographic projection of the first connection structure on the base substrate is not overlapped with an orthographic projection of the overlapping part of the data line on the base substrate.

12. The display substrate according to claim 10, wherein the first connection structure and the data line are arranged in a same layer, and the first connection structure and the overlapping part of the data line are opposite to each other in the second direction.

13. The display substrate according to any one of claims 1 to 12, wherein at least one of the overlapping part of the data line and the first connection structure comprises a recessed part, the recessed part of any one of the overlapping part of the data line and the first connection structure is recessed in a direction away from other one of the overlapping part of the data line and the first connection structure in the second direction.

14. The display substrate according to claim 13, wherein the overlapping part of the data line comprises a first recessed part, the first recessed part is recessed in a direction away from the first connection structure in the second direction, and a part of the first connection structure opposite to the data line is in a straight strip shape.

15. The display substrate according to claim 13, wherein the first connection structure comprises a second recessed part, the second recessed part is recessed in a direction away from the overlapping part of the data line in the second direction, and the overlapping part of the data line is in a straight strip shape.

16. The display substrate according to claim 13, wherein the overlapping part of the data line comprises a first recessed part, the first recessed part is recessed in a direction away from the first connection structure in the second direction, and the first connection structure comprises a second recessed part, the second recessed part is recessed in a direction away from the overlapping part of the data line in the second direction.

17. The display substrate according to any one of claims 1 to 16, further comprising a first reset scan signal line, a second reset scan signal line, a first reset signal line and a second reset signal line, wherein the pixel circuit further comprises:

    a first reset transistor, comprising an active layer, wherein the first reset scan signal line is configured to provide a first reset scan signal to a gate electrode of the first reset transistor, a first electrode of the first reset transistor is electrically connected with the gate electrode of the driving transistor, a second electrode of the first reset transistor is configured to be electrically connected with the first reset signal line to receive a first reset signal, and the first reset transistor is configured to write the first reset signal to the gate electrode of the driving transistor in response to the first reset scan signal; and
    a second reset transistor, wherein the second reset scan signal line is configured to provide a second reset scan signal to a gate electrode of the second reset transistor, a first electrode of the second reset transistor is electrically connected with a first display electrode of the light-emitting device, a second electrode of the second reset transistor is configured to be electrically connected with the second reset signal line to receive a second reset signal, and the second reset transistor is configured to write the second reset signal to the first display electrode of the light-emitting device in response to the second reset scan signal;
    an active layer of the first reset transistor extends along the first direction, and the first reset scan signal line extends in the second direction;
    the plurality of sub-pixels comprise a first sub-pixel and a second sub-pixel that are adjacent to each other in the second direction; the plurality of sub-pixels further comprise a third sub-pixel, and the third sub-pixel is adjacent to the second sub-pixel in the first direction; and
    a part of the second reset signal line in each of the sub-pixels in the plurality of sub-pixels comprises a transverse part and a first vertical part, the transverse part extends along the second direction and has a first end and a second end that are opposite each other in the second direction, the first vertical part is connected with the first end of the transverse part and extends along the first direction, and an orthographic projection of the transverse part of the second reset signal line in the second sub-pixel on the base substrate is at least partially overlapped with an orthographic projection of the first reset scan signal line in the third sub-pixel on the base substrate, and the first vertical part of the second reset signal line in the second sub-pixel is spaced apart from the active layer of the first reset transistor of the third sub-pixel in the second direction.

18. The display substrate according to claim 17, wherein a planar pattern of a sub-part of the second reset signal line corresponding to one of the sub-pixels is in a shape of an inverted "π"; the sub-part in the shape of the inverted "π" comprises a U-shaped groove, and the transverse part of the second reset signal line serves as a bottom of the U-shaped groove.

19. The display substrate according to claim 17 or 18, further comprising a compensation scan signal line, wherein the pixel circuit further comprises:

a compensation transistor, comprising an active layer, a gate electrode, a first electrode and a second electrode, wherein the compensation scan signal line is configured to apply a second scan signal to the gate electrode of the compensation transistor, the compensation transistor is configured to perform threshold compensation on the driving transistor in response to the second scan signal; and

the active layer of the compensation transistor and the active layer of the first reset transistor constitute an integral structure.

20. The display substrate according to any one of claims 17 to 19, wherein a part of the second reset signal line in one of the sub-pixels further comprises a second vertical part, the second vertical part is connected with the second end of the transverse part and extends along the first direction, an active layer of the second reset transistor is between the first vertical part and the second vertical part, and

in one same sub-pixel of the sub-pixels, in the second direction, a distance from the first vertical part to the data line is greater than a distance from the second vertical part to the data line;

a distance from an active layer of the second reset transistor of the third sub-pixel to the first vertical part of the second reset signal line of the second sub-pixel is less than a distance from the active layer of the second reset transistor of the third sub-pixel to the second vertical part of the second reset signal line of the second sub-pixel.

21. The display substrate according to claim 19 or 20, wherein the gate electrode of the driving transistor and the first electrode plate of the storage capacitor are arranged in a same layer and constitute an integral structure, the second reset scan signal line is arranged in a same layer as the gate electrode of the driving transistor;

the gate electrode of the driving transistor and the first electrode plate of the storage capacitor are located on a side of the active layer of the driving transistor away from the base substrate;

a second electrode plate of the storage capacitor is located on a side of both the gate electrode of the driving transistor and the first electrode plate of the storage capacitor away from the base substrate, the compensation scan signal line is arranged in a same layer as the second electrode plate of the storage capacitor;

the active layer of the compensation transistor is located on a side of the second electrode plate of the storage capacitor away from the base substrate; and

the second reset signal line is located on a side of the active layer of the compensation transistor away from the base substrate.

22. The display substrate according to claim 21, further comprising a first reset scan signal line and a first reset signal line, wherein the pixel circuit further comprises:

a first reset transistor, comprising an active layer, wherein the first reset scan signal line is configured to provide a first reset scan signal to a gate electrode of the first reset transistor, the first electrode of the second reset transistor is electrically connected with the gate electrode of the driving transistor, a second electrode of the first reset transistor is configured to be electrically connected with the first reset signal line to receive a first reset signal, the first reset transistor is configured to write the first reset signal to the gate electrode of the driving transistor in response to the first reset scan signal;

the active layer of the first reset transistor and the active layer of the driving transistor are made of different materials and are arranged in different layers; and

the first reset signal line and the second electrode plate of the storage capacitor are arranged in a same layer.

23. The display substrate according to claim 22, wherein the gate electrode of the compensation transistor and the gate electrode of the first reset transistor are both double gate structures, the gate electrode of the compensation transistor comprises a first gate electrode and a second gate electrode, and the gate electrode of the first reset transistor comprises a first gate electrode and a second gate electrode;

an orthographic projection of the first gate electrode of the compensation transistor on the base substrate coincides with an orthographic projection of the second gate electrode of the compensation transistor on the base substrate, and an orthographic projection of the first gate electrode of the first reset transistor on the base substrate coincides with an orthographic projection of the second gate electrode of the first reset transistor on the base substrate.

24. The display substrate according to claim 23, wherein the first gate electrode of the compensation transistor and the first gate electrode of the first reset transistor are arranged in a same layer as the second electrode plate of the storage capacitor, the second gate electrode of the compensation transistor and the second gate electrode of the first reset transistor are located on a side of both the active layer of the compensation transistor and the active layer of the first reset transistor away from the base substrate, and are located on a side of the second reset signal line close to the base substrate.

25. The display substrate according to any one of claims 22 to 24, wherein

a material of the active layer of the first reset transistor is an oxide semiconductor; and
a material of the active layer of the driving transistor and a material of the active layer of the data writing transistor are low-temperature polysilicon.

26. The display substrate according to any one of claims 21 to 25, wherein the first connection structure is located on a side of the second electrode plate of the storage capacitor away from the base substrate;

the second electrode plate of the storage capacitor has a first via hole exposing the first electrode plate of the storage capacitor, the first connection structure passes through the first via hole and is connected with the first electrode plate of the storage capacitor; the second electrode plate of the storage capacitor comprises a first part located on a first side of the first via hole in the second direction and a second part located on a second side of the first via hole in the second direction, the first side of the first via hole is opposite to the second side of the first via hole, the second part of the second electrode plate is located on a side of the first part of the second electrode plate close to the data line;
an orthographic projection of an edge of the first connection structure close to the second part of the second electrode plate of the storage capacitor in the second direction on the base substrate, an orthographic projection of an edge of the first display electrode close to the first connection structure on the base substrate, and an orthographic projection of an edge of the second part of the second electrode plate close to the first connection structure on the base substrate are overlapped with each other.

27. The display substrate according to any one of claims 21 to 26, wherein the first connection structure and the second reset signal line are arranged in a same layer;

upon the first connection structure and the data line being arranged in different layers,
the data line is located on a side of the first connection structure away from the base substrate, or, the data line is located on a side of the first connection structure close to the base substrate.

28. The display substrate according to any one of claims 19 and 21 to 27, wherein the first connection structure comprises a first part extending along the first direction and a second part extending along the second direction, the second part of the first connection structure is connected with the first part of the first connection structure;
the active layer of the compensation transistor is located on a side of the first connection structure away from the data line, and the second part of the first connection structure is connected with the active layer of the compensation transistor.

29. The display substrate according to any one of claims 1 to 28, wherein an orthographic projection of an entirety of the first connection structure on the base substrate is located within an orthographic projection of a first display electrode of the light-emitting device on the base substrate;
the plurality of sub-pixels comprise a first sub-pixel and a second sub-pixel that are adjacent to each other in the second direction; the first display electrode of the first sub-pixel covers a boundary between the first sub-pixel and the second sub-pixel, and an orthographic projection of the first connection structure of the first sub-pixel on the base substrate and an orthographic projection of the first connection structure of the second sub-pixel on the base substrate are both located within an orthographic projection of the first display electrode of the first sub-pixel on the base substrate.

30. The display substrate according to claim 29, wherein an orthographic projection of an edge of the first display electrode of the first sub-pixel away from the second sub-pixel on the base substrate is overlapped with an orthographic projection of an edge of the first connection structure of the first sub-pixel close to the data line of the first sub-pixel on the base substrate, an orthographic projection of an edge of the first display electrode of the first sub-pixel close to the second sub-pixel on the base substrate is overlapped with an orthographic projection of an edge of the first connection structure of the second sub-pixel close to the data line of the second sub-pixel on the base substrate.

31. The display substrate according to any one of claims 1 to 28, wherein a part of the orthographic projection of the first connection structure on the base substrate is located within an orthographic projection of a first display electrode of the light-emitting device on the base substrate;

the plurality of sub-pixels comprise a first sub-pixel and a second sub-pixel that are adjacent to each other in the second direction; a first display electrode of the first sub-pixel covers a boundary between the first sub-pixel and the second sub-pixel, and both a part of an orthographic projection of the first connection structure of the first sub-pixel on the base substrate and a part of an orthographic projection of the first connection structure of the second sub-pixel on the base substrate are located within an orthographic projection of the first display electrode of the first sub-pixel on the base substrate.

32. The display substrate according to claim 31, wherein a light-emitting material of the light-emitting device of the first sub-pixel emits green light.

33. The display substrate according to any one of claims 1 to 32, wherein the first electrode plate of the storage capacitor has an upper surface away from the base substrate and a side surface intersecting the upper surface; a second electrode plate of the storage capacitor comprises:

a central part, wherein an orthographic projection of the central part on the base substrate at least partially coincides with an orthographic projection of the first electrode plate of the storage capacitor on the base substrate, and the central part comprises a bottom surface opposite to the upper surface of the first electrode plate of the storage capacitor;

an edge part, at least partially surrounding the central part and connected with the central part, and comprising a bottom surface close to the base substrate and an inner side surface intersecting the bottom surface, wherein the inner side surface and the side surface of the first electrode plate of the storage capacitor are opposite to each other, and an orthographic projection of the inner surface on a reference plane perpendicular to the base substrate is at least partially overlapped with an orthographic projection, of the side surface of the first electrode plate of the storage capacitor which is opposite to the inner surface, on the reference plane, wherein a distance between the inner side of the edge part and the side surface of the first electrode plate of the storage capacitor which is opposite to the inner side is less than a distance between the bottom surface of the central part and the upper surface of the first electrode plate of the storage capacitor.

34. The display substrate according to any one of claims 1 to 33, wherein a first display electrode of the light-emitting device has a first end and a second end that are opposite to each other in the second direction;

the display substrate comprises a first semiconductor layer, the first semiconductor layer comprises the active layer of the driving transistor and the active layer of the data writing transistor, the data line is connected with the first semiconductor layer through a second via hole;

the plurality of sub-pixels comprise a first sub-pixel and a second sub-pixel that are adjacent to each other in the second direction; a first display electrode of the first sub-pixel covers a boundary between the first sub-pixel and the second sub-pixel, an orthographic projection of the first end of the first display electrode of the first sub-pixel on the base substrate has a first protrusion part that is convex and tapered in the second direction toward an orthographic projection of the second via hole of the first sub-pixel on the base substrate, an orthographic projection of the second end of the first display electrode of the first sub-pixel on the base substrate has a second protrusion part that is convex and tapered in the second direction toward the orthographic projection of the second via hole of the second sub-pixel on the base substrate, and an orthographic projection of the first protrusion part is directly opposite to the orthographic projection of the second via hole of the first sub-pixel on the base substrate in the second direction, an orthographic projection of the second protrusion part and the orthographic projection of the second via hole of the second sub-pixel on the base substrate is directly opposite in the second direction; a light-emitting material of the light-emitting device of the first sub-pixel emits blue light.

35. The display substrate according to any one of claims 1 to 34, wherein the gate electrode of the driving transistor and the first electrode plate of the storage capacitor are arranged in a same layer and constitute an integral structure; the gate electrode of the driving transistor and the first electrode plate of the storage capacitor are located on a side of the active layer of the driving transistor away from the base substrate; a second electrode plate of the storage capacitor is located on a side of both the gate electrode of the driving transistor and the first electrode plate of the storage capacitor away from the base substrate,

the display substrate further comprises:
a first power line, connected with a first voltage terminal and configured to provide a first power voltage to the pixel circuit, and extending along the first direction;
the pixel circuit further comprises:

a second connection structure, located between the first power line and the second electrode plate of the storage capacitor in a direction perpendicular to the base substrate, and connecting the first power line and the second electrode plate of the storage capacitor, wherein the second connection structure comprises a horizontal part and a vertical part, the horizontal part extends along the second direction, and the vertical part is connected with the horizontal part and extends along the first direction;
an orthographic projection of the first power line on the base substrate is overlapped with an orthographic projection of the horizontal part of the second connection structure on the base substrate, the orthographic projection of the first power line on the base substrate is not overlapped with orthographic projections of other structures that are arranged in a same layer as the second connection structure on the base substrate.

36. The display substrate according to claim 35, wherein the vertical part is substantially aligned with the first connection structure in the first direction, the orthographic projection of the horizontal part on the base substrate extends along the first direction from an orthographic projection of the vertical part on the base substrate to the orthographic projection of the first power line on the base substrate.

37. The display substrate according to claim 35 or 36, further comprising:

a first insulation layer, located between the first power line and the second connection structure;
a second insulation layer, located between the second connection structure and the second electrode plate of the storage capacitor, wherein a horizontal part of the first power line is connected with the second connection structure through a third via hole penetrating through the first insulation layer, and the vertical part of the second connection structure is connected with the second electrode plate of the storage capacitor through a fourth via hole penetrating through the second insulation layer.

38. The display substrate according to any one of claims 35 to 37, wherein the first power line and the data line are arranged in a same layer, and the second connection structure and the first connection structure are arranged in a same layer.

39. The display substrate according to any one of claims 35 to 38, wherein the pixel circuit further comprises:

a first light-emitting transistor, connected with the first electrode of the driving transistor and a first voltage terminal, and configured to apply the first power supply voltage of the first voltage terminal to the first electrode of the driving transistor in response to a first light-emitting control signal applied to a gate electrode of the first light-emitting transistor;
the display substrate comprises a first semiconductor layer, the first semiconductor layer comprises the active layer of the driving transistor, the active layer of the data writing transistor, and an active layer of the first light-emitting transistor, and the horizontal part of the second connection structure is connected with the first semiconductor layer through a fifth via hole.

40. The display substrate according to claim 39, wherein the horizontal part of the second connection structure has a first end and a second end that are opposite to each other in the second direction, the first end of the horizontal part is located on a side of the first power line close to the vertical part and is connected with the vertical part, and the second end of the horizontal part is located on a side of the first power line away from the vertical part and is connected with the first semiconductor layer through the fifth via hole.

41. A display apparatus, comprising the display substrate according to any one of claims 1 to 40.

10

Fig. 1

Fig. 2A

Fig. 2B

Fig. 2C

Active1+Gate1

D1

D2

T7/A7/T7g

Scan(P)(n+1)

T5g/A5/ T5

T6/A6/T6g

EM(P)(n)

Active1

T3/A3/T3g

Gate1

Cst1

T4g/A4/ T4

Scan(P)(n)

Fig. 3A

Gate2+Active2

D1

D2

Gate 2

Active2

Scan(N)(n+1)

Vini_N1'

V1

Cst2

T2g/A2/T2

Scan(N)(n)

AL1

Scan(N)(n-1)

T1g/A1/T1

Vini_N1

Fig. 3B

D1
D2

Active1+Gate1+Gate2+Active2

Gate 2

Active2

T7
Scan(P)(n+1)

Scan(N)(n+1)

Vini_N1'

T5          T6
EM(P)(n)

V1

T2
Scan(N)(n)

T4
Scan(P)(n)

Scan(N)(n-1)

T1
Vini_N1

Fig. 3C

D1
D2

Gate2+Gate3

Gate 2

Gate 3

Scan(N)(n+1)

Vini_N1'

V1                    Cst2

Scan(N)(n)'
/Scan(N)(n)

Scan(N)(n-1)'
/Scan(N)(n-1)

Vini_N1

Fig. 3D

Active1+Gate1+Gate2+Active2+Gate3

D1

D2

T7

Scan(P)(n+1)

Scan(N)(n+1)

Vini_N1'

T5

T6

Gate 2

Oxide

Gate 3

EM(P)(n)

V1

T2

Scan(N)(n)

T4

Scan(P)(n)

Scan(N)(n-1)

T1

Vini_N1

Fig. 3E

ILD+SD1

D1

D2

T7 Vini_OLED

VS3

VS2

C21

C2

VS1

C22

T5

T6

C3

ILD

V4

V6

SD1

V9

C11

T2

C1

C12

V21

V10

T1

Fig. 3F

Active1+Gate1+Gate2+Active2+Gate3
+ILD+SD1

Fig. 3G

PLN1+SD2

Fig. 3H

Gate1+Gate2+Active1+Gate3
+ILD+SD1+PLN1+SD2

D1

D2

VS3  Data VDD  VS2

T7  Vini_OLED

PLN1  Scan(P)(n+1)

SD2  V6  V7  Scan(N)(n+1)

V5  Vini_N1'  C4

T5  T6  EM(P)(n)  C3

C2 { C21  V3
     C22

D0  V4

V9

Scan(N)(n)
Vini_OLED

C1  Scan(P)(n)
V10

T4  Scan(N)(n-1)

T1  Vini_N1

Fig. 3I

PLN2+Anode+PDL

D1

D2

PLN2

Anode

PDL

T3d/Active1

C4

V8

V7

V6

21

Fig. 3J

Gate1+Gate2+Active1+Gate3+ILD+S
D1+PLN1+SD2+PLN2+Anode+PDL

Fig. 3K

Fig. 4A

Data1'  21  C1'  Data2'

PDL
SD2
PLN1
ILD2
GI2
ILD1 — Cst(Gate2)  Cst(Gate2)
ILD0
GI1 — T3(Gate1)
01 — LTPS
02
200

Fig. 4B

Flat plate capacitor with electrodes right
facing each other

Electrode 1

d   Power line

Electrode 2

Fig. 4C

Flat plate capacitor with inclined electrodes

**Electrode 1**

d  Power line

**Electrode 2**

Fig. 4D

VDD  C2  CM  C1  21  Data

PDL

PLN2
SD2
PLN1

ILD2  V3

GI2

ILD1  V4

ILD  ILD0

GI1

01
02
1

SD1  SD1

Cgd

V9

Cst(Gate2)  Cst(Gate2)

S2  S1  Cst(Gate2)

Cst(Gate2)  T3(Gate1)

LTPS  Active1

CP

B02  S02  S01  B01  V1  T3g  Cst1  Cst2

T01

Fig. 4E

Fig. 5

P3

D1

D2

PLN1

SD2

Data2 Data1

Data1 Data2

T7

T7

T5

T6

C5

T6

V3

V4

1d

1c

1b

1a

C1 { C11
      C12

L2/C6

3

L1/7

T3

T2

T4

T1

T1

1c

1b

1a

C11
C12 } C1

P1

P2

**Fig. 6**

Vini_OLED

Vini_OLED

T1g2

C3

Data

21

T2g2

PDL

PLN2
SD2
PLN1

SD1

SD1

T2

T1

ILD2
GI2
ILD1
ILD0

GI1

ILD

V22
V21

V2

Cst(Gate2)

Oxide

T2

T1

Active2

Vini_N1

Active1

T4

T3(Gate1)

LTPS

01
02
200

T4g

T3g

T2g1

T1g1

**Fig. 7A**

Fig. 7B

A1-A2

Fig. 7C

**B1-B2**

Fig. 7D

Fig. 8

Fig. 9

Fig. 10

Fig. 11

Fig. 12

Fig. 13

Fig. 14A

Fig. 14B

SD1+SD2

SD1

SD2

Data VDD

T7 — Vini_OLED

VS3

T4

VS2

VS1

C2

V8

T5

T6 — C3

V6

V4

T3

V9

R1/D0

V2

R2

C1

T4

V10

T1

D1

D2

Fig. 14C

10-1          10

Display device

Display substrate

Fig. 15

## INTERNATIONAL SEARCH REPORT

| International application No. |
|---|
| **PCT/CN2023/105120** |

**A. CLASSIFICATION OF SUBJECT MATTER**

G09G3/32(2016.01)i; H10K59/121(2023.01)i

According to International Patent Classification (IPC) or to both national classification and IPC

**B. FIELDS SEARCHED**

Minimum documentation searched (classification system followed by classification symbols)

IPC:G09G H10K

Documentation searched other than minimum documentation to the extent that such documents are included in the fields searched

Electronic data base consulted during the international search (name of data base and, where practicable, search terms used)

CNABS, CNTXT, CNKI: 显示, 面板, 基板, 有源矩阵, 像素, 边框, GOA, 栅极驱动电路, 扫描驱动电路, 寄生电容, 数据线, 信号线, 资料线, 栅极, 重叠, 交叠, 投影; VEN, USTXT, EPTXT, WOTXT: display, panel, active matrix, pixel, frame, gate on array, gate drive circuit, scanning drive circuit, parasitic capacitance, data line, signal line, gate electrode, overlap, superpose, projection

**C. DOCUMENTS CONSIDERED TO BE RELEVANT**

| Category* | Citation of document, with indication, where appropriate, of the relevant passages | Relevant to claim No. |
|---|---|---|
| PX | CN 114882841 A (BEIJING BOE TECHNOLOGY DEVELOPMENT CO., LTD. et al.) 09 August 2022 (2022-08-09) entire document | 1-41 |
| A | CN 113629127 A (BEIJING BOE TECHNOLOGY DEVELOPMENT CO., LTD. et al.) 09 November 2021 (2021-11-09) description, paragraphs 89-157, and figures 1-35B | 1-41 |
| A | CN 103872080 A (LG DISPLAY CO., LTD.) 18 June 2014 (2014-06-18) description, paragraphs 34-100, and figures 1-8 | 1-41 |
| A | CN 111243510 A (SAMSUNG DISPLAY CO., LTD.) 05 June 2020 (2020-06-05) entire document | 1-41 |
| A | CN 111403465 A (KUNSHAN GOVISIONOX OPTOELECTRONICS CO., LTD.) 10 July 2020 (2020-07-10) entire document | 1-41 |

☑ Further documents are listed in the continuation of Box C.    ☑ See patent family annex.

| * | Special categories of cited documents: | "T" | later document published after the international filing date or priority date and not in conflict with the application but cited to understand the principle or theory underlying the invention |
|---|---|---|---|
| "A" | document defining the general state of the art which is not considered to be of particular relevance | | |
| "D" | document cited by the applicant in the international application | "X" | document of particular relevance; the claimed invention cannot be considered novel or cannot be considered to involve an inventive step when the document is taken alone |
| "E" | earlier application or patent but published on or after the international filing date | | |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
|---|---|
| **04 September 2023** | **19 September 2023** |

| Name and mailing address of the ISA/CN | Authorized officer |
|---|---|
| **China National Intellectual Property Administration (ISA/CN)** **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

International application No.

**PCT/CN2023/105120**

### C. DOCUMENTS CONSIDERED TO BE RELEVANT

| Category* | Citation of document, with indication, where appropriate, of the relevant passages | Relevant to claim No. |
|---|---|---|
| A | JP 2008304684 A (HITACHI DISPLAYS LTD.) 18 December 2008 (2008-12-18)<br>entire document | 1-41 |
| A | KR 20180131149 A (LG DISPLAY CO., LTD.) 10 December 2018 (2018-12-10)<br>entire document | 1-41 |

Form PCT/ISA/210 (second sheet) (July 2022)

**INTERNATIONAL SEARCH REPORT**
Information on patent family members

International application No.

**PCT/CN2023/105120**

| Patent document cited in search report | | | Publication date (day/month/year) | Patent family member(s) | | | Publication date (day/month/year) |
|---|---|---|---|---|---|---|---|
| CN | 114882841 | A | 09 August 2022 | CN | 114882841 | B | 02 December 2022 |
| CN | 113629127 | A | 09 November 2021 | CN | 113629127 | B | 21 January 2022 |
| CN | 103872080 | A | 18 June 2014 | KR | 20140077002 | A | 23 June 2014 |
| | | | | KR | 101980757 | B1 | 21 May 2019 |
| | | | | US | 2014167009 | A1 | 19 June 2014 |
| | | | | US | 9257493 | B2 | 09 February 2016 |
| | | | | CN | 103872080 | B | 28 November 2017 |
| CN | 111243510 | A | 05 June 2020 | US | 2022076620 | A1 | 10 March 2022 |
| | | | | US | 11610546 | B2 | 21 March 2023 |
| | | | | KR | 20200064230 | A | 08 June 2020 |
| | | | | US | 2023215371 | A1 | 06 July 2023 |
| | | | | US | 2020168147 | A1 | 28 May 2020 |
| | | | | US | 11176883 | B2 | 16 November 2021 |
| CN | 111403465 | A | 10 July 2020 | CN | CN111403465 | B | 21 October 2022 |
| JP | 2008304684 | A | 18 December 2008 | None | | | |
| KR | 20180131149 | A | 10 December 2018 | KR | 102345787 | B1 | 30 December 2021 |

Form PCT/ISA/210 (patent family annex) (July 2022)

**REFERENCES CITED IN THE DESCRIPTION**

**Patent documents cited in the description**

- CN 202210811589